(19) Europäisches Patentamt
European Patent Office
Office européen des brevets

(11) EP 1 966 842 B1

(12) EUROPEAN PATENT SPECIFICATION

(45) Date of publication and mention of the grant of the patent:
**28.08.2019 Bulletin 2019/35**

(21) Application number: **06838595.4**

(22) Date of filing: **30.11.2006**

(51) Int Cl.:
***H01L 51/54*** *(2006.01)* ***C09K 11/06*** *(2006.01)*
***C08G 61/12*** *(2006.01)*

(86) International application number:
**PCT/US2006/045716**

(87) International publication number:
**WO 2007/064721 (07.06.2007 Gazette 2007/23)**

(54) **Lighting elements and devices**

Beleuchtungselemente und Einrichtungen

Éléments et dispositifs d'éclairage

(84) Designated Contracting States:
**AT BE BG CH CY CZ DE DK EE ES FI FR GB GR HU IE IS IT LI LT LU LV MC NL PL PT RO SE SI SK TR**

(30) Priority: **30.11.2005 US 740633 P**

(43) Date of publication of application:
**10.09.2008 Bulletin 2008/37**

(73) Proprietors:
- **Lomox Limited**
  **Cheshire CW12 1ET (GB)**
- **Kelly, Stephen, M.**
  **Beverley HU17 8XA (GB)**
- **Vlachos, Panagiotis**
  **Hull HU5 2NJ (GB)**

(72) Inventors:
- **ALDRED, Matthew, P.**
  **Congleton,**
  **Cheshire CW12 1ET (GB)**
- **KOCH, Gene, C.**
  **Wales LL28 4RT (GB)**
- **KELLY, Stephen, M.**
  **Beverly HU17 8XA (GB)**
- **VLACHOS, Panagiotis**
  **Hull HU5 2NJ (GB)**

(74) Representative: **Boult Wade Tennant LLP**
**5th Floor, Salisbury Square House**
**8, Salisbury Square**
**London EC4Y 8AP (GB)**

(56) References cited:
**WO-A1-2004/041901 WO-A2-2005/095543**
**US-A1- 2005 116 199**

- **CONTORET A E A ET AL: "THE PHOTOPOLYMERIZATION AND CROSS-LINKING OF ELECTROLUMINESCENT LIQUID CRYSTALS CONTAINING METHACRYLATE AND DIENE PHOTOPOLYMERIZABLE END GROUPS FOR MULTILAYER ORGANIC LIGHT-EMITTING DIODES", CHEMISTRY OF MATERIALS, AMERICAN CHEMICAL SOCIETY, WASHINGTON, US, vol. 14, no. 4, 1 April 2002 (2002-04-01), pages 1477-1487, XP001163183, ISSN: 0897-4756, DOI: DOI:10.1021/CM011111F**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 1 966 842 B1

## Description

## Related Applications

This application claims priority from US Provisional application serial No. 60/740,633, filed November 30, 2005.

## Field of the Invention

The present invention relates generally to materials for use in organic light emitting devices (OLEDs) and their method of fabrication; and more particularly, to liquid crystalline emitter and charge-transport materials for use in OLEDs and their method of fabrication.

## Background

A growing number of photocrosslinkable organic semiconductor materials have been created. These materials have various advantageous characteristics but also have one or more of less than satisfactory characteristics. For example, such materials may have need to high UV fluences in order to be polymerized, may have low thermal stability, may have- low shelf stability and may have other problems. According, there is a strong need in the art for OLED materials with improved characteristics. Such materials are described in "The Photopolymerization and Cross-Linking of Electroluminescent Liquid Crystals Containing Methacrylate and Diene Photopolymerizable End Groups for Multilayer Organic Light-Emitting Diodes", Adam A. E. Contoret et a/, Chem. Mater., 2002, 14, 1477-1487. In published International Application WO2004/041901, is described organic semiconductive polymers comprising a new backbone system, monomers for the preparation of such polymers, methods for the preparation of such polymers and the use of such polymers in organic optoelectronic devices. In published International Application WO2005/095543, is described photovoltaic cells comprising an interconnecting liquid crystalline polymer network. In pubslihed United States Application No. US2005/116199 A1, is described charge transporting or light emitting polymerizable materials having photocrosslinkable dienes, that may be polymerized to form charge-transport or light emission layers. The diene substituted materials include small molecules, oligomers, and polymers that are either of liquid crystalline or non-liquid crystalline nature. Also described are materials formed from polymerizing the charge transport or light emitting polymerizable materials, processes of forming the polymers, and devices using the polymers.

## Summary of the Invention

In a first aspect of the present invention there is provided a material for use in forming organic semiconductor, charge transporting or light emitting polymers comprising: a photopolymerizable material having the molecular structure B-S-A-S-B,
characterised in that

B is a crosslinkable end group;
S is a flexible spacer; and
A is an aromatic molecular nucleus having the structure

$$-(Ar-D)_n-Ar-$$

wherein

n = 1 to 6;
Ar is an aromatic diradical, a heteroaromatic diradical bonded linearly to adjoining diradicals, or a single bond;

wherein D are each independently chose from the group:

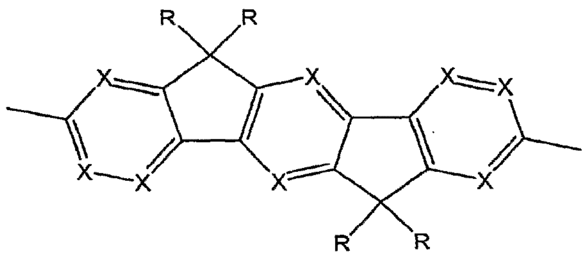

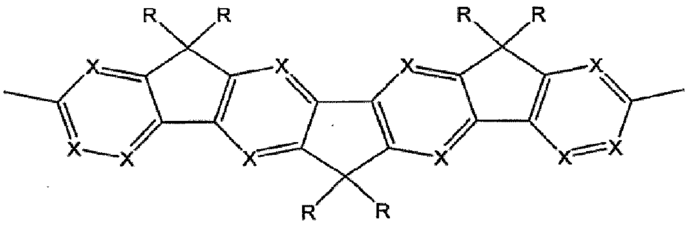

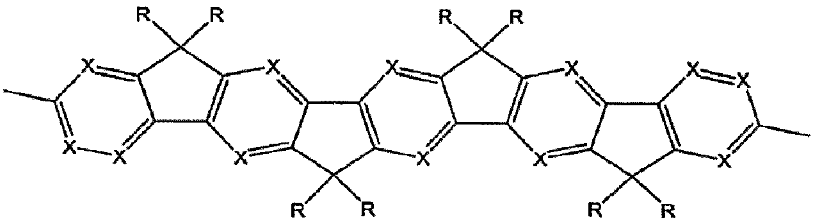

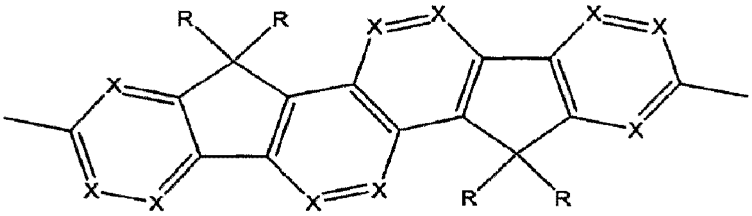

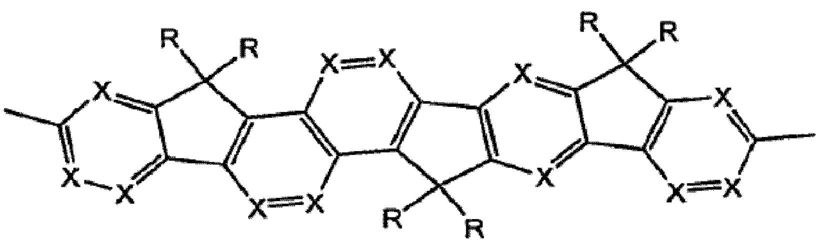

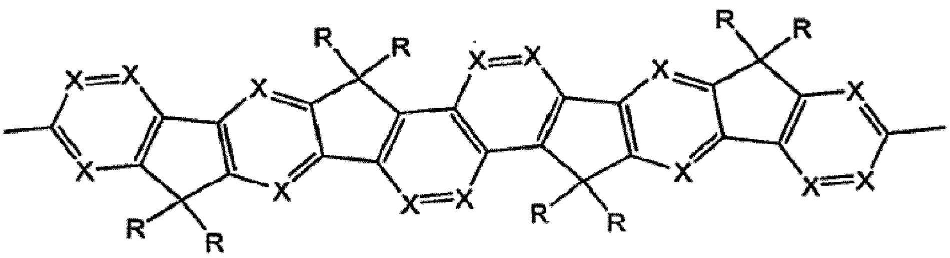

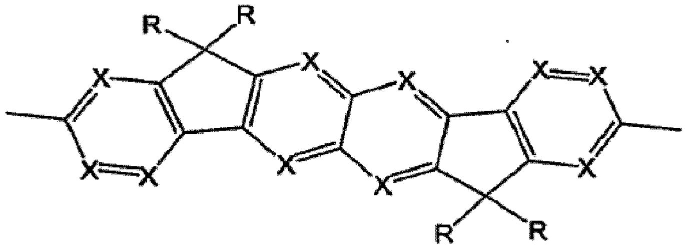

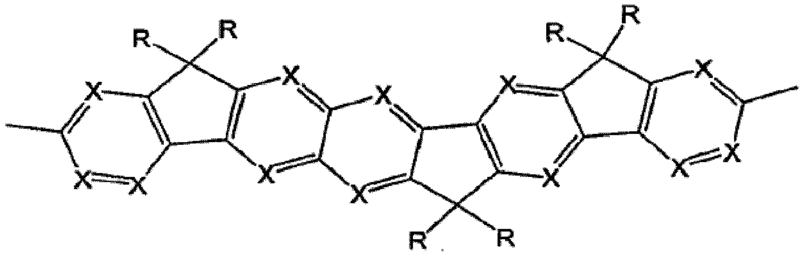

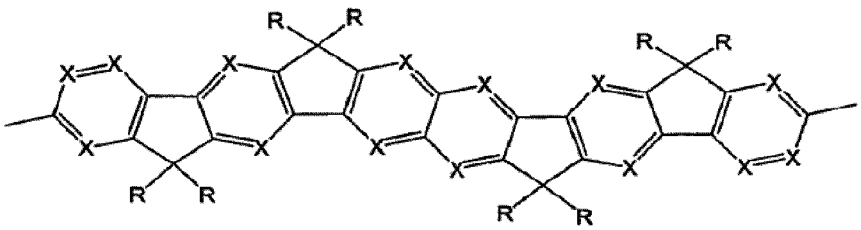

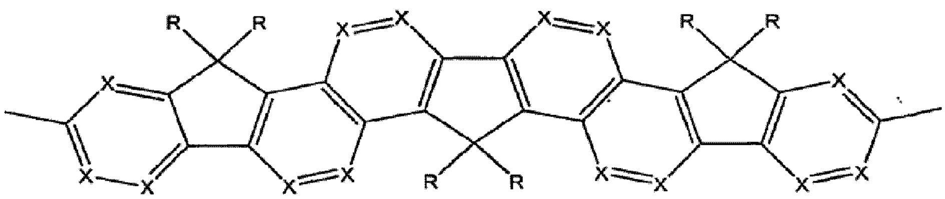

and wherein

X is independently selected from N, CH, or $CR_1$ where $R_1$ is independently selected from hydrocarbyl groups $C_jH_{2j+1}$, branched hydrocarbyl groups, or hydrocarbyl groups with one or more heteroatoms of S, N, O, P, or Si with j = 1 to 6; and

R is independently selected from hydrocarbyl groups, $C_mH_{2m+1}$, branched hydrocarbyl groups, or hydrocarbyl groups with one or more heteroatoms of S, N, O, P, or Si, with m = 1 to 15, and
the Ar and D diradicals are independently selected in each of the n subunits of the chromophore.

Preferably, the crosslinkable end group B is chosen from 1,4-pentadien-3-yl, methacrylato, ethacrylato, vinyloxy, alkylvinyloxy, ethoxyfumarato, ethoxymaleato, N-maleimido, vinyloxyfumarato, vinyloxymaleato, alkylvinyloxyethacrylato, alkylvinyloxyethacrylato, or N-(2-vinyloxy)maleimido.
Preferably, one or more metallic atoms are chemically bonded into the aromatic molecular nucleus A.
Preferably, the aromatic diradical Ar is chosen from:

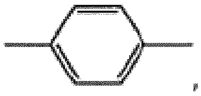 , 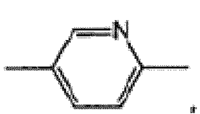 , 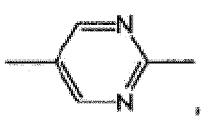 , 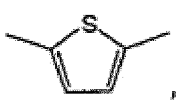 , 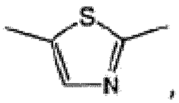 ,

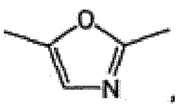, 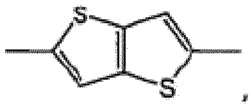, 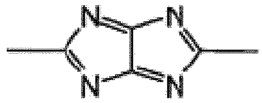, 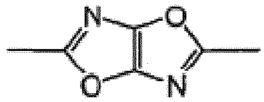,

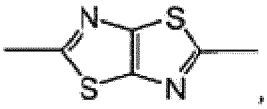, 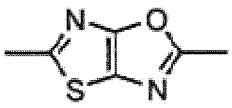, 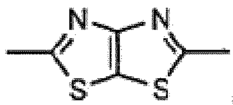, 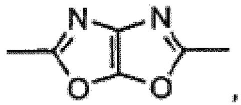,

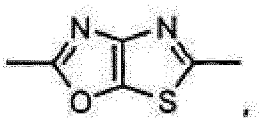, 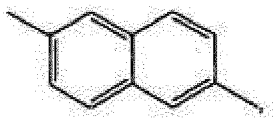 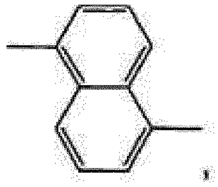, 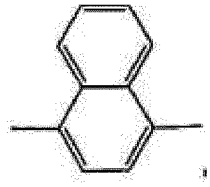,

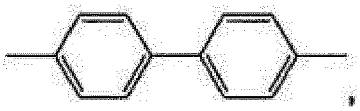, or 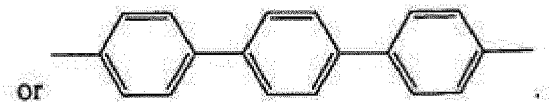.

In a second aspect of the present invention there is provided an organic semiconductor, charge transporting or light emitting polymer formed from a polymerisable material according to the first aspect.

Preferably, the polymer exhibits a liquid crystalline structure.

Preferably, the structure of the polymer is thermotropic or monotropic. Preferably, the polymer has a calamitic, nematic, or a discotic structure.

In a third aspect of the present invention, there is described a use of a polymer according to the second aspect in an electronic or optical application that utilizes phosphorescence.

There is described herein a first material, a second mixture of materials and a third process as embodiments not forming part of the invention.

A first material for use in forming organic semiconductor, charge transporting or light emitting polymers includes a polymer formed from a mixture of at least two polymerizable components. At least one of the at least two components includes molecules of the general formula:

$$A_e\text{-}(\text{-}S\text{-}B_e)_n,$$

and at least another one of the at least two components includes molecules of the general formula:

$$A_e\text{-}(\text{-}S\text{-}B_d)_m$$

wherein

$A_e$ is a substantially aromatic molecular nucleus,
$B_e$ is an independently selected crosslinking group,
$A_d$ is a substantially aromatic molecular nucleus,
$B_d$ is an independently selected crosslinking group,
S is independently selected flexible spacer,
n is from 1 to 20, and
m is from 1 to 20.

The polymerization of the mixture is initiated by electron transfer from $B_e$ groups to $B_d$ groups.

The polymerization may be photopolymerization. The polymer may be an electroluminescent material. The polymer may be included in a field effect transistor or a photovoltaic device. The polymer may be used in a luminescent application. The polymer may exhibit a thermotropic or monotropic liquid crystalline structure, such as a calamitic structure, a nematic structure, or a discotic structure. The crosslinking group $B_e$ may be a vinyl ether group. The crosslinking group $B_d$ may be a maleimide group, a maleate group, or a fumarate group. The at least one of the substantially aromatic

molecular nuclei, $A_e$ or $A_d$, may be organometallic in nature.

A second mixture of materials for use in forming organic semiconductor, charge transporting or light emitting polymers includes a mixture of at least two polymerizable components. At least one of the at least two components includes molecules of the general formula:

$$A_e\text{-}(\text{-}S\text{-}B_e)_n,$$

and

At least another one of the at least two components includes molecules of the general formula:

$$A_e\text{-}(\text{-}S\text{-}B_d)_m$$

wherein

$A_e$ is a substantially aromatic molecular nucleus,

$B_e$ is an independently selected crosslinking group,

$A_d$ is a substantially aromatic molecular nucleus,

$B_d$ is an independently selected crosslinking group,

S is independently selected flexible spacer,

n is from 1 to 20, and

m is from 1 to 20.

The mixture is photopolymerizable by initiating electron transfer from $B_e$ groups to $B_d$ groups.

The mixture may be photopolymerizable. The mixture may form an electroluminescent material upon polymerization. The mixture may be included in a field effect transistor or a photovoltaic device. The mixture may be used in a luminescent application. The mixture may exhibit a liquid crystalline phase such as a calamitic phase, a nematic phase, or a discotic phase. The crosslinking group $B_e$ may be a vinyl ether group. The crosslinking group $B_d$ may be a maleimide group, a maleate group, or a fumarate group.

The at least one of the substantially aromatic molecular nuclei, $A_e$ or $A_d$, may be organometallic in nature.

A third process for forming organic semiconductor, charge transporting or light emitting polymers includes photopolymerization of a mixture of at least two polymerizable components. At least one of the at least two components includes molecules of the general formula:

$$A_e\text{-}(\text{-}S\text{-}B_e)_n,$$

and at least another one of the at least two components includes molecules of the general formula:

$$A_e\text{-}(\text{-}S\text{-}B_d)_m$$

wherein

$A_e$ is a substantially aromatic molecular nucleus,
$B_e$ is an independently selected crosslinking group,
$A_d$ is a substantially aromatic molecular nucleus,
$B_d$ is an independently selected crosslinking group,
S is independently selected flexible spacer,
n is from 1 to 20, and
m is from 1 to 20.

The photopolymerization is initiated by electron transfer from $B_e$ groups to $B_d$ groups.

The polymerization may be photopolymerization. The mixture after polymerization may form an electroluminescent material. The mixture after polymerization may be included in a field effect transistor or a photovoltaic device.

The mixture after polymerization is used in a luminescent application. The mixture before polymerization may exhibit a liquid crystalline phase such as a calamitic phase, a nematic phase, or a discotic phase. The crosslinking group $B_e$ may be a vinyl ether group. The crosslinking group $B_d$ may be a maleimide group, a maleate group, or a fumarate group. The at least one of the substantially aromatic molecular nuclei, $A_e$ or $A_d$, may be organometallic in nature.

For the first material, second mixture of materials and third process, the at least one of the substantially aromatic molecular nuclei, $A_e$ or $A_d$, may have the structure:

$$-(Ar\text{-}F)_n\text{-}Ar\ -$$

wherein

Ar is independently selected from an aromatic diradical, a heteroaromatic diradical bonded linearly or substantially linearly to adjoining diradicals, or a single bond;

F is an independently selected diradical having the structure:

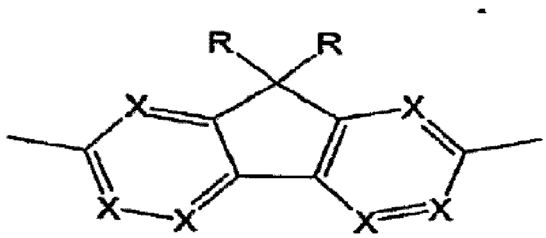

wherein X is independently selected from N, CH, or $CR_1$ where $R_1$ is independently selected from hydrocarbyl groups, $C_jH_{2j+1}$, branched hydrocarbyl groups, or hydrocarbyl groups with one or more heteroatoms of S, N, O, P, or Si with j = 1 to 6; and

R is independently selected from hydrocarbyl groups, $C_mH_{2m+1}$, branched hydrocarbyl groups, or hydrocarbyl groups with one or more heteroatoms of S, N, O, P, or Si, with m = 1 to 15, and

The Ar and F diradicals are independently selected in each of the n subunits of the chromophore; and

For the first material, second mixture of materials and third process, the at least one of the substantially aromatic molecular nuclei, $A_e$ or $A_d$, may have the structure

$$-(Ar\text{-}D)_n\text{-}Ar\text{-}$$

wherein

Ar is independently selected from an aromatic diradical, a heteroaromatic diradical bonded linearly or substantially linearly to adjoining diradicals, or a single bond;

D is a diradical having the structure:

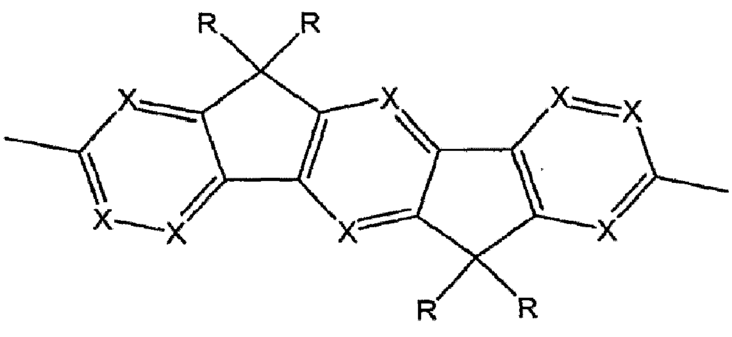

wherein

X is independently selected from N, CH, or $CR_1$ where $R_1$ is independently selected from hydrocarbyl groups, $C_jH_{2j+1}$, branched hydrocarbyl groups, or hydrocarbyl groups with one or more heteroatoms of S, N, O, P, or Si with j = 1 to 6=; and

R is independently selected from hydrocarbyl groups, $C_mH_{2m+1}$, branched hydrocarbyl groups, or hydrocarbyl groups with one or more heteroatoms of S, N, O, P, or Si, with m = 1 to 15, and

the Ar and D diradicals are independently selected in each of the n subunits of the chromophore; and

n = 1 to 6.

For the first material, second mixture of materials and third process, the at least one of the substantially aromatic molecular nuclei, $A_e$ or $A_d$, may have the structure: -

$(Ar-T)_n-Ar-$

wherein

Ar is independently selected from an aromatic diradical, a heteroaromatic diradical bonded linearly or substantially linearly to adjoining diradicals, or a single bond;
T is a diradical having the structure:

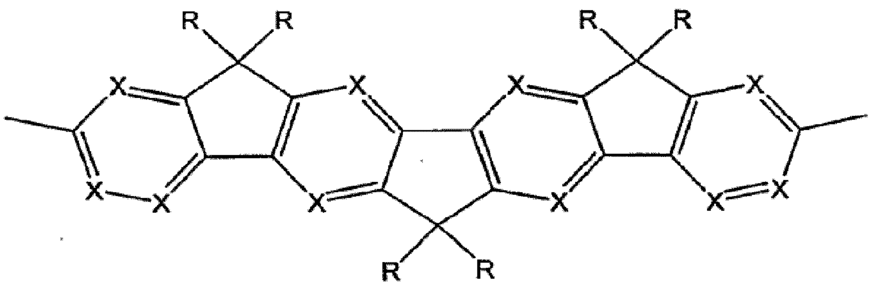

wherein

X is independently selected from N, CH, or $CR_1$ where $R_1$ is independently selected from hydrocarbyl groups, $C_jH_{2j+1}$, branched hydrocarbyl groups, or hydrocarbyl groups with one or more heteroatoms of S, N, O, P, or Si with j = 1 to 6; and
R is independently selected from hydrocarbyl groups, $C_mH_{2m+1}$, branched hydrocarbyl groups, or hydrocarbyl groups with one or more heteroatoms of S, N, O, P, or Si with m = 1 to 15, and

n = 1 to 4,
wherein the Ar and T diradicals are independently selected in each of the n subunits of the chromophore.

For the first material, second mixture of materials and third process, the at least one of the substantially aromatic molecular nuclei, $A_e$ or $A_d$, may have the structure:

$-(Ar-Q)_n-Ar-$

wherein

Ar is independently selected from an aromatic diradical, a heteroaromatic diradical bonded linearly or substantially linearly to adjoining diradicals, or a single bond;

Q is a diradical having the structure:

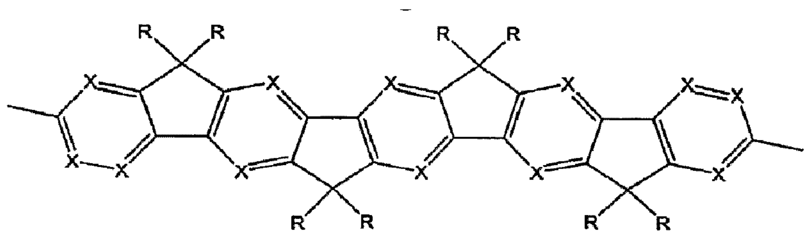

wherein

X is independently selected from N, CH, or $CR_1$ where $R_1$ is independently selected from hydrocarbyl groups, $C_jH_{2j+1}$, branched hydrocarbyl groups, or hydrocarbyl groups with one or more heteroatoms of S, N, O, P, or Si with j = 1 to 6; and

R is independently selected from hydrocarbyl groups, $C_mH_{2m+1}$, branched hydrocarbyl groups, or hydrocarbyl groups with one or more heteroatoms of S, N, O, P, or Si with m = 1 to 15, and

n = 1 to 4,

wherein the Ar and Q diradicals are independently selected in each of the n subunits of the chromophore.

For the first material, second mixture of materials and third process, the at least one of the substantially aromatic molecular nuclei, $A_e$ or $A_d$, may have the structure:

$$-(Ar-N)_n-Ar-$$

wherein

Ar is independently selected form an aromatic diradical, a heteroaromatic diradical bonded linearly or substantially linearly to adjoining diradicals, or a single bond;

N is a diradical having the structure:

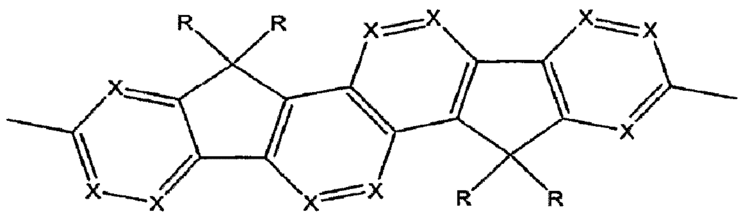

wherein

X is independently selected from N, CH, or $CR_1$ where $R_1$ is independently selected from hydrocarbyl groups, $C_jH_{2j+1}$, branched hydrocarbyl groups, or hydrocarbyl groups with one or more heteroatoms of S, N, O, P, or Si with j = 1 to 6; and

R is independently selected from hydrocarbyl groups, $C_mH_{2m+1}$ branched hydrocarbyl groups, or hydrocarbyl groups with one or more heteroatoms of S, N, O, P, or Si with m = 1 to 15, and

n = 1 to 6,

wherein the Ar and N diradicals are independently selected in each of the n subunits of the chromophore.

For the first material, second mixture of materials and third process, the at least one of the substantially aromatic molecular nuclei, $A_e$ or $A_d$, may have the structure:

$-(Ar-L)_n-Ar-$

wherein

Ar is independently selected from an aromatic diradical, a heteroaromatic diradical bonded linearly or substantially linearly to adjoining diradicals, or a single bond;

L is a diradical having the structure:

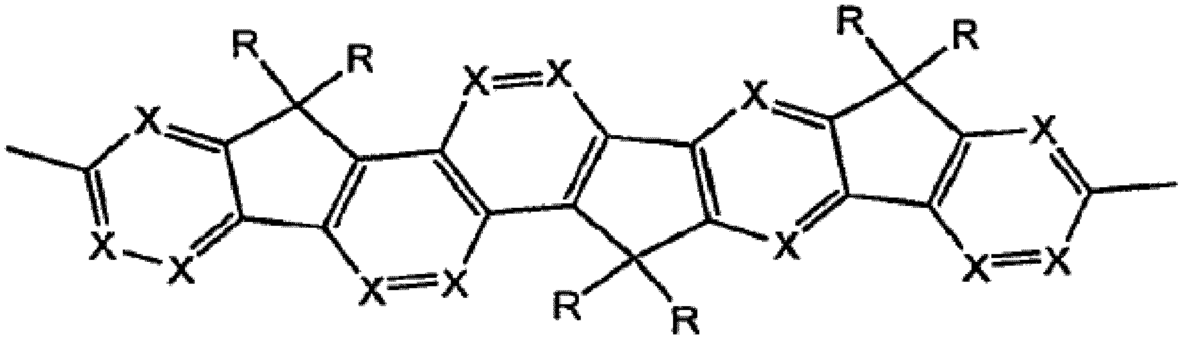

wherein

X is independently selected from N, CH, or $CR_1$ where $R_1$ is independently selected from hydrocarbyl groups, $C_jH_{2j+1}$, branched hydrocarbyl groups, or hydrocarbyl groups with one or more heteroatoms of S, N, O, P, or Si with j = 1 to 6; and

R is independently selected from hydrocarbyl groups, $C_mH_{2m+1}$, branched hydrocarbyl groups, or hydrocarbyl groups with one or more heteroatoms of S, N, O, P, or Si with m = 1 to 15, and

n = 1 to 4,

wherein the Ar and L diradicals are independently selected in each of the n subunits of the chromophore.

For the first material, second mixture of materials and third process, the at least one of the substantially aromatic molecular nuclei, $A_e$ or $A_d$, may have the structure:

$-(Ar-M)_n-Ar-$

wherein

Ar is independently selected form an aromatic diradical, a heteroaromatic diradical bonded linearly or substantially linearly to adjoining diradicals, or a single bond;

M is a diradical having the structure:

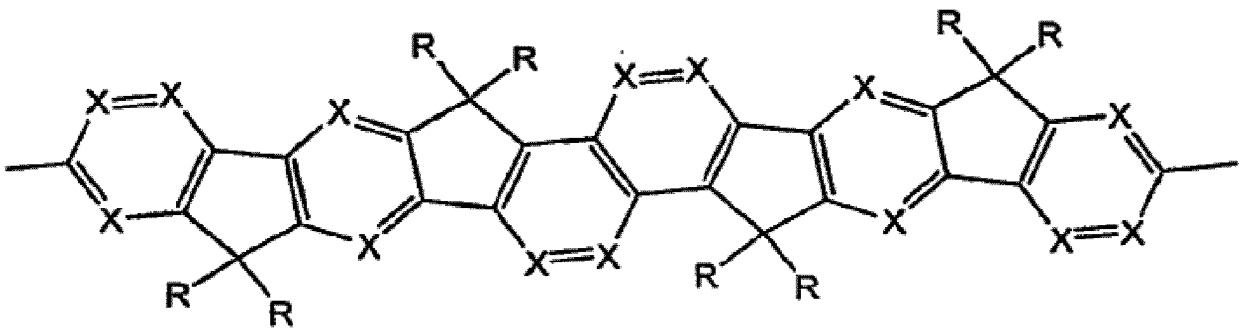

wherein

X is independently selected from N, CH, or $CR_1$ where $R_1$ is independently selected from hydrocarbyl groups, $C_jH_{2j+1}$, branched hydrocarbyl groups, or hydrocarbyl groups with one or more heteroatoms of S, N, O, P, or Si with j = 1 to 6; and,

R is independently selected from hydrocarbyl groups, $C_mH_{2m+1}$ branched hydrocarbyl groups, or hydrocarbyl groups with one or more heteroatoms of S, N, O, P, or Si with m = 1 to 15, and

n = 1 to 4,

wherein the Ar and M diradicals are independently selected in each of the n subunits of the chromophore.

For the first material, second mixture of materials and third process, the at least one of the substantially aromatic molecular nuclei, $A_e$ or $A_d$, may have the structure:

$$-(Ar\text{-}G)_n\text{-}Ar\text{-}$$

wherein

Ar is independently selected from an aromatic diradical, a heteroaromatic diradical bonded linearly or substantially linearly to adjoining diradicals, or a single bond;

G is a diradical having the structure:

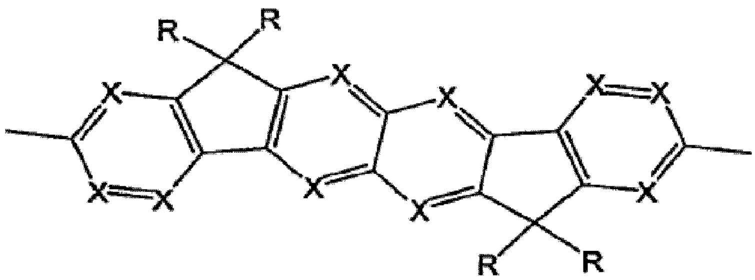

wherein

X is independently selected from N, CH, or $CR_1$ where $R_1$ is independently selected from hydrocarbyl groups, $C_jH_{2j+1}$, branched hydrocarbyl groups, or hydrocarbyl groups with one or more heteroatoms of S, N, O, P, or Si with j = 1 to 6; and,

R is independently selected from hydrocarbyl groups, $C_mH_{2m+1}$, branched hydrocarbyl groups, or hydrocarbyl groups with one or more heteroatoms of S, N, O, P, or Si with m = 1 to 15, and

n = 1 to 6,

wherein the Ar and G diradicals are independently selected in each of the n subunits of the chromophore.

For the first material, second mixture of materials and third process, the at least one of the substantially aromatic molecular nuclei, $A_e$ or $A_d$, may have the structure:

$$-(Ar\text{-}S')_n\text{-}Ar\text{-}$$

wherein

Ar is independently selected from an aromatic diradical, a heteroaromatic diradical bonded linearly or substantially linearly to adjoining diradicals, or a single bond;

S' is a diradical having the structure:

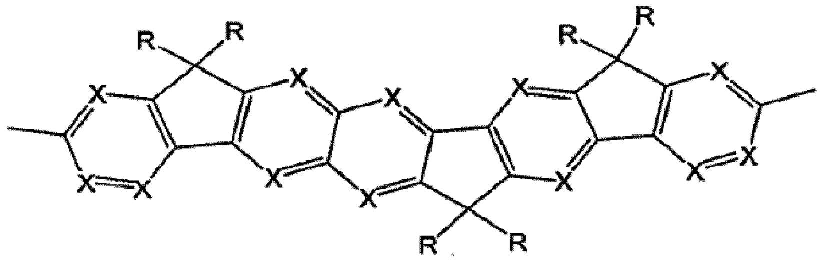

wherein

X is independently selected from N, CH, or $CR_1$ where $R_1$ is independently selected from hydrocarbyl groups, $C_jH_{2j+1}$, branched hydrocarbyl groups, or hydrocarbyl groups with one or more heteroatoms of S, N, O, P, or Si with j = 1 to 6; and,

R is independently selected from hydrocarbyl groups, $C_mH_{2m+1}$, branched hydrocarbyl groups, or hydrocarbyl groups with one or more heteroatoms of S, N, O, P, or Si with m = 1 to 15, and

n = 1 to 4,

wherein the Ar and S' diradicals are independently selected in each of the n subunits of the chromophore.

For the first material, second mixture of materials and third process, the at least one of the substantially aromatic molecular nuclei, $A_e$ or $A_d$, may have the structure:

$$-(Ar-U)_n-Ar-$$

wherein

Ar is independently selected from an aromatic diradical, a heteroaromatic diradical bonded linearly or substantially linearly to adjoining diradicals, or a single bond;

U is a diradical having the structure:

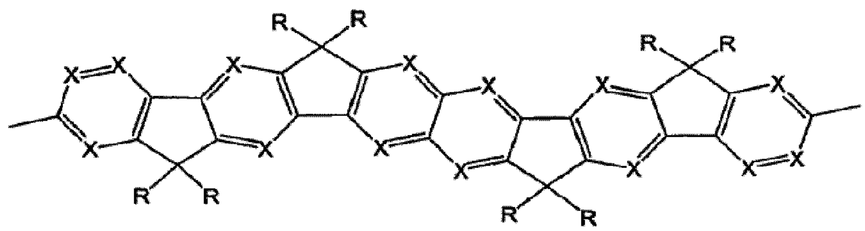

wherein

X is independently selected from N, CH, or $CR_1$ where $R_1$ is independently selected from hydrocarbyl groups, $C_jH_{2j+1}$, branched hydrocarbyl groups, or hydrocarbyl groups with one or more heteroatoms of S, N, O, P, or Si with j = 1 to 6; and,

R is independently selected from hydrocarbyl groups, $C_mH_{2m+1}$, branched hydrocarbyl groups, or hydrocarbyl groups with one or more heteroatoms of S, N, O, P, or Si with m = 1 to 15, and

n = 1 to 4,

wherein the Ar and U diradicals are independently selected in each of the n subunits of the chromophore.

For the first material, second mixture of materials and third process, the at least one of the substantially aromatic molecular nuclei, $A_e$ or $A_d$, may have the structure:

$$-(Ar-V)_n-Ar-$$

wherein

Ar is independently selected from an aromatic diradical, a heteroaromatic diradical bonded linearly or substantially linearly to adjoining diradicals, or a single bond;
V is a diradical having the structure:

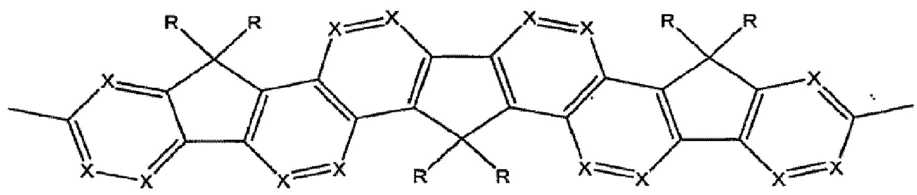

wherein

X is independently selected from N, CH, or $CR_1$ where $R_1$ is independently selected from hydrocarbyl groups, $C_jH_{2j+1}$, branched hydrocarbyl groups, or hydrocarbyl groups with one or more heteroatoms of S, N, O, P, or Si with j = 1 to 6; and,
R is independently selected from hydrocarbyl groups, $C_mH_{2m+1}$, branched hydrocarbyl groups, or hydrocarbyl groups with one or more heteroatoms of S, N, O, P, or Si with m = 1 to 15, and

n = 1 to 4,
wherein the Ar and V diradicals are independently selected in each of the n subunits of the chromophore.

There are described herein fourth to thirteenth materials.

A fourth material for use in forming organic semiconductor, charge transporting or light emitting polymers includes a polymerizable material having the molecular structure

B-S-A-S-B,

wherein

B is a crosslinkable end group;
S is a flexible spacer; and
A is a substantially aromatic molecular nucleus having

the structure:

$$-(Ar-D)_n-Ar-$$

wherein

n = 1 to 6;
Ar is an aromatic diradical, a heteroaromatic diradical bonded linearly or substantially linearly to adjoining diradicals, or a single bond;
D is a diradical having the structure:

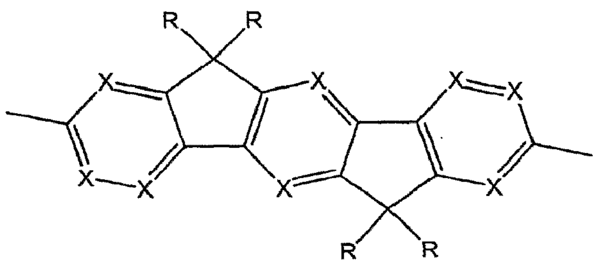

wherein

X is independently selected from N, CH, or $CR_1$ where $R_1$ is independently selected from hydrocarbyl groups, $C_jH_{2j+1}$, branched hydrocarbyl groups, or hydrocarbyl groups with one or more heteroatoms of S, N, O, P, or Si with j = 1 to 6; and,

R is independently selected from hydrocarbyl groups, $C_mH_{2m+1}$, branched hydrocarbyl groups, or hydrocarbyl groups with one or more heteroatoms of S, N, O, P, or Si, with m = 1 to 15, and

the Ar and D diradicals are independently selected in each of the n subunits of the chromophore.

A fifth material for use in forming organic semiconductor, charge transporting or light emitting polymers includes a polymerizable material having the molecular structure

B-S-A-S-B,

wherein

B is a crosslinkable end group;

S is a flexible spacer; and

A is a substantially aromatic molecular nucleus having the structure

$-(Ar-T)_n-Ar-$

wherein

n = 1 to 4;

Ar is an aromatic diradical, a heteroaromatic diradical bonded linearly or substantially linearly to adjoining diradicals, or a single bond;

T is a diradical having the structure

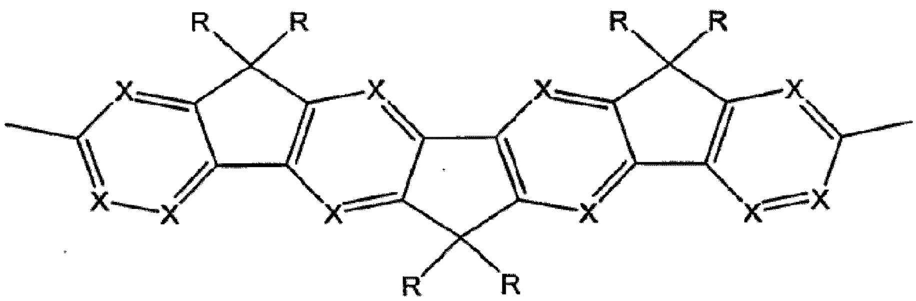

wherein

X is independently selected from N, CH, or $CR_1$ where $R_1$ is independently selected from hydrocarbyl groups, $C_jH_{2j+1}$, branched hydrocarbyl groups, or hydrocarbyl groups with one or more heteroatoms of S, N, O, P, or Si with j = 1 to 6; and,

R is independently selected from hydrocarbyl groups, $C_mH_{2m+1}$, branched hydrocarbyl groups, or hydrocarbyl groups with one or more heteroatoms of S, N, O, P, or Si with m = 1 to 15, and

the Ar and T diradicals are independently selected in each of the n subunits of the chromophore.

A sixth material for use in forming organic semiconductor, charge transporting or light emitting polymers includes a polymerizable material having the molecular structure

B-S-A-S-B,

wherein

B is a crosslinkable end group;

S is a flexible spacer; and

A is a substantially aromatic molecular nucleus having the structure

$-(Ar-Q)_n-Ar-$

wherein

n = 1 to 4;

Ar is an aromatic diradical, a heteroaromatic diradical bonded linearly or substantially linearly to adjoining diradicals, or a single bond;

Q is a diradical having the structure

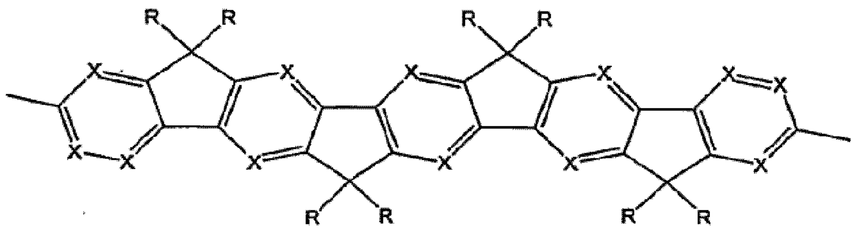

wherein

X is independently selected from N, CH, or $CR_1$ where $R_1$ is independently selected from hydrocarbyl groups, $C_jH_{2j+1}$, branched hydrocarbyl groups, or hydrocarbyl groups with one or more heteroatoms of S, N, O, P, or Si with j = 1 to 6; and,

R is independently selected from hydrocarbyl groups, $C_mH_{2m+1}$, branched hydrocarbyl groups, or hydrocarbyl groups with one or more heteroatoms of S, N, O, P, or Si with m = 1 to 15, and

the Ar and Q diradicals are independently selected in each of the n subunits of the chromophore.

A seventh material for use in forming organic semiconductor, charge transporting or light emitting polymers includes a polymerizable material having the molecular structure B-S-A-S-B,
wherein

B is a crosslinkable end group;

S is a flexible spacer; and

A is substantially aromatic molecular nucleus having the structure $-(Ar-N)_n-Ar-$ wherein

n = 1 to 6;

Ar is an aromatic diradical, a heteroaromatic diradical bonded linearly or substantially linearly to adjoining diradicals, or a single bond;

N is a diradical having the structure

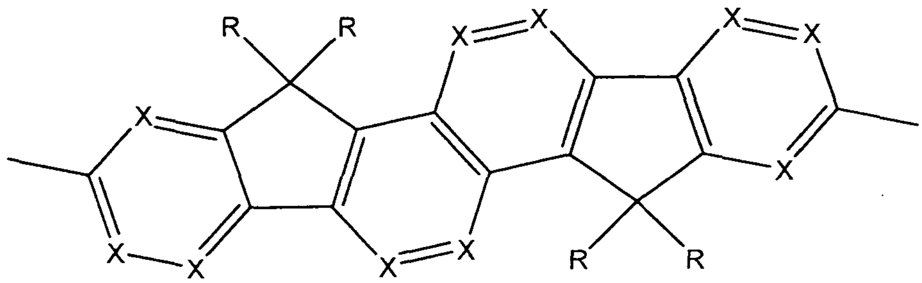

wherein

X is independently selected from N, CH, or $CR_1$ where $R_1$ is independently selected from hydrocarbyl groups, $C_jH_{2j+1}$, branched hydrocarbyl groups, or hydrocarbyl groups with one or more heteroatoms of S, N, O, P, or Si with j = 1 to 6; and,

R is independently selected from hydrocarbyl groups, $C_mH_{2m+1}$, branched hydrocarbyl groups, or hydrocarbyl groups with one or more heteroatoms of S, N, O, P, or Si with m = 1 to 15, and

the Ar and N diradicals are independently selected in each of the n subunits of the chromophore.

An eighth material for use in forming organic semiconductor, charge transporting or light emitting polymers includes a polymerizable material having the molecular structure B-S-A-S-B, wherein

B is a crosslinkable end group;

S is a flexible spacer; and

A is substantially aromatic molecular nucleus having the structure

$$-(Ar-L)_n-Ar-$$

wherein

n = 1 to 4;

Ar is an aromatic diradical, a heteroaromatic diradical bonded linearly or substantially linearly to adjoining diradicals, or a single bond;

L is a diradical having the structure

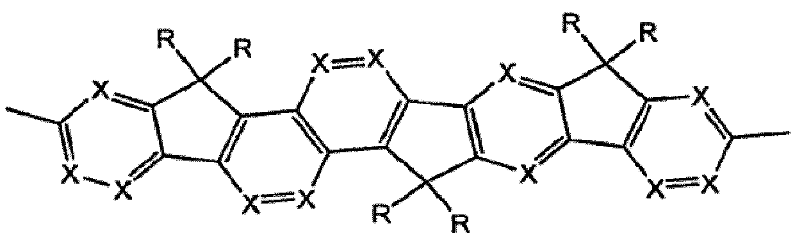

wherein

X is independently selected from N, CH, or $CR_1$ where $R_1$ is independently selected from hydrocarbyl groups, $C_jH_{2j+1}$, branched hydrocarbyl groups, or hydrocarbyl groups with one or more heteroatoms of S, N, O, P, or Si with j = 1 to 6; and,

R is independently selected from hydrocarbyl groups, $C_mH_{2m+1}$ branched hydrocarbyl groups, or hydrocarbyl groups with one or more heteroatoms of S, N, O, P, or Si with m = 1 to 15, and

the Ar and L diradicals are independently selected in each of the n subunits of the chromophore.

A ninth material for use in forming organic semiconductor, charge transporting or light emitting polymers includes a polymerizable material having the molecular structure B-S-A-S-B,
wherein

B is a crosslinkable end group;

S is a flexible spacer; and

A is a substantially aromatic molecular nucleus having the structure - $(Ar-M)_n$-Ar-
wherein

n = 1 to 4;

Ar is an aromatic diradical, a heteroaromatic diradical bonded linearly or substantially linearly to adjoining diradicals, or a single bond;

M is a diradical having the structure

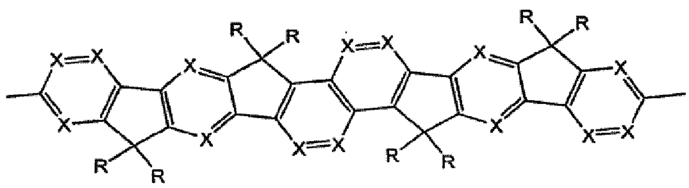

wherein

X is independently selected from N, CH, or $CR_1$ where $R_1$ is independently selected from hydrocarbyl groups, $C_jH_{2j+1}$, branched hydrocarbyl groups, or hydrocarbyl groups with one or more heteroatoms of S, N, O, P, or Si with j = 1 to 6; and,
R is independently selected from hydrocarbyl groups, $C_mH_{2m+1}$, branched hydrocarbyl groups, or hydrocarbyl groups with one or more heteroatoms of S, N, O, P, or Si with m = 1 to 15, and

the Ar and M diradicals are independently selected in each of the n subunits of the chromophore.

A tenth material for use in forming organic semiconductor, charge transporting or light emitting polymers includes a polymerizable material having the molecular structure B-S-A-S-B,
wherein

B is a crosslinkable end group;

S is a flexible spacer; and

A is a substantially aromatic molecular nucleus having the structure

$$-(Ar-G)_n-Ar-$$

wherein

n = 1 to 6;

Ar is an aromatic diradical, a heteroaromatic diradical bonded linearly or substantially linearly to adjoining diradicals, or a single bond;
G is a diradical having the structure

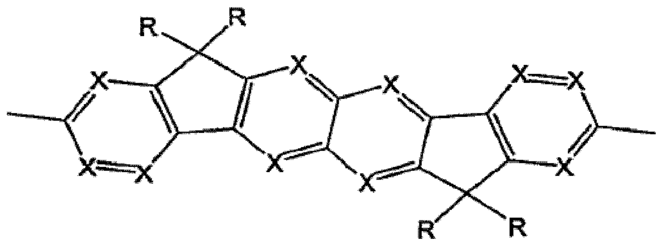

wherein

X is independently selected from N, CH, or $CR_1$ where $R_1$ is independently selected from hydrocarbyl groups, $C_jH_{2j+1}$, branched hydrocarbyl groups, or hydrocarbyl groups with one or more heteroatoms of S, N, O, P, or Si with j = 1 to 6; and,

R is independently selected from hydrocarbyl groups, $C_mH_{2m+1}$, branched hydrocarbyl groups, or hydrocarbyl groups with one or more heteroatoms of S, N, O, P, or Si with m = 1 to 15, and

the Ar and G diradicals are independently selected in each of the n subunits of the chromophore.

An eleventh material for use in forming organic semiconductor, charge transporting or light emitting polymers includes a polymerizable material having the molecular structure B-S-A-S-B,
wherein

B is a crosslinkable end group;

S is a flexible spacer; and

A is a substantially aromatic molecular nucleus having the structure

$$-(Ar-S')_n-Ar-$$

wherein

n = 1 to 4;
Ar is an aromatic diradical, a heteroaromatic diradical bonded linearly or substantially linearly to adjoining diradicals, or a single bond;
S' is a diradical having the structure

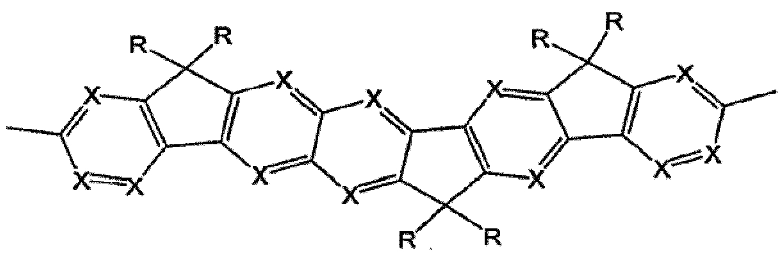

wherein

X is independently selected from N, CH, or $CR_1$ where $R_1$ is independently selected from hydrocarbyl groups, $C_jH_{2j+1}$, branched hydrocarbyl groups, or hydrocarbyl groups with one or more heteroatoms of S,

N, O, P, or Si with j = 1 to 6; and,

R is independently selected from hydrocarbyl groups, $C_mH_{2m+1}$, branched hydrocarbyl groups, or hydrocarbyl groups with one or more heteroatoms of S, N, O, P, or Si with m = 1 to 15, and

the Ar and S' diradicals are independently selected in each of the n subunits of the chromophore.

A twelfth material for use in forming organic semiconductor, charge transporting or light emitting polymers includes a polymerizable material having the molecular structure B-S-A-S-B, wherein

B is a crosslinkable end group;

S is a flexible spacer; and

A is a substantially aromatic molecular nucleus having the structure

$$-(Ar-U)_n-Ar-$$

wherein

n = 1 to 4;
Ar is an aromatic diradical, a heteroaromatic diradical bonded linearly or substantially linearly to adjoining diradicals, or a single bond;
U is a diradical having the structure

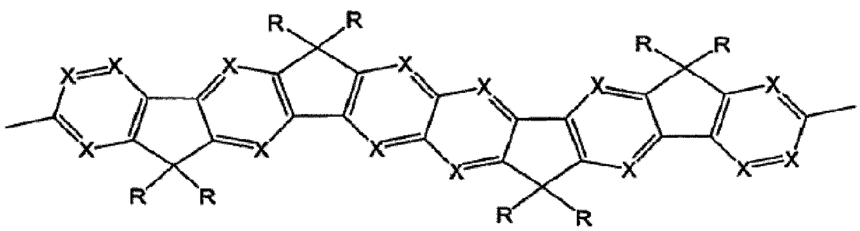

wherein

X is independently selected from N, CH, or $CR_1$ where $R_1$ is independently selected from hydrocarbyl groups, $C_jH_{2j+1}$, branched hydrocarbyl groups, or hydrocarbyl groups with one or more heteroatoms of S, N, O, P, or Si with j = 1 to 6; and,

R is independently selected from hydrocarbyl groups, $C_mH_{2m+1}$, branched hydrocarbyl groups, or hydrocarbyl groups with one or more heteroatoms of S, N, O, P, or Si with m = 1 to 15, and

the Ar and U diradicals are independently selected in each of the n subunits of the chromophore.

A thirteenth material for use in forming organic semiconductor, charge transporting or light emitting polymers includes a polymerizable material having the molecular structure

B-S-A-S-B,

wherein

B is a crosslinkable end group;

S is a flexible spacer; and

A is a substantially aromatic molecular nucleus having the structure

-(Ar-V)$_n$-Ar -

wherein

n = 1 to 4;

Ar is an aromatic diradical, a heteroaromatic diradical bonded linearly or substantially linearly to adjoining diradicals, or a single bond;
V is a diradical having the structure

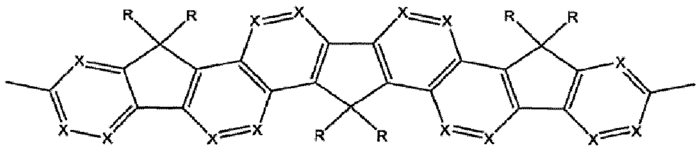

wherein

X is independently selected from N, CH, or $CR_1$ where $R_1$ is independently selected from hydrocarbyl groups, $C_jH_{2j+1}$, branched hydrocarbyl groups, or hydrocarbyl groups with one or more heteroatoms of S, N, O, P, or Si with j = 1 to 6; and,

R is independently selected from hydrocarbyl groups, $C_mH_{2m+1}$, branched hydrocarbyl groups, or hydrocarbyl groups with one or more heteroatoms of S, N, O, P, or Si with m = 1 to 15, and

the Ar and V diradicals are independently selected in each of the n subunits of the chromophore.

There are described herein fourteenth to twenty-third organic semiconductor, charge transporting or light emitting polymers.
A fourteenth organic semiconductor, charge transporting or light emitting polymer includes a polymer formed from a polymerizable material having the molecular structure B-S-A-S-B,
wherein

B is a crosslinkable end group;
S is a flexible spacer; and
A is substantially aromatic molecular nucleus having the structure -(Ar-D)$_n$-Ar-
wherein

n = 1 to 6;
Ar is an aromatic diradical, a heteroaromatic diradical bonded linearly or substantially linearly to adjoining diradicals, or a single bond;
D is a diradical having the structure

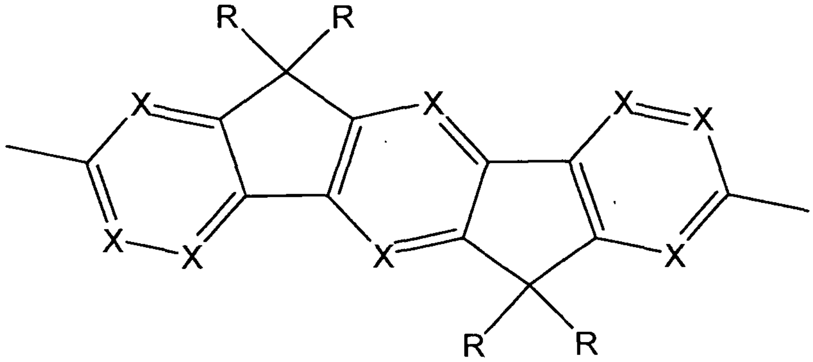

wherein

X is independently selected from N, CH, or $CR_1$ where $R_1$ is independently selected from hydrocarbyl groups, $C_jH_{2j+1}$, branched hydrocarbyl groups, or hydrocarbyl groups with one or more heteroatoms of S, N, O, P, or Si with j = 1 to 6; and,
R is independently selected from hydrocarbyl groups, $C_mH_{2m+1}$, branched hydrocarbyl groups, or hydrocarbyl groups with one or more heteroatoms of S, N, O, P, or Si with m = 1 to 15, and

the Ar and D diradicals are independently selected in each of the n subunits of the chromophore.

A fifteenth organic semiconductor, charge transporting or light emitting polymer includes a polymer formed from a polymerizable material having the molecular structure B-S-A-S-B,
wherein

B is a crosslinkable end group;

S is a flexible spacer; and

A is a substantially aromatic molecular nucleus having the structure

$$-(Ar-T)_n-Ar-$$

wherein

n = 1 to 4;

Ar is an aromatic diradical, a heteroaromatic diradical bonded linearly or substantially linearly to adjoining diradicals, or a single bond;

T is a diradical having the structure

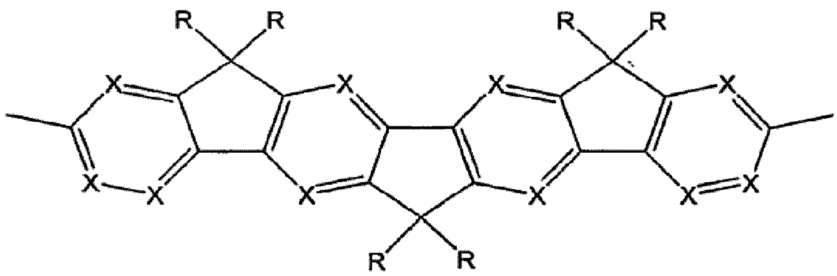

wherein

X is independently selected from N, CH, or $CR_1$ where $R_1$ is independently selected from hydrocarbyl groups, $C_jH_{2j+1}$, branched hydrocarbyl groups, or hydrocarbyl groups with one or more heteroatoms of S, N, O, P, or Si with j = 1 to 6; and,
R is independently selected from hydrocarbyl groups, $C_mH_{2m+1}$, branched hydrocarbyl groups, or hydrocarbyl groups with one or more heteroatoms of S, N, O, P, or Si with m = 1 to 15, and
the Ar and T diradicals are independently selected in each of the n subunits of the chromophore.

A sixteenth organic semiconductor, charge transporting or light emitting polymer includes a polymer formed from a polymerizable material having the molecular structure B-S-A-S-B,
wherein

B is a crosslinkable end group;
S is a flexible spacer; and
A is a substantially aromatic molecular nucleus having the structure

$$-(Ar-Q)_n-Ar-$$

wherein

n = 1 to 4;

Ar is an aromatic diradical, a heteroaromatic diradical bonded linearly or substantially linearly to adjoining diradicals, or a single bond;

Q is a diradical having the structure

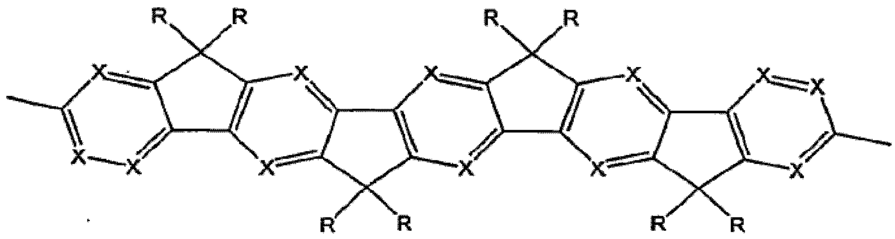

wherein

X is independently selected from N, CH, or $CR_1$ where $R_1$ is independently selected from hydrocarbyl groups, $C_jH_{2j+1}$, branched hydrocarbyl groups, or hydrocarbyl groups with one or more heteroatoms of S, N, O, P, or Si with j = 1 to 6; and,

R is independently selected from hydrocarbyl groups, $C_mH_{2m+1}$, branched hydrocarbyl groups, or hydrocarbyl groups with one or more heteroatoms of S, N, O, P, or Si with m = 1 to 15, and

the Ar and Q diradicals are independently selected in each of the n subunits of the chromophore.

A seventeenth organic semiconductor, charge transporting or light emitting polymer includes a polymer formed from a polymerizable material having the molecular structure B-S-A-S-B,
wherein

B is a crosslinkable end group;

S is a flexible spacer; and

A is a substantially aromatic molecular nucleus having the structure $-(Ar-N)_n-Ar-$
wherein

n = 1 to 6;

Ar is an aromatic diradical, a heteroaromatic diradical bonded linearly or substantially linearly to adjoining diradicals, or a single bond;

N is a diradical having the structure

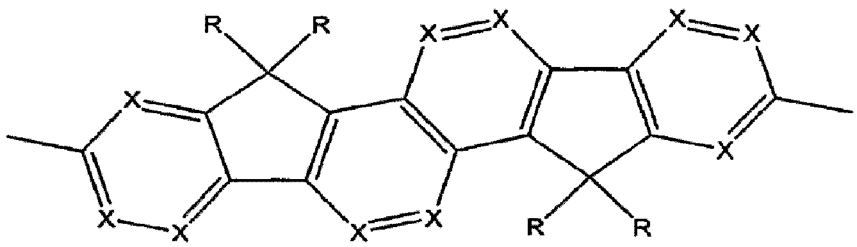

wherein

X is independently selected from N, CH, or $CR_1$ where $R_1$ is independently selected from hydrocarbyl groups, $C_jH_{2j+1}$, branched hydrocarbyl groups, or hydrocarbyl groups with one or more heteroatoms of S, N, O, P, or Si with j = 1 to 6; and,

R is independently selected from hydrocarbyl groups, $C_mH_{2m+1}$, branched hydrocarbyl groups, or hydrocarbyl groups with one or more heteroatoms of S, N, O, P, or Si with m = 1 to 15, and

the Ar and N diradicals are independently selected in each of the n subunits of the chromophore.

An eighteenth organic semiconductor, charge transporting or light emitting polymer includes a polymer formed from a polymerizable material having the molecular structure B-S-A-S-B,
wherein

B is a crosslinkable end group;

S is a flexible spacer; and

A is a substantially aromatic molecular nucleus having the structure $-(Ar-L)_n-Ar-$
wherein

n = 1 to 4;
Ar is an aromatic diradical, a heteroaromatic diradical bonded linearly or substantially linearly to adjoining diradicals, or a single bond;
L is a diradical having the structure

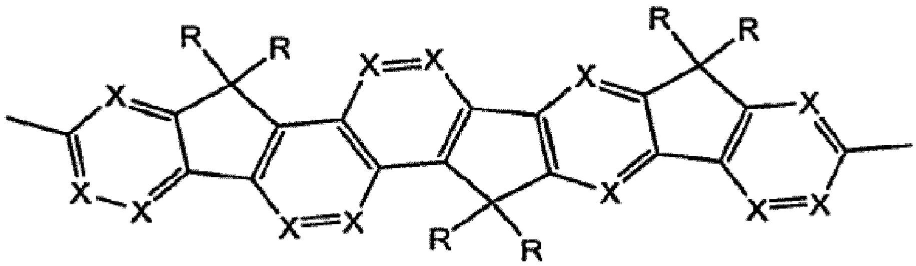

wherein

X is independently selected from N, CH, or $CR_1$, where $R_1$ is independently selected from hydrocarbyl groups, branched hydrocarbyl groups, or hydrocarbyl groups with one or more heteroatoms of S, N, O, P, or Si with j = 1 to 6; and,

R is independently selected from hydrocarbyl groups, $C_mH_{2m+1}$, branched hydrocarbyl groups, or hydrocarbyl groups with one or more heteroatoms of S, N, O, P, or Si with m = 1 to 15, and

the Ar and L diradicals are independently selected in each of the n subunits of the chromophore.

A nineteenth organic semiconductor, charge transporting or light emitting polymer includes a polymer formed from a polymerizable material having the molecular structure

B-S-A-S-B,

wherein

B is a crosslinkable end group;

S is a flexible spacer; and

A is a substantially aromatic molecular nucleus having the structure

-(Ar-M)$_n$-Ar-

wherein

n = 1 to 4;

Ar is an aromatic diradical, a heteroaromatic diradical bonded linearly or substantially linearly to adjoining diradicals, or a single bond;

M is a diradical having the structure

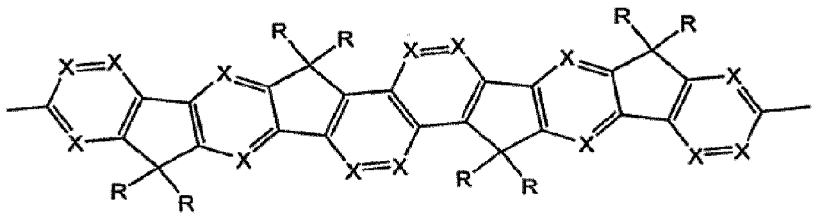

wherein

X is independently selected from N, CH, or $CR_1$, where $R_1$ is independently selected from hydrocarbyl groups, $C_jH_{2j+1}$, branched hydrocarbyl groups, or hydrocarbyl groups with one or more heteroatoms of S, N, O, P, or Si with j = 1 to 6; and,

R is independently selected from hydrocarbyl groups, $C_mH_{2m+1}$ branched hydrocarbyl groups, or hydrocarbyl groups with one or more heteroatoms of S, N, O, P, or Si with m = 1 to 15, and

the Ar and M diradicals are independently selected in each of the n subunits of the chromophore.

A twentieth organic semiconductor, charge transporting or light emitting polymer includes a polymer formed from a polymerizable material having the molecular structure B-S-A-S-B,
wherein

B is a crosslinkable end group;
S is a flexible spacer; and
A is substantially aromatic molecular nucleus having the structure -(Ar-G)$_n$-Ar-
wherein

n = 1 to 6;
Ar is an aromatic diradical, a heteroaromatic diradical bonded linearly or substantially linearly to adjoining diradicals, or a single bond;
G is a diradical having the structure

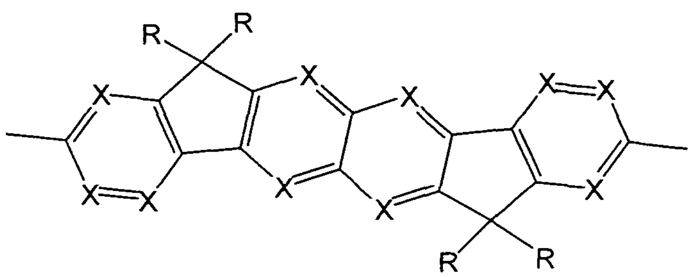

wherein

X is independently selected from N, CH, or $CR_1$ where $R_1$ is independently selected from hydrocarbyl

groups, $C_jH_{2j+1}$, branched hydrocarbyl groups, or hydrocarbyl groups with one or more heteroatoms of S, N, O, P, or Si with j = 1 to 6; and,
R is independently selected from hydrocarbyl groups, $C_mH_{2m+1}$, branched hydrocarbyl groups, or hydrocarbyl groups with one or more heteroatoms of S, N, O, P, or Si with m = 1 to 15, and

the Ar and G diradicals are independently selected in each of the n subunits of the chromophore.

A twenty-first organic semiconductor, charge transporting or light emitting polymer includes a polymer formed from a polymerizable material having the molecular structure B-S-A-S-B,
wherein

B is a crosslinkable end group;
S is a flexible spacer; and
A is a substantially aromatic molecular nucleus having the structure

$$-(Ar\text{-}S')_n\text{-}Ar-$$

wherein

n = 1 to 4;
Ar is an aromatic diradical, a heteroaromatic diradical bonded linearly or substantially linearly to adjoining diradicals, or a single bond;
S' is a diradical having the structure

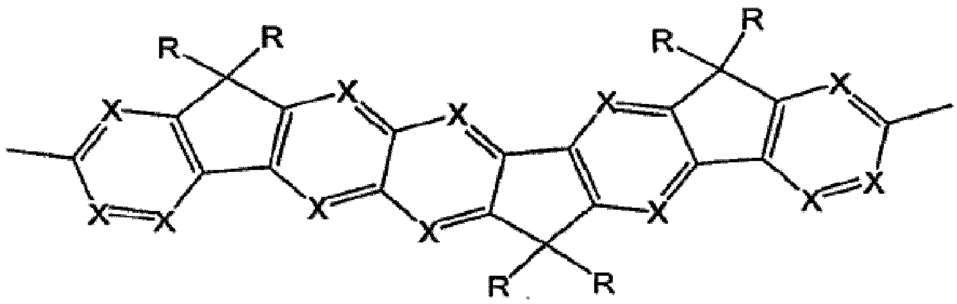

wherein

X is independently selected from N, CH, or $CR_1$, where $R_1$ is independently selected from hydrocarbyl groups, $C_jH_{2j+1}$, branched hydrocarbyl groups, or hydrocarbyl groups with one or more heteroatoms of S, N, O, P, or Si with j = 1 to 6; and,
R is independently selected from hydrocarbyl groups, $C_mH_{2m+1}$, branched hydrocarbyl groups with one or more heteroatoms of S, N, O, P, or Si with m = 1 to 15, and

the Ar and S' diradicals are independently selected in each of the n subunits of the chromophore.

A twenty-second organic semiconductor, charge transporting or light emitting polymer includes a polymer formed from a polymerizable material having the molecular structure B-S-A-S-B,
wherein

B is a crosslinkable end group;

S is a flexible spacer; and

A is a substantially aromatic molecular nucleus having the structure

$$-(Ar\text{-}U)_n\text{-}Ar-$$

wherein

n = 1 to 4;

Ar is an aromatic diradical, a heteroaromatic diradical bonded linearly or substantially linearly to adjoining diradicals, or a single bond;

U is a diradical having the structure

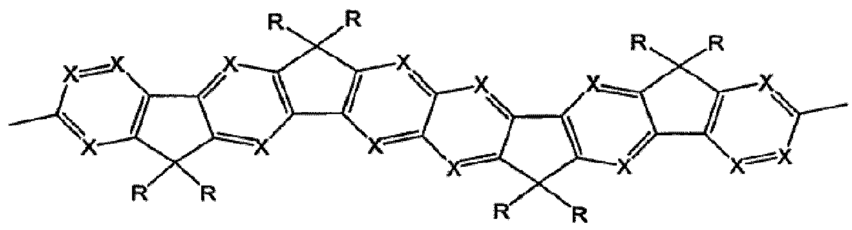

wherein

X is independently selected from N, CH, or $CR_1$, where $R_1$ is independently selected from hydrocarbyl groups, $C_jH_{2j+1}$, branched hydrocarbyl groups, or hydrocarbyl groups with one or more heteroatoms of S, N, O, P, or Si with j = 1 to 6; and,
R is independently selected from hydrocarbyl groups, $C_mH_{2m+1}$, branched hydrocarbyl groups, or hydrocarbyl groups with one or more heteroatoms of S, N, O, P, or Si with m = 1 to 15, and

the Ar and U diradicals are independently selected in each of the n subunits of the chromophore.

A twenty-third organic semiconductor, charge transporting or light emitting polymer includes a polymer formed from a polymerizable material having the molecular structure B-S-A-S-B,
wherein

B is a crosslinkable end group;

S is a flexible spacer; and

A is a substantially aromatic molecular nucleus having the structure

$$-(Ar-V)_n-Ar-$$

wherein

n = 1 to 4;

Ar is an aromatic diradical, a heteroaromatic diradical bonded linearly or substantially linearly to adjoining diradicals, or a single bond;

V is a diradical having the structure

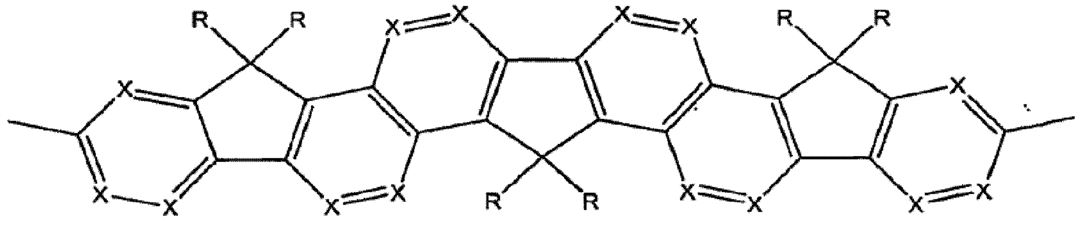

wherein

X is independently selected from N, CH, or $CR_1$ where $R_1$ is independently selected from hydrocarbyl groups, $C_jH_{2j+1}$, branched hydrocarbyl groups, or hydrocarbyl groups with one or more heteroatoms of S, N, O, P, or Si with j = 1 to 6; and,

R is independently selected from hydrocarbyl groups, $C_mH_{2m+1}$, branched hydrocarbyl groups, or hydrocarbyl groups with one or more heteroatoms of S, N, O, P, or Si with m = 1 to 15, and

the Ar and V diradicals are independently selected in each of the n subunits of the chromophore.

For the fourth through the thirteenth materials and the fourteenth through the twenty-third organic semiconductor, charge transporting or light emitting polymers, the crosslinkable end group B may be 1,4-pentadien-3-yl. For the fourth through the thirteenth materials and the fourteenth through the twenty-third organic semiconductor, charge transporting or light emitting polymers, the crosslinkable end group B may be a methacrylate. For the fourth through the thirteenth materials and the fourteenth through the twenty-third organic semiconductor, charge transporting or light emitting polymers, the one or more metallic atoms may be chemically bonded into the aromatic molecular nucleus A. For the fourth through the thirteenth materials and the fourteenth through the twenty-third organic semiconductor, charge transporting or light emitting polymers, the polymerizable material or polymer may be used in an electronic or optical application that utilizes phosphorescence. For the fourteenth through the twenty-third organic semiconductor, charge transporting or light emitting polymers, the polymer formed from the polymerizable material may be used in an electronic or optical application that utilizes phosphorescence.

There are described herein twenty-fourth to thirty-third processes.

A twenty-fourth process for forming an organic semiconductor polymer, charge transporting polymer or light emitting polymer includes polymerizing polymerizable materials having the molecular structure B-S-A-S-B, wherein

B is a crosslinkable end group;
S is a flexible spacer; and
A is a substantially aromatic molecular nucleus having the structure

$$-(Ar-D)_n-Ar-$$

wherein

n = 1 to 6;

Ar is an aromatic diradical, a heteroaromatic diradical bonded linearly or substantially linearly to adjoining diradicals, or a single bond;

D is a diradical having the structure:

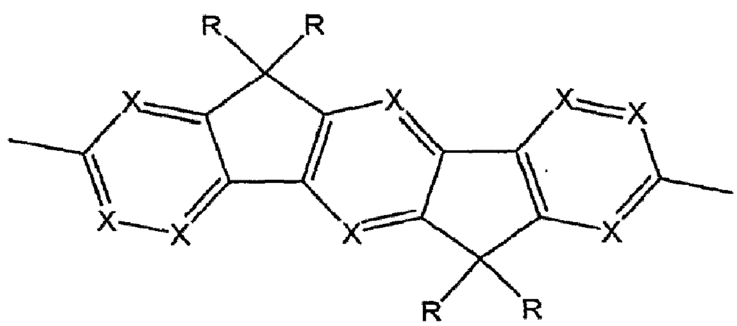

wherein

X is independently selected from N, CH, or $CR_1$ where $R_1$ is independently selected from hydrocarbyl groups, $C_jH_{2j+1}$, branched hydrocarbyl groups, or hydrocarbyl groups with one or more heteroatoms of S, N, O, P, or Si with j = 1 to 6; and,

R is independently selected from hydrocarbyl groups, $C_mH_{2m+1}$, branched hydrocarbyl groups, or hydrocarbyl groups with one or more heteroatoms of S, N, O, P, or Si, with m = 1 to 15, and

the Ar and D diradicals are independently selected in each of the n subunits of the chromophore.

A twenty-fifth process for forming a charge transporting polymer or light emitting polymer includes polymerizing polymerizable materials having the molecular structure B-S-A-S-B,
wherein

B is a crosslinkable end group;
S is a flexible spacer; and
A is substantially aromatic molecular nucleus having the structure $-(Ar-T)_n-Ar-$
wherein

n = 1 to 4;
Ar is an aromatic diradical, a heteroaromatic diradical bonded linearly or substantially linearly to adjoining diradicals, or a single bond;
T is a diradical having the structure

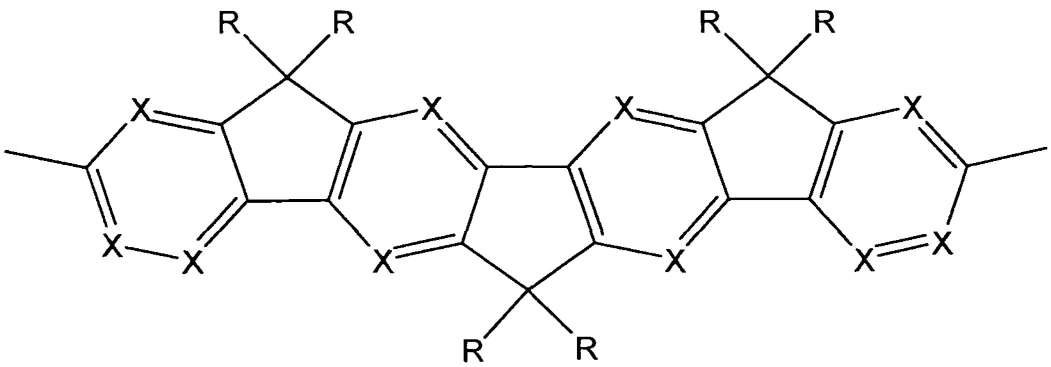

wherein

X is independently selected from N, CH, or $CR_1$ where $R_1$ is independently selected from hydrocarbyl groups, $C_jH_{2j+1}$, branched hydrocarbyl groups, or hydrocarbyl groups with one or more heteroatoms of S, N, O, P, or Si with j = 1 to 6; and,
R is independently selected from hydrocarbyl groups, $C_mH_{2m+1}$, branched hydrocarbyl groups, or hydrocarbyl groups with one or more heteroatoms of S, N, O, P, or Si with m = 1 to 15, and

the Ar and T diradicals are independently selected in each of the n subunits of the chromophore.

A twenty-sixth process for forming an organic semiconductor polymer, charge transporting polymer or light emitting polymer includes polymerizing polymerizable materials having the molecular structure B-S-A-S-B,
wherein

B is a crosslinkable end group;
S is a flexible spacer; and
A is a substantially aromatic molecular nucleus having the structure

$$-(Ar-Q)_n-Ar-$$

wherein

n = 1 to 4;

Ar is an aromatic diradical, a heteroaromatic diradical bonded linearly or substantially linearly to adjoining diradicals, or a single bond;

Q is a diradical having the structure

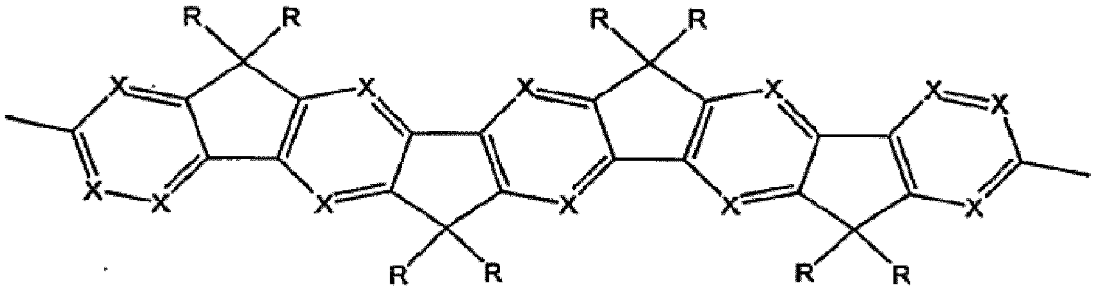

wherein

X is independently selected from N, CH, or $CR_1$ where $R_1$ is independently selected from hydrocarbyl groups, $C_jH_{2j+1}$, branched hydrocarbyl groups, or hydrocarbyl groups with one or more heteroatoms of S, N, O, P, or Si with j = 1 to 6; and,

R is independently selected from hydrocarbyl groups, $C_mH_{2m+1}$, branched hydrocarbyl groups, or hydrocarbyl groups with one or more heteroatoms of S, N, O, P, or Si with m = 1 to 15, and

the Ar and Q diradicals are independently selected in each of the n subunits of the chromophore.

A twenty-seventh process for forming an organic semiconductor polymer, charge transporting polymer or light emitting polymer including polymerizing polymerizable materials having the molecular structure B-S-A-S-B, wherein

B is a crosslinkable end group;

S is a flexible spacer; and

A is a substantially aromatic molecular nucleus having the structure

$$-(Ar-N)_n-Ar-$$

wherein

n = 1 to 6;

Ar is an aromatic diradical, a heteroaromatic diradical bonded linearly or substantially linearly to adjoining diradicals, or a single bond;

N is a diradical having the structure

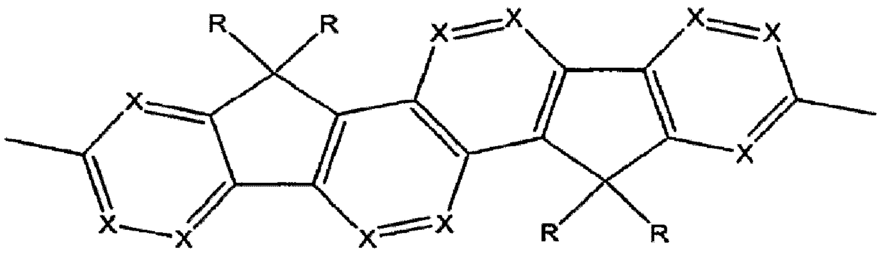

wherein

X is independently selected from N, CH, or $CR_1$ where $R_1$ is independently selected from hydrocarbyl

groups, $C_jH_{2j+1}$, branched hydrocarbyl groups, or hydrocarbyl groups with one or more heteroatoms of S, N, O, P, or Si with j = 1 to 6; and,
R is independently selected from hydrocarbyl groups, $C_mH_{2m+1}$, branched hydrocarbyl groups, or hydrocarbyl groups with one or more heteroatoms of S, N, O, P, or Si with m = 1 to 15, and

the Ar and N diradicals are independently selected in each of the n subunits of the chromophore.

A twenty-eighth process for forming an organic semiconductor polymer, charge transporting polymer or light emitting polymer includes polymerizing polymerizable materials having the molecular structure B-S-A-S-B, wherein

B is a crosslinkable end group;

S is a flexible spacer; and

A is a substantially aromatic molecular nucleus having the structure

$$-(Ar-L)_n-Ar-$$

wherein

n = 1 to 4;
Ar is an aromatic diradical, a heteroaromatic diradical bonded linearly or substantially linearly to adjoining diradicals, or a single bond;
L is a diradical having the structure

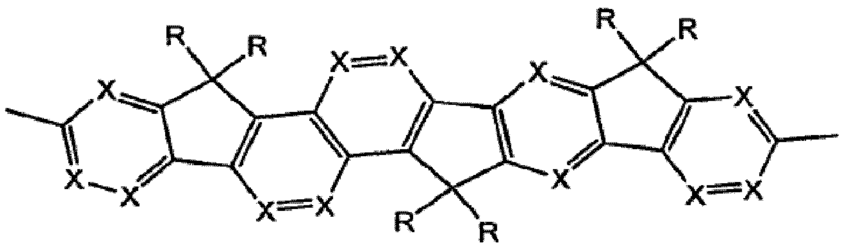

wherein

X is independently selected from N, CH, or $CR_1$ where $R_1$ is independently selected from hydrocarbyl groups, $C_jH_{2j+1}$, branched hydrocarbyl groups, or hydrocarbyl groups with one or more heteroatoms of S, N, O, P, or Si with j = 1 to 6; and,

R is independently selected from hydrocarbyl groups, $C_mH_{2m+1}$, branched hydrocarbyl groups, or hydrocarbyl groups with one or more heteroatoms of S, N, O, P, or Si with m = 1 to 15, and

the Ar and L diradicals are independently selected in each of the n subunits of the chromophore.

A twenty-ninth process for forming an organic semiconductor polymer, charge transporting polymer or light emitting polymer includes polymerizing polymerizable materials having the molecular structure B-S-A-S-B, wherein

B is a crosslinkable end group;

S is a flexible spacer; and

A is a substantially aromatic molecular nucleus having the structure

$$-(Ar-M)_n-Ar-$$

wherein

n = 1 to 4;

Ar is an aromatic diradical, a heteroaromatic diradical bonded linearly or substantially linearly to adjoining diradicals, or a single bond;

M is a diradical having the structure

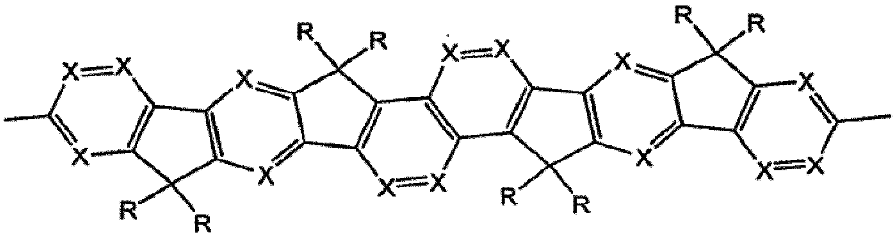

wherein

X is independently selected from N, CH, or $CR_1$ where $R_1$ is independently selected from hydrocarbyl groups, $C_jH_{2j+1}$, branched hydrocarbyl groups, or hydrocarbyl groups with one or more heteroatoms of S, N, O, P, or Si with j = 1 to 6; and,

R is independently selected from hydrocarbyl groups, $C_mH_{2m+1}$, branched hydrocarbyl groups, or hydrocarbyl groups with one or more heteroatoms of S, N, O, P, or Si with m = 1 to 15, and

the Ar and M diradicals are independently selected in each of the n subunits of the chromophore.

A thirtieth process for forming an organic semiconductor polymer, charge transporting polymer or light emitting polymer includes polymerizing polymerizable materials having the molecular structure B-S-A-S-B, wherein

B is a crosslinkable end group;

S is a flexible spacer; and

A is a substantially aromatic molecular nucleus having the structure

$$-(Ar-G)_n-Ar-$$

wherein

n = 1 to 6;

Ar is an aromatic diradical, a heteroaromatic diradical bonded linearly or substantially linearly to adjoining diradicals, or a single bond;

G is a diradical having the structure

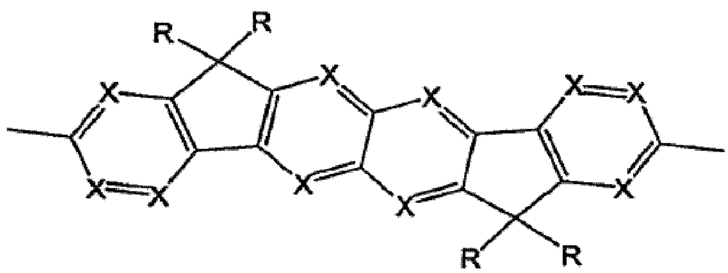

wherein

X is independently selected from N, CH, or $CR_1$ where $R_1$ is independently selected from hydrocarbyl groups, $C_jH_{2j+1}$, branched hydrocarbyl groups, or hydrocarbyl groups with one or more heteroatoms of S, N, O, P, or Si with j = 1 to 6; and,

R is independently selected from hydrocarbyl groups, $C_mH_{2m+1}$, branched hydrocarbyl groups, or hydrocarbyl groups with one or more heteroatoms of S, N, O, P, or Si with m = 1 to 15, and

the Ar and G diradicals are independently selected in each of the n subunits of the chromophore.

A thirty-first process for forming an organic semiconductor polymer, charge transporting polymer or light emitting polymer includes polymerizing polymerizable materials having the molecular structure B-S-A-S-B, wherein

B is a crosslinkable end group;

S is a flexible spacer; and

A is a substantially aromatic molecular nucleus having the structure

$$-(Ar\text{-}S')_n\text{-}Ar-$$

wherein

n = 1 to 4;

Ar is an aromatic diradical, a heteroaromatic diradical bonded linearly or substantially linearly to adjoining diradicals, or a single bond;

S' is a diradical having the structure

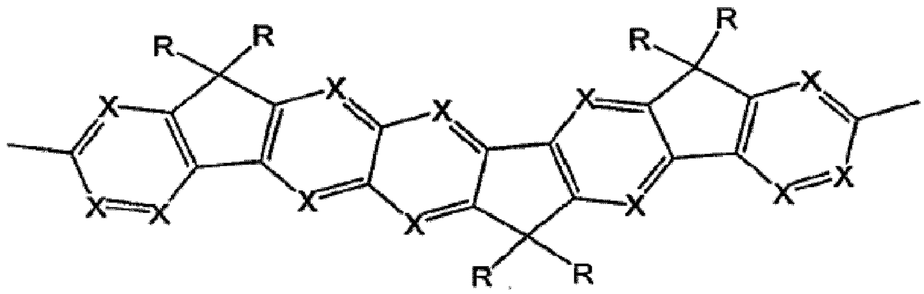

wherein

X is independently selected from N, CH, or $CR_1$ where $R_1$ is independently selected from hydrocarbyl groups, $C_jH_{2j+1}$, branched hydrocarbyl groups, or hydrocarbyl groups with one or more heteroatoms of S, N, O, P, or Si with j = 1 to 6; and,

R is independently selected from hydrocarbyl groups, $C_mH_{2m+1}$, branched hydrocarbyl groups, or hydrocarbyl groups with one or more heteroatoms of S, N, O, P, or Si with m = 1 to 15, and

the Ar and S' diradicals are independently selected in each of the n subunits of the chromophore.

A thirty-second process for forming an organic semiconductor polymer, charge transporting polymer or light emitting polymer includes polymerizing polymerizable materials having the molecular structure B-S-A-S-B, wherein

B is a crosslinkable end group;

S is a flexible spacer; and

A is a substantially aromatic molecular nucleus having the structure

$$-(Ar-U)_n-Ar-$$

wherein

n = 1 to 4;

Ar is an aromatic diradical, a heteroaromatic diradical bonded linearly or substantially linearly to adjoining diradicals, or a single bond;

U is a diradical having the structure

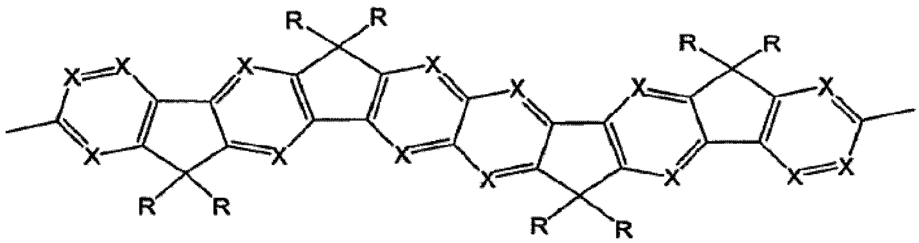

wherein

X is independently selected from N, CH, or $CR_1$ where $R_1$ is independently selected from hydrocarbyl groups, $C_jH_{2j+1}$, branched hydrocarbyl groups, or hydrocarbyl groups with one or more heteroatoms of S, N, O, P, or Si with j = 1 to 6; and,

R is independently selected from hydrocarbyl groups, $C_mH_{2m+1}$, branched hydrocarbyl groups, or hydrocarbyl groups with one or more heteroatoms of S, N, O, P, or Si with m = 1 to 15, and

the Ar and U diradicals are independently selected in each of the n subunits of the chromophore.

A thirty-third process for forming an organic semiconductor polymer, charge transporting polymer or light emitting polymer includes polymerizing polymerizable materials having the molecular structure B-S-A-S-B, wherein

B is a crosslinkable end group;
S is a flexible spacer; and
A is substantially aromatic molecular nucleus having the structure $-(Ar-V)_n-Ar-$
wherein

n = 1 to 4;
Ar is an aromatic diradical, a heteroaromatic diradical bonded linearly or substantially linearly to adjoining diradicals, or a single bond;
V is a diradical having the structure

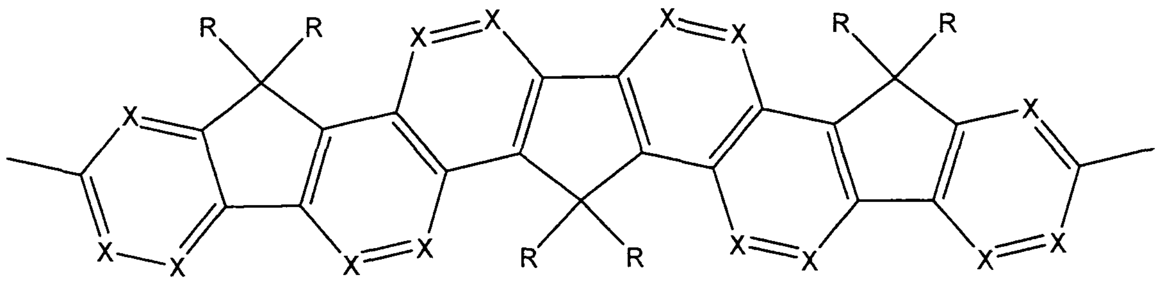

wherein

X is independently selected from N, CH, or $CR_1$ where $R_1$ is independently selected from hydrocarbyl groups, $C_jH_{2j+1}$, branched hydrocarbyl groups, or hydrocarbyl groups with one or more heteroatoms of S, N, O, P, or Si with j = 1 to 6; and,
R is independently selected from hydrocarbyl groups, $C_mH_{2m+1}$, branched hydrocarbyl groups, or hydrocarbyl groups with one or more heteroatoms of S, N, O, P, or Si with m = 1 to 15, and

the Ar and V diradicals are independently selected in each of the n subunits of the chromophore.

For the twenty-fourth through the thirty-third processes, the crosslinkable end group B may be 1,4-pentadien-3-yl. For the twenty-fourth through the thirty-third processes, the crosslinkable end group B may be a methacrylate.
There is described herein a thirty-fourth material (not forming part of the invention) for use in forming organic semiconductor polymer, charge transporting or light emitting polymers including a polymerizable material having the molecular structure B-S-A-S-B,
wherein

B is a crosslinkable end group;
S is a flexible spacer; and
A is a substantially aromatic molecular nucleus having the structure

$$-(Ar-F^1)_n-Ar-$$

wherein

n = 1 to 8;
Ar is an aromatic diradical, a heteroaromatic diradical bonded linearly or substantially linearly to adjoining diradicals, or a single bond;
$F^1$ is a diradical having a structure selected from the group consisting of:

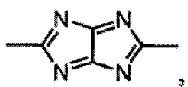, 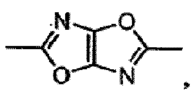, 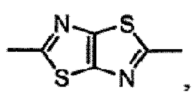,

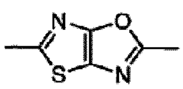, 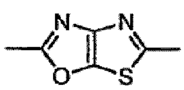, 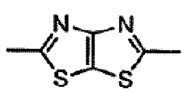 and, 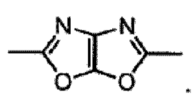.

The Ar diradicals are independently selected in each of the n subunits of the chromophore.
There is described herein a thirty-fifth polymeric organic semiconductor, charge transporting or light emitting material (not forming part of the invention) including a polymer formed from a polymerizable material having the molecular structure B-S-A-S-B
wherein

B is a crosslinkable end group;
S is a flexible spacer; and
A is a substantially aromatic molecular nucleus having the structure

-(Ar-$F^1$)$_n$-Ar-

wherein

n = 1 to 8;
Ar is an aromatic diradical, a heteroaromatic diradical bonded linearly or substantially linearly to adjoining diradicals, or a single bond;
$F^1$ is a diradical having a structure selected from the group consisting of:

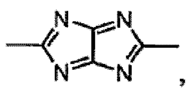, 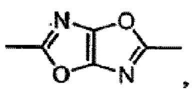, 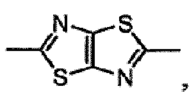,

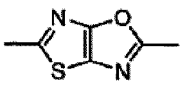, 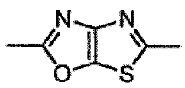, 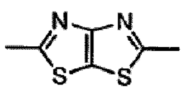 and, 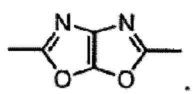.

The Ar diradicals are independently selected in each of the n subunits of the chromophore.

There is described herein a thirty-sixth process (not forming part of the invention) for forming an organic semiconductor polymer, charge transporting polymer or light emitting polymer including polymerizing polymerizable materials having the molecular structure B-S-A-S-B,
wherein

B is a crosslinkable end group;
S is a flexible spacer; and
A is a substantially aromatic molecular nucleus having the structure -(Ar-$F^1$)$_n$-Ar-
wherein
n = 1 to 8;Ar is an aromatic diradical, a heteroaromatic diradical bonded linearly or substantially linearly to adjoining diradicals, or a single bond;$F^1$ is a diradical having a structure selected from the group consisting of:

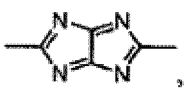, 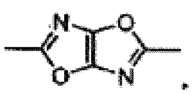, 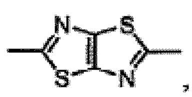,

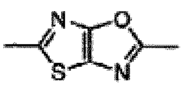, 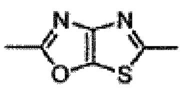, 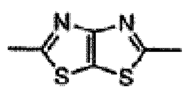 and, 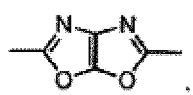.

The Ar diradicals are independently selected in each of the n subunits of the chromophore.

There is described herein a thirty-seventh organic semiconductor, charge transporting or light emitting polymer including a polymer formed by polymerization of mixture of one of more components (not forming part of the invention), at least one of the one of more components having molecules of formula A-(S-B)$_n$
wherein n is from 1 to 20;A is a substantially aromatic molecular nucleus;S is a flexible spacer; and B is an independently selected crosslinking group chosen from the group consisting of:

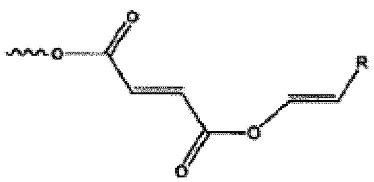 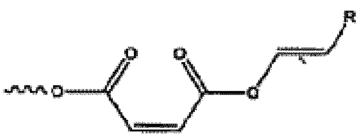 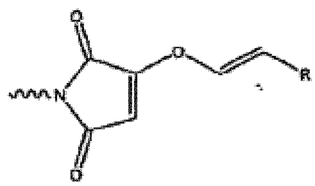

wherein R = H or alkyl.

For the thirty-seventh organic semiconductor, charge transporting or light emitting polymer, the polymerization may be photopolymerization. For the thirty-seventh organic semiconductor, charge transporting or light emitting polymer, the polymer may be an electroluminescent material. For the thirty-seventh organic semiconductor, charge transporting

or light emitting polymer, the polymer may be included in a field effect transistor or a photovoltaic device. For the thirty-seventh organic semiconductor, charge transporting or light emitting polymer, the polymer may be used in a luminescent application. For the thirty-seventh organic semiconductor, charge transporting or light emitting polymer, the polymer may exhibit a liquid crystalline structure such as a smectic structure, a nematic structure, or a discotic structure. For the thirty-seventh organic semiconductor, charge transporting or light emitting polymer, the at least one of the substantially aromatic molecular nuclei, A, may be organometallic in nature.

There is described herein a thirty-eighth material for use in forming organic semiconductor, charge transporting or light emitting polymers including a mixture including one of more components (not forming part of the invention), at least one of the one of more components having molecules of formula A-(S-B)$_n$
wherein

n is from 1 to 20;
A is a substantially aromatic molecular nucleus;
S is a flexible spacer; and
B is an independently selected crosslinking group chosen from

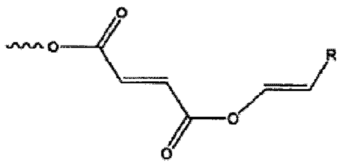 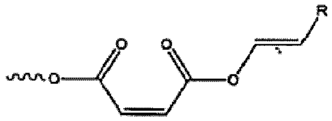 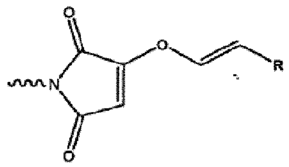

wherein R = H or alkyl.

For the thirty-eighth material, the mixture may exhibit a liquid crystalline structure upon polymerization such as a smectic structure, a nematic structure, or a discotic structure. For the thirty-eighth material, the at least one of the substantially aromatic molecular nuclei, A, may be organometallic in nature.

There is described herein a thirty-ninth process (not forming part of the invention) for forming organic semiconductor, charge transporting or light emitting polymers including polymerizing polymerizable materials having the formula A-(-S-B)$_n$
wherein

n is from 1 to 20;
A is a substantially aromatic molecular nucleus;
S is a flexible spacer; and
B is an independently selected crosslinking group chosen from the group consisting of:

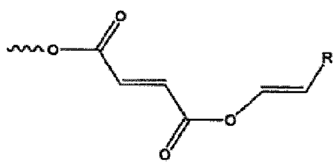 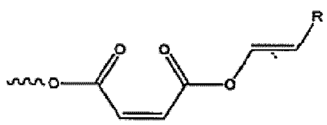 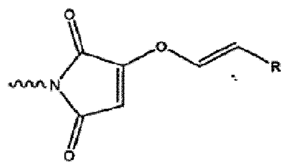

wherein R = H or alkyl.

For the thirty-ninth process, the polymerizing may be photopolymerizing. For the thirty-ninth process, the polymerizable materials formed may be an electroluminescent material after polymerization. For the thirty-ninth process, the process may further comprise depositing the polymerizable materials in a field effect transistor or a photovoltaic device.

For the thirty-ninth process, the polymerizable materials may be used in a luminescent application. For the thirty-ninth process, the polymerizable materials may exhibit a liquid crystalline structure after polymerization such as a smectic structure, a nematic structure, or a discotic structure. For the thirty-ninth process, the at least one of the substantially aromatic molecular nuclei, A, may be organometallic in nature.

There is described herein a fortieth organic semiconductor, charge transporting or light emitting polymer including a polymer with calamitic liquid crystalline structure formed by polymerization of mixture of one of more components (not forming part of the invention), at least one of the one of more components has molecules of formula B-S-A-S-B
wherein

A is a substantially aromatic molecular nucleus;
S is a flexible spacer; and
B is an independently selected crosslinking group chosen from the group consisting of

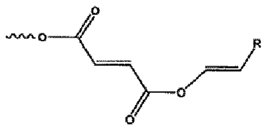 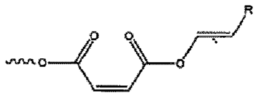 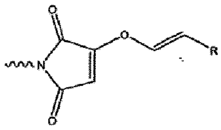

wherein R = H or alkyl.

For the fortieth organic semiconductor, charge transporting or light emitting polymer, the polymerization may be photopolymerization. For the fortieth organic semiconductor, charge transporting or light emitting polymer, the polymer may be an electroluminescent material. For the fortieth organic semiconductor, charge transporting or light emitting polymer, the polymer may be included in a field effect transistor or a photovoltaic device. For the fortieth organic semiconductor, charge transporting or light emitting polymer, the polymer may be used in a luminescent application. For the fortieth organic semiconductor, charge transporting or light emitting polymer, the at least one of the substantially aromatic molecular nuclei, A, may be organometallic in nature.

There is described herein a forty-first material for use in forming organic semiconductor, charge transporting or light emitting polymers including a mixture of one of more components (not forming part of the invention), at least one of the one of more components has molecules of formula B-S-A-S-B
wherein

A is a substantially aromatic molecular nucleus;
S is a flexible spacer; and
B is an independently selected crosslinking group chosen from the group consisting of:

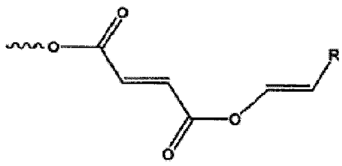 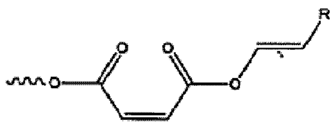 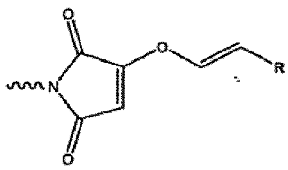

wherein R = H or alkyl.

For the forty-first material, the mixture formed may exhibit a liquid crystalline structure after polymerization. For the forty-first material, the at least one of the one of more components may have a monotropic or thermotropic calamitic liquid crystalline phase. For the forty-first material, the at least one of the substantially aromatic molecular nuclei, A, may be organometallic in nature. For the forty-first material, the mixture may be photopolymerizable. For the forty-first material, the mixture may form an electroluminescent material upon polymerization. For the forty-first material, the mixture may be included in a field effect transistor or a photovoltaic device. For the forty-first material, the mixture may be used in a luminescent application.

There is described herein a forty-second process (not forming part of the invention) for in forming organic semiconductor, charge transporting or light emitting polymers including polymerizing of a mixture of one of more components, at least one of the one of more components has molecules of formula B-S-A-S-B
wherein

A is a substantially aromatic molecular nucleus;
S is a flexible spacer; and
B is an independently selected crosslinking group chosen from

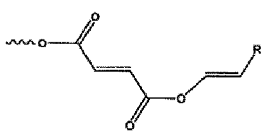 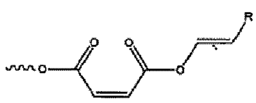 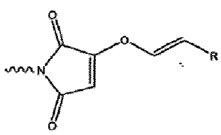

wherein R = H or alkyl.

For the forty-second process, the mixture of one of more components may exhibit a liquid crystalline structure after polymerization. For the forty-second process, the at least one of the one of more components may have a monotropic or thermotropic calamitic liquid crystalline phase. For the forty-second process, the at least one of the substantially aromatic molecular nuclei, A, may be organometallic in nature. For the forty-second process, the polymerizing may be photopolymerizing. For the forty-second process, the mixture of one of more components may be an electroluminescent material after polymerization. For the forty- second process, the process may further comprise forming a field effect transistor or a photovoltaic device. For the forty-second process, the mixture of one of more components after polymerization may be used in a luminescent application.

There is described herein a material (not forming part of the invention) for use in forming organic semiconductor, charge transporting or light emitting polymers comprising:
a polymer formed from a mixture of at least two polymerizable components, wherein
at least one of the at least two components comprises molecules of the general formula:

$$A_e\{S\text{-}Be)_n,$$

and at least another one of the at least two components comprises molecules of the general formula:

$$A_d\{S\text{-}B_d)_m$$

wherein

$A_e$ is a substantially aromatic molecular nucleus;
$B_e$ is an independently selected crosslinking group;
$A_d$ is a substantially aromatic molecular nucleus;
$B_d$ is an independently selected crosslinking group;
S is independently selected flexible spacer;
n is from 1 to 20;
m is from 1 to 20, and
wherein polymerization of the mixture is initiated by electron transfer from $B_e$ groups to $B_d$ groups.

Preferably, the polymerization is photopolymerization. Preferably, the polymer is an electroluminescent material. Preferably, the polymer is included in a field effect transistor or a photovoltaic device. Preferably, the polymer is used in a luminescent application. Preferably, the polymer exhibits a thermotropic or monotropic liquid crystalline structure. Preferably, the thermotropic or monotropic liquid crystalline structure is a calamitic structure, a nematic structure, or a discotic structure. Preferably, the crosslinking group $B_e$ is a vinyl ether group. Preferably, the crosslinking group $B_d$ is a maleimide group, a maleate group, or a fumarate group. Preferably, at least one of the substantially aromatic molecular nuclei, $A_e$ or $A_d$, is organometallic in nature. Preferably, at least one of the substantially aromatic molecular nuclei, $A_e$ or $A_d$, has the structure:

$$-(Ar\text{-}F)_n\text{-}Ar\text{-}$$

wherein

Ar is independently selected from an aromatic diradical, a heteroaromatic diradical bonded linearly or substantially linearly to adjoining diradicals, or a single bond;
F is an independently selected diradical having the structure:

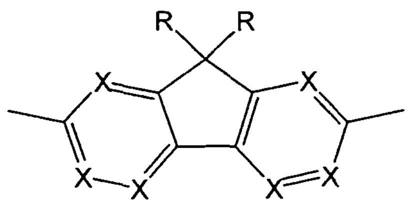

wherein X is independently selected from N, CH, or $CR_1$ where $R_1$ is independently selected from hydrocarbyl

groups, $C_jH_{2j+1}$, branched hydrocarbyl groups, or hydrocarbyl groups with one or more heteroatoms of S, N, O, P, or Si with j = 1 to 6; and
R is independently selected from hydrocarbyl groups, $C_mH_{2m+1}$, branched hydrocarbyl groups, or hydrocarbyl groups with one or more heteroatoms of S, N, O, P, or Si, with m = 1 to 15, and

the Ar and F diradicals are independently selected in each of the n subunits of the chromophore; and

$$1 \leq n \leq 10.$$

Preferably, at least one of the substantially aromatic molecular nuclei, $A_e$ or $A_d$, has the structure

$-(Ar-D)_n-Ar-$

wherein

Ar is independently selected from an aromatic diradical, a heteroaromatic diradical bonded linearly or substantially linearly to adjoining diradicals, or a single bond;
D is a diradical having the structure:

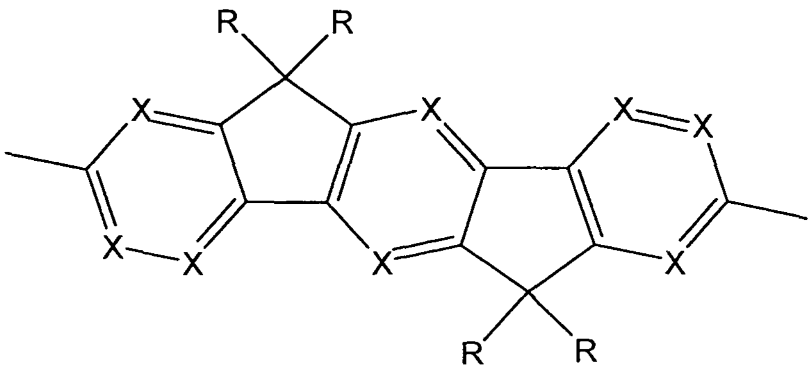

wherein

X is independently selected from N, CH, or $CR_1$ where $R_1$ is independently selected from hydrocarbyl groups, $C_jH_{2j+1}$, branched hydrocarbyl groups, or hydrocarbyl groups with one or more heteroatoms of S, N, O, P, or Si with j = 1 to 6; and
R is independently selected from hydrocarbyl groups, $C_mH_{2m+1}$, branched hydrocarbyl groups, or hydrocarbyl groups with one or more heteroatoms of S, N, O, P, or Si, with m = 1 to 15, and

the Ar and D diradicals are independently selected in each of the n subunits of the chromophore; and
n = 1 to 6.

Preferably, at least one of the substantially aromatic molecular nuclei, $A_e$ or $A_d$, has the structure:

$-(Ar-T)_n-Ar-$

wherein

Ar is independently selected from an aromatic diradical, a heteroaromatic diradical bonded linearly or substantially linearly to adjoining diradicals, or a single bond;
T is a diradical having the structure:

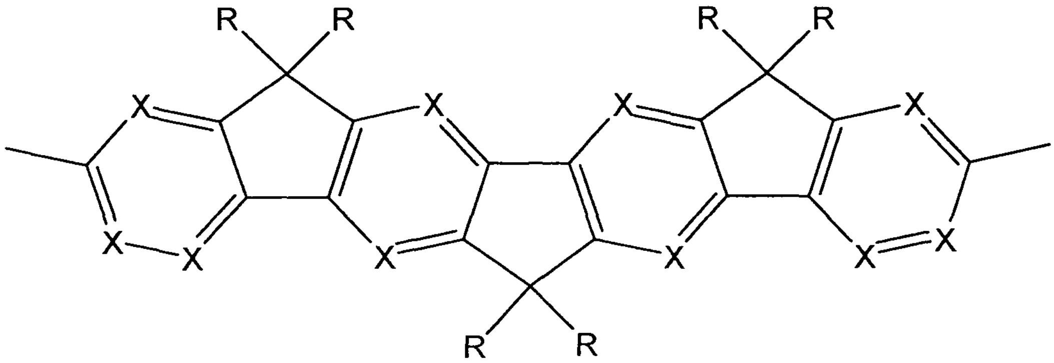

wherein

X is independently selected from N, CH, or $CR_1$ where $R_1$ is independently selected from hydrocarbyl groups, $C_jH_{2j+1}$, branched hydrocarbyl groups, or hydrocarbyl groups with one or more heteroatoms of S, N, O, P, or Si with j = 1 to 6;
R is independently selected from hydrocarbyl groups, $C_mH_{2m+1}$, branched hydrocarbyl groups, or hydrocarbyl groups with one or more heteroatoms of S, N, O, P, or Si with m = 1 to 15, and

n = 1 to 4,
wherein the Ar and T diradicals are independently selected in each of the n subunits of the chromophore.

Preferably, at least one of the substantially aromatic molecular nuclei, $A_e$ or $A_d$, has the structure:

$-(Ar-Q)_n-Ar-$

wherein

Ar is independently selected from an aromatic diradical, a heteroaromatic diradical bonded linearly or substantially linearly to adjoining diradicals, or a single bond;
Q is a diradical having the structure:

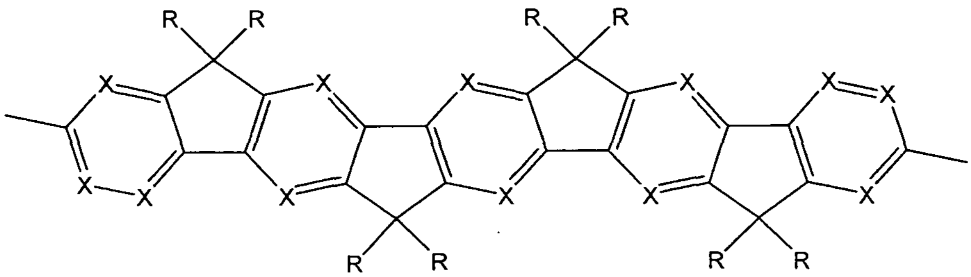

wherein

X is independently selected from N, CH, or $CR_1$ where $R_1$ is independently selected from hydrocarbyl groups, $C_jH_{2j+1}$, branched hydrocarbyl groups, or hydrocarbyl groups with one or more heteroatoms of S, N, O, P, or Si with j = 1 to 6; and
R is independently selected from hydrocarbyl groups, $C_mH_{2m+1}$, branched hydrocarbyl groups, or hydrocarbyl groups with one or more heteroatoms of S, N, O, P, or Si with m = 1 to 15, and

n = 1 to 4,
wherein the Ar and Q diradicals are independently selected in each of the n subunits of the chromophore.

Preferably, at least one of the substantially aromatic molecular nuclei, $A_e$ or $A_d$, has the structure:

$-(Ar-N)_n-Ar-$

wherein

Ar is independently selected form an aromatic diradical, a heteroaromatic diradical bonded linearly or substantially linearly to adjoining diradicals, or a single bond;
N is a diradical having the structure:

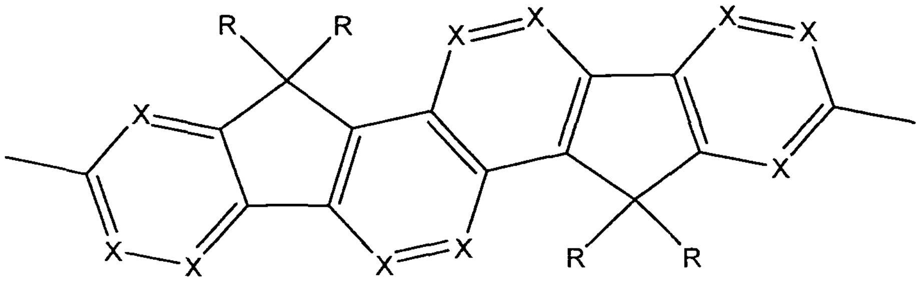

wherein

X is independently selected from N, CH, or $CR_1$ where $R_1$ is independently selected from hydrocarbyl groups, $C_jH_{2j+1}$, branched hydrocarbyl groups, or hydrocarbyl groups with one or more heteroatoms of S, N, O, P, or Si with j = 1 to 6; and
R is independently selected from hydrocarbyl groups, $C_mH_{2m+1}$, branched hydrocarbyl groups, or hydrocarbyl groups with one or more heteroatoms of S, N, O, P, or Si with m = 1 to 15, and

n = 1 to 6,
wherein the Ar and N diradicals are independently selected in each of the n subunits of the chromophore.

Preferably, at least one of the substantially aromatic molecular nuclei, $A_e$ or $A_d$, has the structure:

$$-(Ar-L)_n-Ar-$$

wherein

Ar is independently selected from an aromatic diradical, a heteroaromatic diradical bonded linearly or substantially linearly to adjoining diradicals, or a single bond;
L is a diradical having the structure:

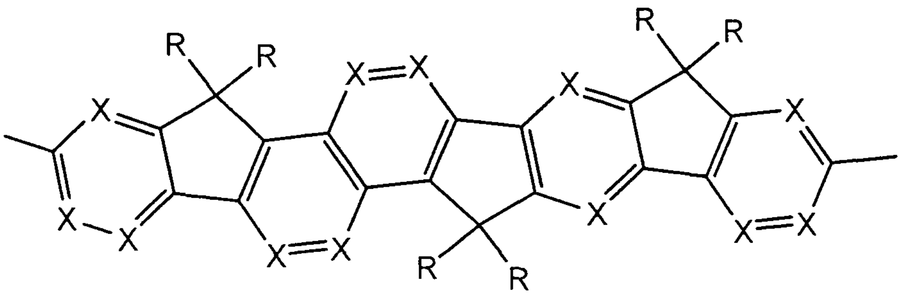

wherein

X is independently selected from N, CH, or $CR_1$ where $R_1$ is independently selected from hydrocarbyl groups, $C_jH_{2j+1}$, branched hydrocarbyl groups, or hydrocarbyl groups with one or more heteroatoms of S, N, O, P, or Si with j = 1 to 6; and
R is independently selected from hydrocarbyl groups, $C_mH_{2m+1}$, branched hydrocarbyl groups, or hydrocarbyl groups with one or more heteroatoms of S, N, O, P, or Si with m = 1 to 15, and

n = 1 to 4,

wherein the Ar and L diradicals are independently selected in each of the n subunits of the chromophore.

Preferably, at least one of the substantially aromatic molecular nuclei, $A_e$ or $A_d$, has the structure:

$-(Ar-M)_n-Ar-$

wherein

Ar is independently selected form an aromatic diradical, a heteroaromatic diradical bonded linearly or substantially linearly to adjoining diradicals, or a single bond;
M is a diradical having the structure:

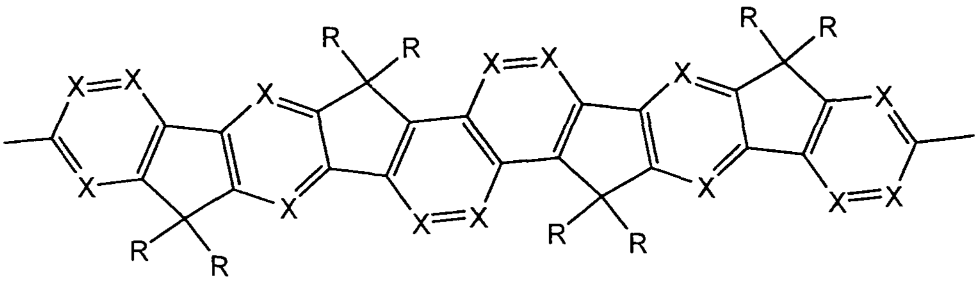

wherein

X is independently selected from N, CH, or $CR_1$ where $R_1$ is independently selected from hydrocarbyl groups, $C_jH_{2j+1}$, branched hydrocarbyl groups, or hydrocarbyl groups with one or more heteroatoms of S, N, O, P, or Si with j = 1 to 6; and
R is independently selected from hydrocarbyl groups, $C_mH_{2m+1}$, branched hydrocarbyl groups, or hydrocarbyl groups with one or more heteroatoms of S, N, O, P, or Si with m = 1 to 15, and

n = 1 to 4,
wherein the Ar and M diradicals are independently selected in each of the n subunits of the chromophore.

Preferably, at least one of the substantially aromatic molecular nuclei, $A_e$ or $A_d$, has the structure:

$-(Ar-G)_n-Ar-$

wherein

Ar is independently selected from an aromatic diradical, a heteroaromatic diradical bonded linearly or substantially linearly to adjoining diradicals, or a single bond;
G is a diradical having the structure:

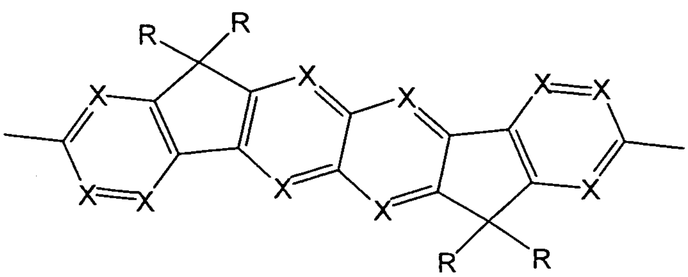

wherein

X is independently selected from N, CH, or $CR_1$ where $R_1$ is independently selected from hydrocarbyl groups, $C_jH_{2j+1}$, branched hydrocarbyl groups, or hydrocarbyl groups with one or more heteroatoms of S, N, O, P, or Si with j = 1 to 6; and

R is independently selected from hydrocarbyl groups, $C_mH_{2m+1}$, branched hydrocarbyl groups, or hydrocarbyl groups with one or more heteroatoms of S, N, O, P, or Si with m = 1 to 15, and

n = 1 to 6,
wherein the Ar and G diradicals are independently selected in each of the n subunits of the chromophore.

Preferably, at least one of the substantially aromatic molecular nuclei, $A_e$ or $A_d$, has the structure:

$$-(Ar-S')_n-Ar-$$

wherein

Ar is independently selected from an aromatic diradical, a heteroaromatic diradical bonded linearly or substantially linearly to adjoining diradicals, or a single bond;
S' is a diradical having the structure:

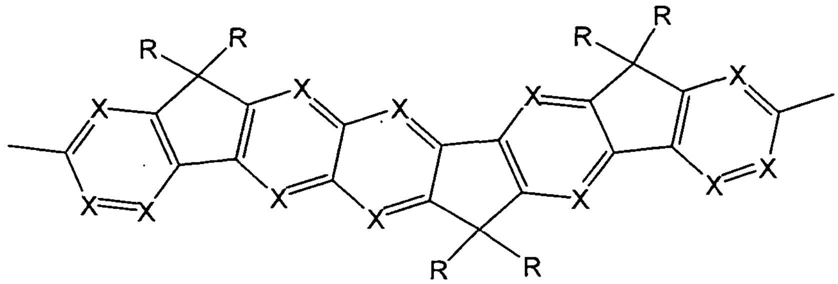

wherein

X is independently selected from N, CH, or $CR_1$ where $R_1$ is independently selected from hydrocarbyl groups, $C_jH_{2j+1}$, branched hydrocarbyl groups, or hydrocarbyl groups with one or more heteroatoms of S, N, O, P, or Si with j = 1 to 6; and
R is independently selected from hydrocarbyl groups, $C_mH_{2m+1}$, branched hydrocarbyl groups, or hydrocarbyl groups with one or more heteroatoms of S, N, O, P, or Si with m = 1 to 15, and

n = 1 to 4,
wherein the Ar and S' diradicals are independently selected in each of the n subunits of the chromophore.

Preferably, at least one of the substantially aromatic molecular nuclei, $A_e$ or $A_d$, has the structure:

$$-(Ar-U)_n-Ar-$$

wherein

Ar is independently selected from an aromatic diradical, a heteroaromatic diradical bonded linearly or substantially linearly to adjoining diradicals, or a single bond;
U is a diradical having the structure:

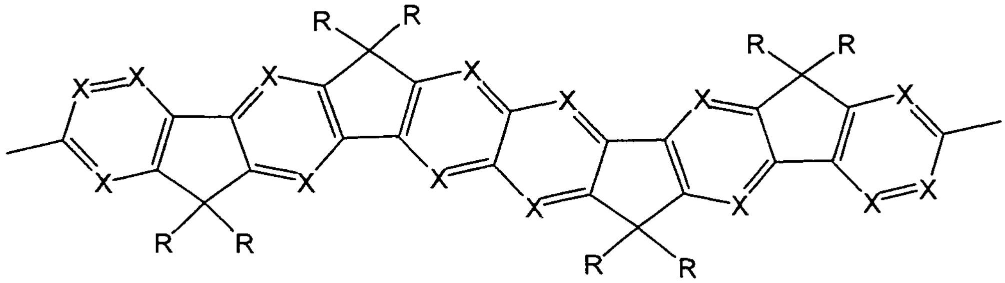

wherein

X is independently selected from N, CH, or $CR_1$ where $R_1$ is independently selected from hydrocarbyl groups, $C_jH_{2j+1}$, branched hydrocarbyl groups, or hydrocarbyl groups with one or more heteroatoms of S, N, O, P, or Si with j = 1 to 6; and
R is independently selected from hydrocarbyl groups, $C_mH_{2m+1}$, branched hydrocarbyl groups, or hydrocarbyl groups with one or more heteroatoms of S, N, O, P, or Si with m = 1 to 15, and

n = 1 to 4,
wherein the Ar and U diradicals are independently selected in each of the n subunits of the chromophore.

Preferably, at least one of the substantially aromatic molecular nuclei, $A_e$ or $A_d$, has the structure:

$$-(Ar-V)_n-Ar-$$

wherein

Ar is independently selected from an aromatic diradical, a heteroaromatic diradical bonded linearly or substantially linearly to adjoining diradicals, or a single bond;
V is a diradical having the structure:

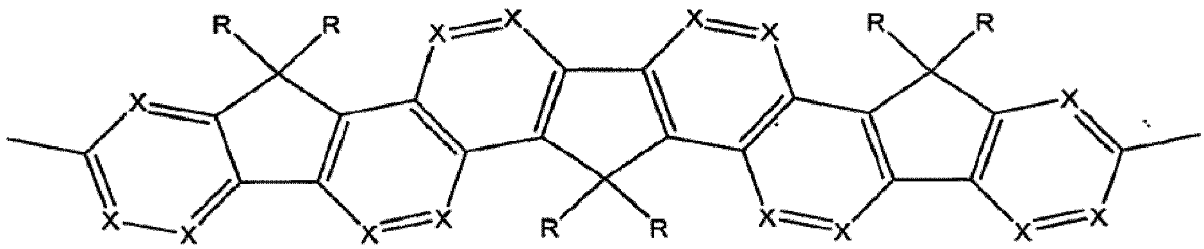

wherein

X is independently selected from N, CH, or $CR_1$ where $R_1$ is independently selected from hydrocarbyl groups, $C_jH_{2j+1}$, branched hydrocarbyl groups, or hydrocarbyl groups with one or more heteroatoms of S, N, O, P, or Si with j = 1 to 6; and
R is independently selected from hydrocarbyl groups, $C_mH_{2m+1}$, branched hydrocarbyl groups, or hydrocarbyl groups with one or more heteroatoms of S, N, O, P, or Si with m = 1 to 15, and

n = 1 to 4,
wherein the Ar and V diradicals are independently selected in each of the n subunits of the chromophore.

There is described herein a mixture of materials for use in forming organic semiconductor, charge transporting or light emitting polymers comprising:

a mixture of at least two polymerizable components,
wherein
at least one of the at least two components comprises molecules of the general formula (not forming part of the invention):

$$A_e\text{-}(\text{-}S\text{-}B_e)_n,$$

and
at least another one of the at least two components comprises molecules of the general formula:

$$A_d(S\text{-}B_d)_m$$

wherein

$A_e$ is a substantially aromatic molecular nucleus;
$B_e$ is an independently selected crosslinking group;
$A_d$ is a substantially aromatic molecular nucleus;
$B_d$ is an independently selected crosslinking group;
S is independently selected flexible spacer;
n is from 1 to 20;
m is from 1 to 20, and

wherein the mixture is photopolymerizable by initiating electron transfer from $B_e$ groups to $B_d$ groups.

Preferably 23 the mixture is photopolymerizable. Preferably the mixture forms an electroluminescent material upon polymerization. Preferably the mixture is included in a field effect transistor or a photovoltaic device. Preferably the mixture is used in a luminescent application. Preferably the mixture exhibits a liquid crystalline phase. Preferably the liquid crystalline phase is a calamitic phase, a nematic phase, or a discotic phase. Preferably the crosslinking group $B_e$ is a vinyl ether group. Preferably the crosslinking group $B_d$ is a maleimide group, a maleate group, or a fumarate group. Preferably at least one of the substantially aromatic molecular nuclei, $A_e$ or $A_d$, is organometallic in nature. Preferably at least one of the substantially aromatic molecular nuclei, $A_e$ or $A_d$, has the structure:

$$-(Ar\text{-}F)_n\text{-}Ar-$$

wherein

Ar is independently selected from an aromatic diradical, a heteroaromatic diradical bonded linearly or substantially linearly to adjoining diradicals, or a single bond;
F is an independently selected diradical having the structure:

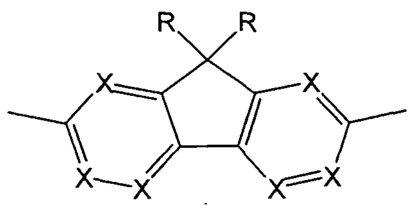

wherein X is independently selected from N, CH, or $CR_1$ where $R_1$ is independently selected from hydrocarbyl groups, $C_jH_{2j+1}$, branched hydrocarbyl groups, or hydrocarbyl groups with one or more heteroatoms of S, N, O, P, or Si with j = 1 to 6; and
R is independently selected from hydrocarbyl groups, $C_mH_{2m+1}$, branched hydrocarbyl groups, or hydrocarbyl groups with one or more heteroatoms of S, N, O, P, or Si, with m = 1 to 15, and

the Ar and F diradicals are independently selected in each of the n subunits of the chromophore; and
$1 \leq n \leq 10$.

Preferably at least one of the substantially aromatic molecular nuclei, $A_e$ or $A_d$, has the structure

$$-(Ar\text{-}D)_n\text{-}Ar-$$

wherein

Ar is independently selected from an aromatic diradical, a heteroaromatic diradical bonded linearly or substantially linearly to adjoining diradicals, or a single bond;
D is a diradical having the structure:

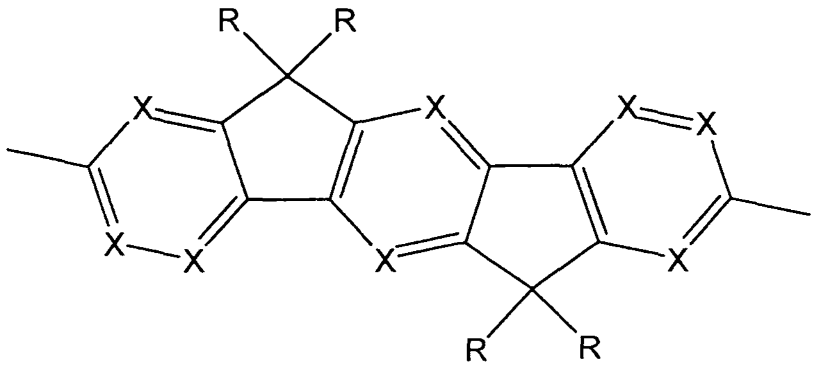

wherein

X is independently selected from N, CH, or $CR_1$ where $R_1$ is independently selected from hydrocarbyl groups, $C_jH_{2j+1}$, branched hydrocarbyl groups, or hydrocarbyl groups with one or more heteroatoms of S, N, O, P, or Si with j = 1 to 6, and
R is independently selected from hydrocarbyl groups, $C_mH_{2m+1}$, branched hydrocarbyl groups, or hydrocarbyl groups with one or more heteroatoms of S, N, O, P, or Si, with m = 1 to 15, and

the Ar and D diradicals are independently selected in each of the n subunits of the chromophore; and
n = 1 to 6.

Preferably at least one of the substantially aromatic molecular nuclei, $A_e$ or $A_d$, has the structure:

$$-(Ar-T)_n-Ar-$$

wherein

Ar is independently selected from an aromatic diradical, a heteroaromatic diradical bonded linearly or substantially linearly to adjoining diradicals, or a single bond;
T is a diradical having the structure:

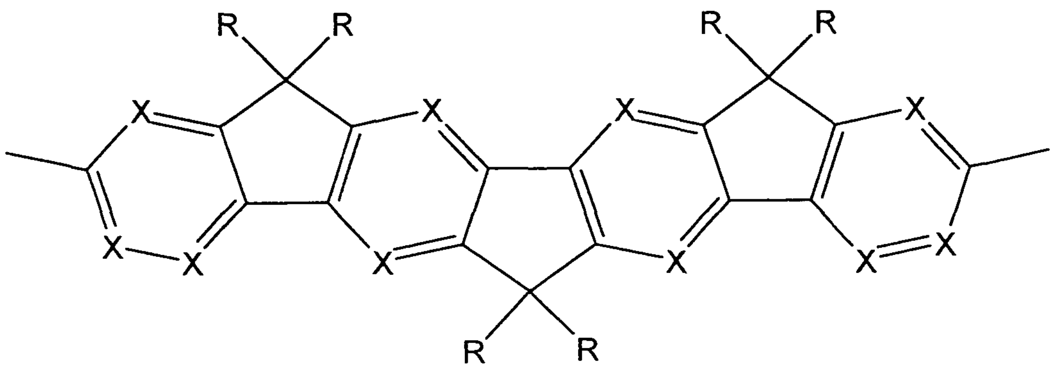

wherein

X is independently selected from N, CH, or $CR_1$ where $R_1$ is independently selected from hydrocarbyl groups, $C_jH_{2j+1}$, branched hydrocarbyl groups, or hydrocarbyl groups with one or more heteroatoms of S, N, O, P, or Si with j = 1 to 6;
R is independently selected from hydrocarbyl groups, $C_mH_{2m+1}$, branched hydrocarbyl groups, or hydrocarbyl groups with one or more heteroatoms of S, N, O, P, or Si with m = 1 to 15, and

n = 1 to 4,
wherein the Ar and T diradicals are independently selected in each of the n subunits of the chromophore.

Preferably at least one of the substantially aromatic molecular nuclei, $A_e$ or $A_d$, has the structure:

$$-(Ar-Q)_n-Ar-$$

wherein

Ar is independently selected from an aromatic diradical, a heteroaromatic diradical bonded linearly or substantially linearly to adjoining diradicals, or a single bond;
Q is a diradical having the structure:

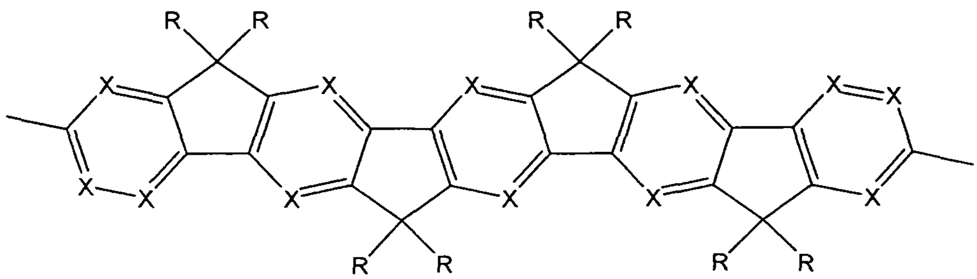

wherein

X is independently selected from N, CH, or $CR_1$ where $R_1$ is independently selected from hydrocarbyl groups, $C_jH_{2j+1}$, branched hydrocarbyl groups, or hydrocarbyl groups with one or more heteroatoms of S, N, O, P, or Si with j = 1 to 6; and
R is independently selected from hydrocarbyl groups, $C_mH_{2m+1}$, branched hydrocarbyl groups, or hydrocarbyl groups with one or more heteroatoms of S, N, O, P, or Si with m = 1 to 15, and

n = 1 to 4,
wherein the Ar and Q diradicals are independently selected in each of the n subunits of the chromophore.

Preferably at least one of the substantially aromatic molecular nuclei, $A_e$ or $A_d$, has the structure:

$$-(Ar-N)_n-Ar-$$

wherein

Ar is independently selected form an aromatic diradical, a heteroaromatic diradical bonded linearly or substantially linearly to adjoining diradicals, or a single bond;
N is a diradical having the structure:

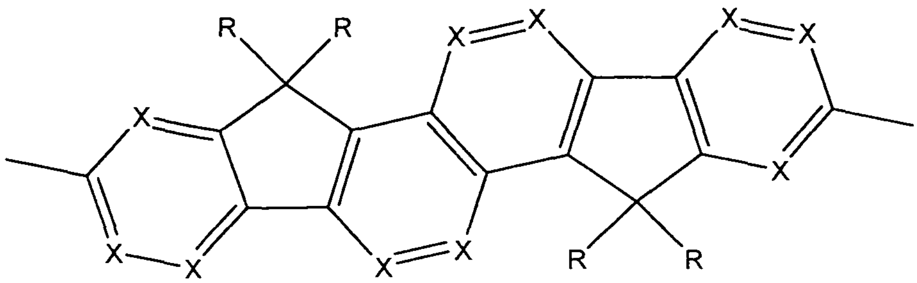

wherein

X is independently selected from N, CH, or $CR_1$ where $R_1$ is independently selected from hydrocarbyl groups, $C_jH_{2j+1}$, branched hydrocarbyl groups, or hydrocarbyl groups with one or more heteroatoms of S, N, O, P, or Si with j = 1 to 6; and
R is independently selected from hydrocarbyl groups, $C_mH_{2m+1}$, branched hydrocarbyl groups, or hydrocarbyl groups with one or more heteroatoms of S, N, O, P, or Si with m = 1 to 15, and

n = 1 to 6,
wherein the Ar and N diradicals are independently selected in each of the n subunits of the chromophore.

Preferably at least one of the substantially aromatic molecular nuclei, $A_e$ or $A_d$, has the structure:

$$-(Ar-L)_n-Ar-$$

wherein

Ar is independently selected from an aromatic diradical, a heteroaromatic diradical bonded linearly or substantially linearly to adjoining diradicals, or a single bond;
L is a diradical having the structure:

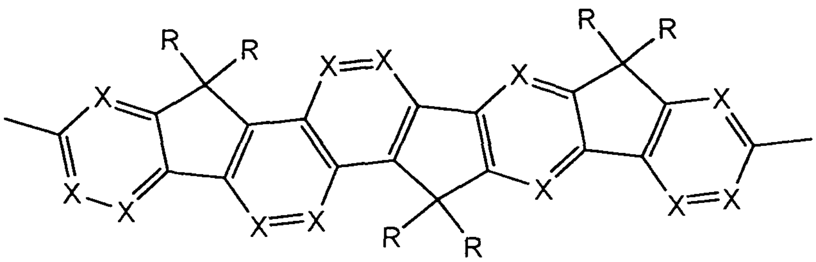

wherein

X is independently selected from N, CH, or $CR_1$ where $R_1$ is independently selected from hydrocarbyl groups, $C_jH_{2j+1}$, branched hydrocarbyl groups, or hydrocarbyl groups with one or more heteroatoms of S, N, O, P, or Si with j = 1 to 6; and
R is independently selected from hydrocarbyl groups, $C_mH_{2m+1}$, branched hydrocarbyl groups, or hydrocarbyl groups with one or more heteroatoms of S, N, O, P, or Si with m = 1 to 15, and

n = 1 to 4,
wherein the Ar and L diradicals are independently selected in each of the n subunits of the chromophore.

Preferably at least one of the substantially aromatic molecular nuclei, $A_e$ or $A_d$, has the structure:

$$-(Ar-M)_n-Ar-$$

wherein

Ar is independently selected form an aromatic diradical, a heteroaromatic diradical bonded linearly or substantially linearly to adjoining diradicals, or a single bond;
M is a diradical having the structure:

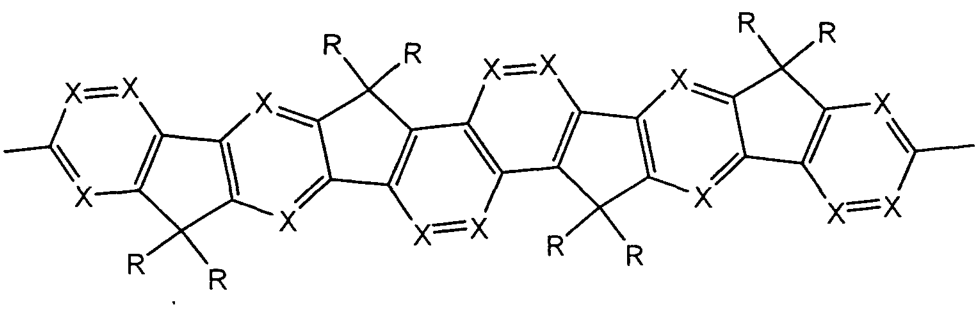

wherein

X is independently selected from N, CH, or $CR_1$ where $R_1$ is independently selected from hydrocarbyl groups,

$C_jH_{2j+1}$, branched hydrocarbyl groups, or hydrocarbyl groups with one or more heteroatoms of S, N, O, P, or Si with j = 1 to 6; and
R is independently selected from hydrocarbyl groups, $C_mH_{2m+1}$, branched hydrocarbyl groups, or hydrocarbyl groups with one or more heteroatoms of S, N, O, P, or Si with m = 1 to 15, and

n = 1 to 4,
wherein the Ar and M diradicals are independently selected in each of the n subunits of the chromophore.

Preferably at least one of the substantially aromatic molecular nuclei, $A_e$ or $A_d$, has the structure:

$$-(Ar-G)_n-Ar-$$

wherein

Ar is independently selected from an aromatic diradical, a heteroaromatic diradical bonded linearly or substantially linearly to adjoining diradicals, or a single bond;
G is a diradical having the structure:

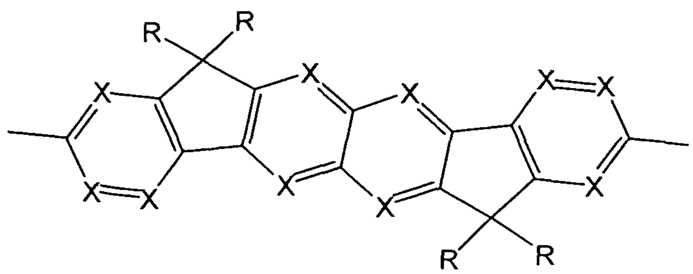

wherein

X is independently selected from N, CH, or $CR_1$ where $R_1$ is independently selected from hydrocarbyl groups, $C_jH_{2j+1}$, branched hydrocarbyl groups, or hydrocarbyl groups with one or more heteroatoms of S, N, O, P, or Si with j = 1 to 6; and
R is independently selected from hydrocarbyl groups, $C_mH_{2m+1}$, branched hydrocarbyl groups, or hydrocarbyl groups with one or more heteroatoms of S, N, O, P, or Si with m = 1 to 15, and

n = 1 to 6,
wherein the Ar and G diradicals are independently selected in each of the n subunits of the chromophore.

Preferably at least one of the substantially aromatic molecular nuclei, $A_e$ or $A_d$, has the structure:

$$-(Ar-S')_n-Ar-$$

wherein

Ar is independently selected from an aromatic diradical, a heteroaromatic diradical bonded linearly or substantially linearly to adjoining diradicals, or a single bond;
S' is a diradical having the structure:

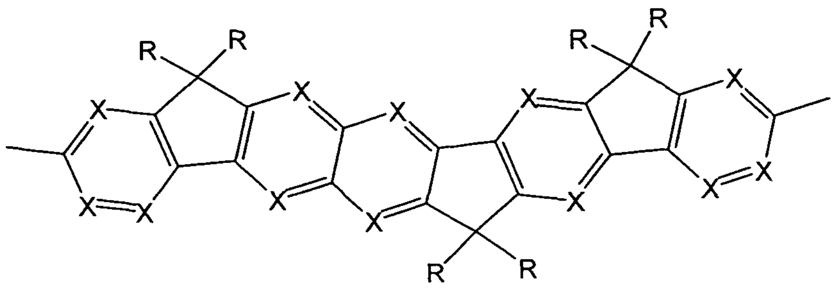

wherein

X is independently selected from N, CH, or $CR_1$ where $R_1$ is independently selected from hydrocarbyl groups, $C_jH_{2j+1}$, branched hydrocarbyl groups, or hydrocarbyl groups with one or more heteroatoms of S, N, O, P, or Si with j = 1 to 6; and
R is independently selected from hydrocarbyl groups, $C_mH_{2m+1}$, branched hydrocarbyl groups, or hydrocarbyl groups with one or more heteroatoms of S, N, O, P, or Si with m = 1 to 15, and

n = 1 to 4,
wherein the Ar and S' diradicals are independently selected in each of the n subunits of the chromophore.

Preferably at least one of the substantially aromatic molecular nuclei, $A_e$ or $A_d$, has the structure:

$-(Ar-U)_n-Ar-$

wherein

Ar is independently selected from an aromatic diradical, a heteroaromatic diradical bonded linearly or substantially linearly to adjoining diradicals, or a single bond;
U is a diradical having the structure:

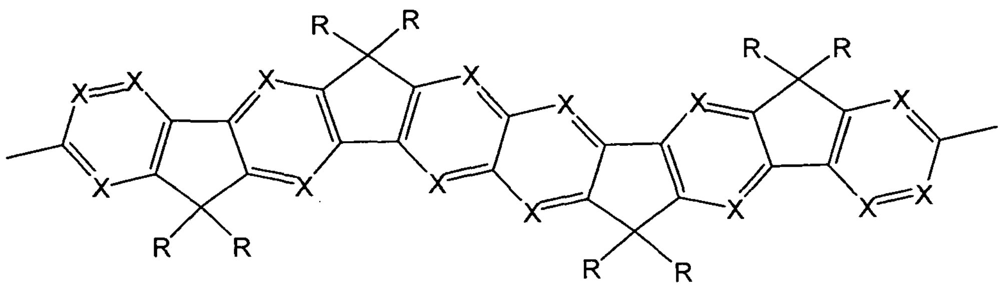

wherein

X is independently selected from N, CH, or $CR_1$ where $R_1$ is independently selected from hydrocarbyl groups, $C_jH_{2j+1}$, branched hydrocarbyl groups, or hydrocarbyl groups with one or more heteroatoms of S, N, O, P, or Si with j = 1 to 6; and
R is independently selected from hydrocarbyl groups, $C_mH_{2m+1}$, branched hydrocarbyl groups, or hydrocarbyl groups with one or more heteroatoms of S, N, O, P, or Si with m = 1 to 15, and

n = 1 to 4,
wherein the Ar and U diradicals are independently selected in each of the n subunits of the chromophore.

Preferably at least one of the substantially aromatic molecular nuclei, $A_e$ or $A_d$, has the structure:

$-(Ar-V)_n-Ar-$

wherein

Ar is independently selected from an aromatic diradical, a heteroaromatic diradical bonded linearly or substantially linearly to adjoining diradicals, or a single bond;
V is a diradical having the structure:

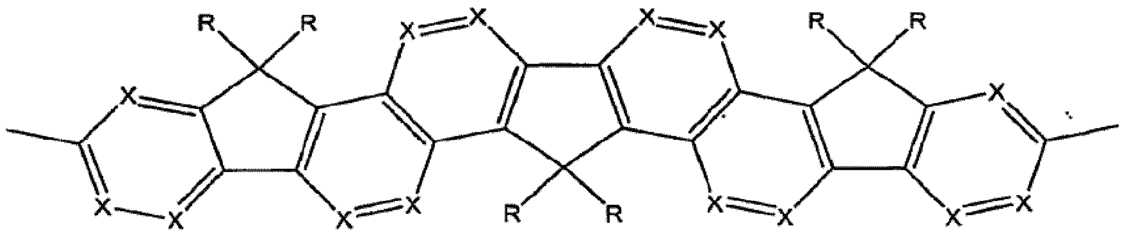

wherein

X is independently selected from N, CH, or $CR_1$ where $R_1$ is independently selected from hydrocarbyl groups, $C_jH_{2j+1}$, branched hydrocarbyl groups, or hydrocarbyl groups with one or more heteroatoms of S, N, O, P, or Si with j = 1 to 6; and
R is independently selected from hydrocarbyl groups, $C_mH_{2m+1}$, branched hydrocarbyl groups, or hydrocarbyl groups with one or more heteroatoms of S, N, O, P, or Si with m = 1 to 15, and

n = 1 to 4,
wherein the Ar and V diradicals are independently selected in each of the n subunits of the chromophore.

There is described herein a process (not forming part of the invention) for forming organic semiconductor, charge transporting or light emitting polymers comprising:

photopolymerization of a mixture of at least two polymerizable components,
wherein
At least one of the at least two components comprises molecules of the general formula:

$$A_e\text{-}(S\text{-}B_e)_n,$$

and
at least another one of the at least two components comprises molecules of the general formula:

$$A_d(S\text{-}B_d)_m$$

wherein

$A_e$ is a substantially aromatic molecular nucleus;
$B_e$ is an independently selected crosslinking group;
$A_d$ is a substantially aromatic molecular nucleus;
$B_d$ is an independently selected crosslinking group;
S is independently selected flexible spacer;
n is from 1 to 20;
m is from 1 to 20, and

wherein the photopolymerization is initiated by electron transfer from $B_e$ groups to $B_d$ groups.

Preferably the polymerization is photopolymerization. Preferably the mixture after polymerization forms an electroluminescent material. Preferably the mixture after polymerization is included in a field effect transistor or a photovoltaic device. Preferably the mixture after polymerization is used in a luminescent application. Preferably the mixture before polymerization exhibits a liquid crystalline phase. Preferably the liquid crystalline phase is a calamitic phase, a nematic phase, or a discotic phase. Preferably
the crosslinking group $B_e$ is a vinyl ether group. Preferably the crosslinking group $B_d$ is a maleimide group, a maleate

group, or a fumarate group. Preferably at least one of the substantially aromatic molecular nuclei, $A_e$ or $A_d$, is organometallic in nature. Preferably at least one of the substantially aromatic molecular nuclei, $A_e$ or $A_d$, has the structure:

$$-(Ar\text{-}F)_n\text{-}Ar-$$

wherein

Ar is independently selected from an aromatic diradical, a heteroaromatic diradical bonded linearly or substantially linearly to adjoining diradicals, or a single bond;
F is an independently selected diradical having the structure:

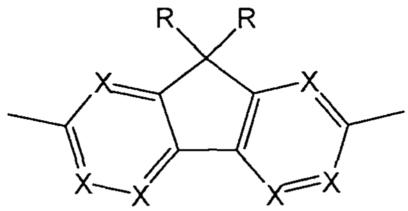

wherein X is independently selected from N, CH, or $CR_1$ where $R_1$ is independently selected from hydrocarbyl groups, $C_jH_{2j+1}$, branched hydrocarbyl groups, or hydrocarbyl groups with one or more heteroatoms of S, N, O, P, or Si with j = 1 to 6; and
R is independently selected from hydrocarbyl groups, $C_mH_{2m+1}$, branched hydrocarbyl groups, or hydrocarbyl groups with one or more heteroatoms of S, N, O, P, or Si, with m = 1 to 15, and

the Ar and F diradicals are independently selected in each of the n subunits of the chromophore; and
$1 \leq n \leq 10$.

Preferably at least one of the substantially aromatic molecular nuclei, $A_e$ or $A_d$, has the structure

$$-(Ar\text{-}D)_n\text{-}Ar-$$

wherein

Ar is independently selected from an aromatic diradical, a heteroaromatic diradical bonded linearly or substantially linearly to adjoining diradicals, or a single bond;
D is a diradical having the structure:

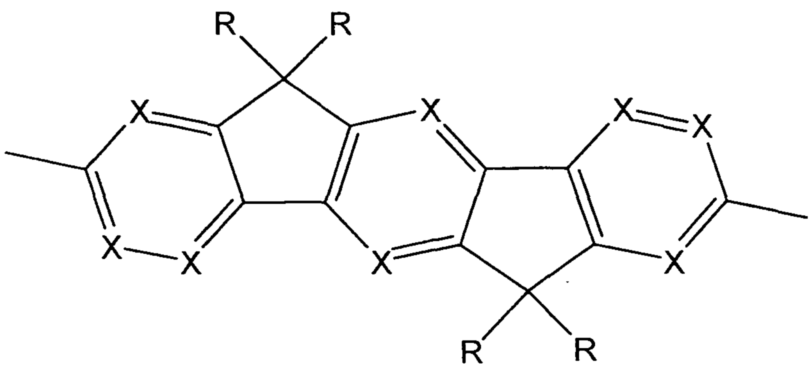

wherein

X is independently selected from N, CH, or $CR_1$ where $R_1$ is independently selected from hydrocarbyl groups, $C_jH_{2j+1}$, branched hydrocarbyl groups, or hydrocarbyl groups with one or more heteroatoms of S, N, O, P, or Si with j = 1 to 6, and
R is independently selected from hydrocarbyl groups, $C_mH_{2m+1}$, branched hydrocarbyl groups, or hydrocarbyl groups with one or more heteroatoms of S, N, O, P, or Si, with m = 1 to 15, and

the Ar and D diradicals are independently selected in each of the n subunits of the chromophore; and n = 1 to 6.

Preferably at least one of the substantially aromatic molecular nuclei, $A_e$ or $A_d$, has the structure:

$$-(Ar-T)_n-Ar-$$

wherein

Ar is independently selected from an aromatic diradical, a heteroaromatic diradical bonded linearly or substantially linearly to adjoining diradicals, or a single bond;
T is a diradical having the structure:

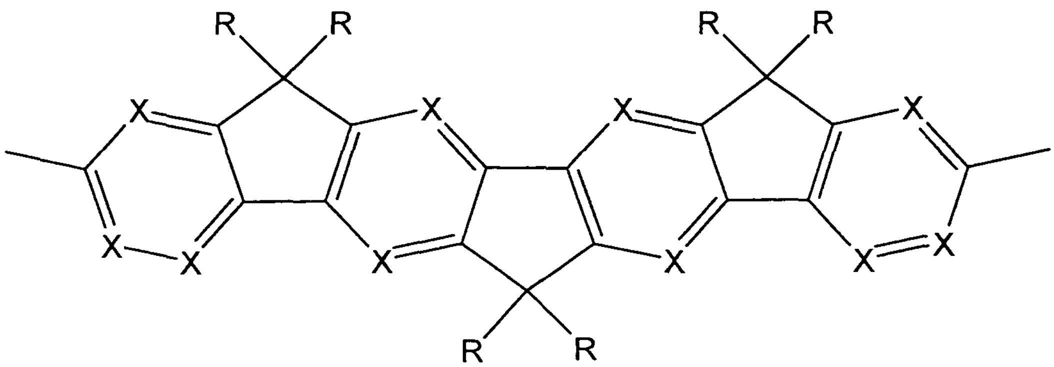

wherein

X is independently selected from N, CH, or $CR_1$ where $R_1$ is independently selected from hydrocarbyl groups, $C_jH_{2j+1}$, branched hydrocarbyl groups, or hydrocarbyl groups with one or more heteroatoms of S, N, O, P, or Si with j = 1 to 6;
R is independently selected from hydrocarbyl groups, $C_mH_{2m+1}$, branched hydrocarbyl groups, or hydrocarbyl groups with one or more heteroatoms of S, N, O, P, or Si with m = 1 to 15, and

n = 1 to 4,
wherein the Ar and T diradicals are independently selected in each of the n subunits of the chromophore.

Preferably at least one of the substantially aromatic molecular nuclei, $A_e$ or $A_d$, has the structure:

$$-(Ar-Q)_n-Ar-$$

wherein

Ar is independently selected from an aromatic diradical, a heteroaromatic diradical bonded linearly or substantially linearly to adjoining diradicals, or a single bond;
Q is a diradical having the structure:

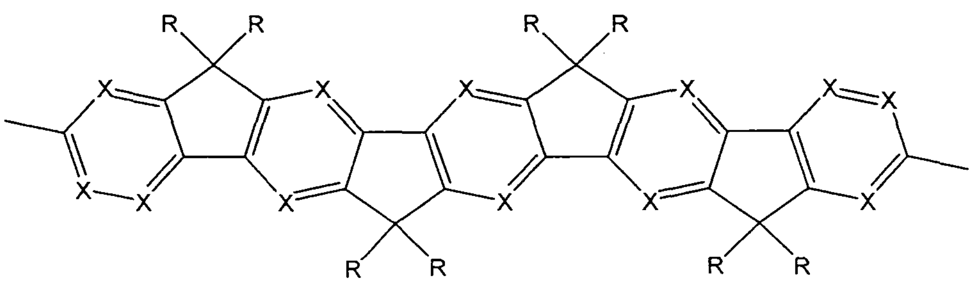

wherein

X is independently selected from N, CH, or $CR_1$ where $R_1$ is independently selected from hydrocarbyl groups, $C_jH_{2j+1}$, branched hydrocarbyl groups, or hydrocarbyl groups with one or more heteroatoms of S, N, O, P, or Si with j = 1 to 6; and

R is independently selected from hydrocarbyl groups, $C_mH_{2m+1}$, branched hydrocarbyl groups, or hydrocarbyl groups with one or more heteroatoms of S, N, O, P, or Si with m = 1 to 15, and

n = 1 to 4,

wherein the Ar and Q diradicals are independently selected in each of the n subunits of the chromophore.

Preferably at least one of the substantially aromatic molecular nuclei, $A_e$ or $A_d$, has the structure:

$$-(Ar-N)_n-Ar-$$

wherein

Ar is independently selected form an aromatic diradical, a heteroaromatic diradical bonded linearly or substantially linearly to adjoining diradicals, or a single bond;

N is a diradical having the structure:

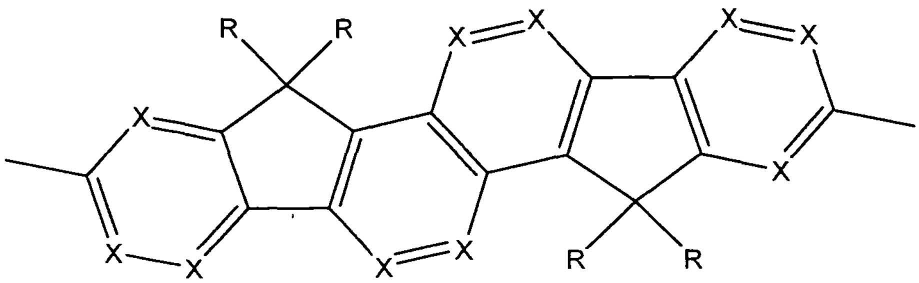

wherein

X is independently selected from N, CH, or $CR_1$ where $R_1$ is independently selected from hydrocarbyl groups, $C_jH_{2j+1}$, branched hydrocarbyl groups, or hydrocarbyl groups with one or more heteroatoms of S, N, O, P, or Si with j = 1 to 6; and

R is independently selected from hydrocarbyl groups, $C_mH_{2m+1}$, branched hydrocarbyl groups, or hydrocarbyl groups with one or more heteroatoms of S, N, O, P, or Si with m = 1 to 15, and

n = 1 to 6,

wherein the Ar and N diradicals are independently selected in each of the n subunits of the chromophore.

Preferably at least one of the substantially aromatic molecular nuclei, $A_e$ or $A_d$, has the structure:

$$-(Ar-L)_n-Ar-$$

wherein

Ar is independently selected from an aromatic diradical, a heteroaromatic diradical bonded linearly or substantially linearly to adjoining diradicals, or a single bond;

L is a diradical having the structure:

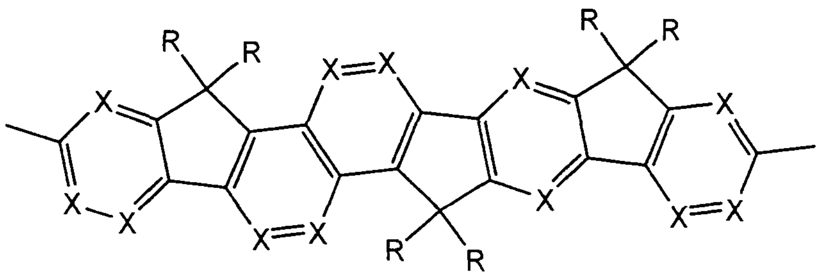

wherein

X is independently selected from N, CH, or $CR_1$ where $R_1$ is independently selected from hydrocarbyl groups, $C_jH_{2j+1}$, branched hydrocarbyl groups, or hydrocarbyl groups with one or more heteroatoms of S, N, O, P, or Si with j = 1 to 6; and
R is independently selected from hydrocarbyl groups, $C_mH_{2m+1}$, branched hydrocarbyl groups, or hydrocarbyl groups with one or more heteroatoms of S, N, O, P, or Si with m = 1 to 15, and

n = 1 to 4,
wherein the Ar and L diradicals are independently selected in each of the n subunits of the chromophore.

Preferably at least one of the substantially aromatic molecular nuclei, $A_e$ or $A_d$, has the structure:

$$-(Ar-M)_n-Ar-$$

wherein

Ar is independently selected form an aromatic diradical, a heteroaromatic diradical bonded linearly or substantially linearly to adjoining diradicals, or a single bond;
M is a diradical having the structure:

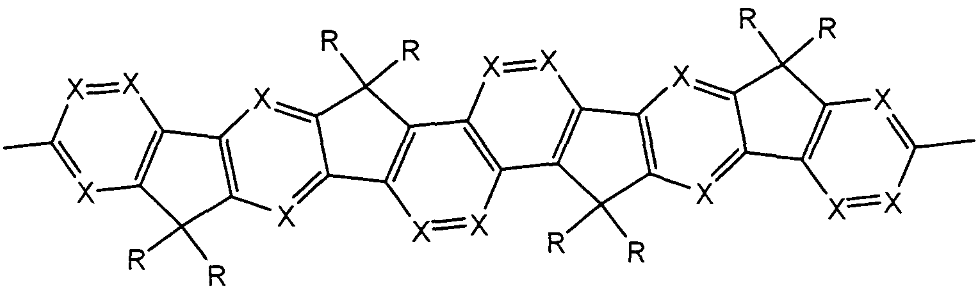

wherein

X is independently selected from N, CH, or $CR_1$ where $R_1$ is independently selected from hydrocarbyl groups, $C_jH_{2j+1}$, branched hydrocarbyl groups, or hydrocarbyl groups with one or more heteroatoms of S, N, O, P, or Si with j = 1 to 6; and
R is independently selected from hydrocarbyl groups, $C_mH_{2m+1}$, branched hydrocarbyl groups, or hydrocarbyl groups with one or more heteroatoms of S, N, O, P, or Si with m = 1 to 15, and

n = 1 to 4,
wherein the Ar and M diradicals are independently selected in each of the n subunits of the chromophore.

Preferably at least one of the substantially aromatic molecular nuclei, $A_e$ or $A_d$, has the structure:

$$-(Ar-G)_n-Ar-$$

wherein

Ar is independently selected from an aromatic diradical, a heteroaromatic diradical bonded linearly or substantially linearly to adjoining diradicals, or a single bond;
G is a diradical having the structure:

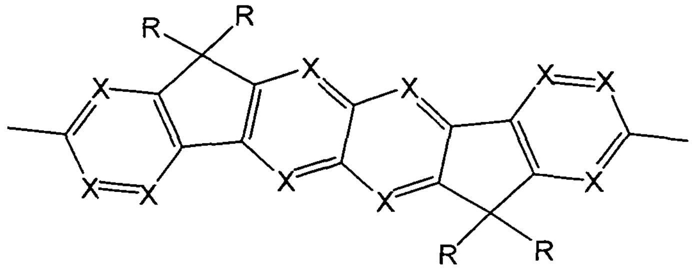

wherein

X is independently selected from N, CH, or $CR_1$ where $R_1$ is independently selected from hydrocarbyl groups, $C_jH_{2j+1}$, branched hydrocarbyl groups, or hydrocarbyl groups with one or more heteroatoms of S, N, O, P, or Si with j = 1 to 6; and
R is independently selected from hydrocarbyl groups, $C_mH_{2m+1}$, branched hydrocarbyl groups, or hydrocarbyl groups with one or more heteroatoms of S, N, O, P, or Si with m = 1 to 15, and

n = 1 to 6,
wherein the Ar and G diradicals are independently selected in each of the n subunits of the chromophore.

Preferably at least one of the substantially aromatic molecular nuclei, $A_e$ or $A_d$, has the structure:

$$-(Ar\text{-}S')_n\text{-}Ar-$$

wherein

Ar is independently selected from an aromatic diradical, a heteroaromatic diradical bonded linearly or substantially linearly to adjoining diradicals, or a single bond;
S' is a diradical having the structure:

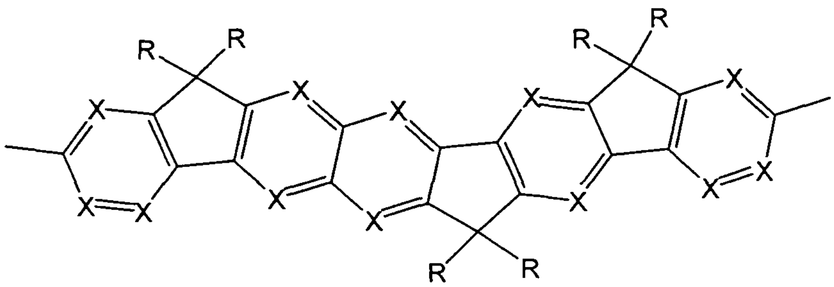

wherein

X is independently selected from N, CH, or $CR_1$ where $R_1$ is independently selected from hydrocarbyl groups, $C_jH_{2j+1}$, branched hydrocarbyl groups, or hydrocarbyl groups with one or more heteroatoms of S, N, O, P, or Si with j = 1 to 6; and
R is independently selected from hydrocarbyl groups, $C_mH_{2m+1}$, branched hydrocarbyl groups, or hydrocarbyl groups with one or more heteroatoms of S, N, O, P, or Si with m = 1 to 15, and

n = 1 to 4,
wherein the Ar and S' diradicals are independently selected in each of the n subunits of the chromophore.

Preferably at least one of the substantially aromatic molecular nuclei, $A_e$ or $A_d$, has the structure:

$-(Ar-U)_n-Ar-$

wherein

Ar is independently selected from an aromatic diradical, a heteroaromatic diradical bonded linearly or substantially linearly to adjoining diradicals, or a single bond;
U is a diradical having the structure:

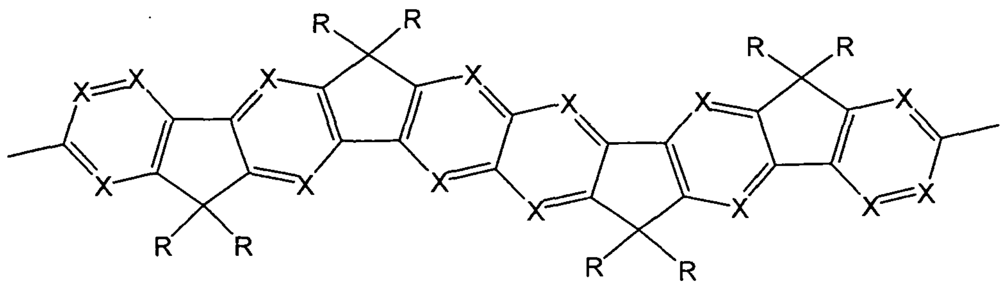

wherein

X is independently selected from N, CH, or $CR_1$ where $R_1$ is independently selected from hydrocarbyl groups, $C_jH_{2j+1}$, branched hydrocarbyl groups, or hydrocarbyl groups with one or more heteroatoms of S, N, O, P, or Si with j = 1 to 6; and
R is independently selected from hydrocarbyl groups, $C_mH_{2m+1}$, branched hydrocarbyl groups, or hydrocarbyl groups with one or more heteroatoms of S, N, O, P, or Si with m = 1 to 15, and

n = 1 to 4,
wherein the Ar and U diradicals are independently selected in each of the n subunits of the chromophore.

Preferably at least one of the substantially aromatic molecular nuclei, $A_e$ or $A_d$, has the structure:

$-(Ar-V)_n-Ar-$

wherein

Ar is independently selected from an aromatic diradical, a heteroaromatic diradical bonded linearly or substantially linearly to adjoining diradicals, or a single bond;
V is a diradical having the structure:

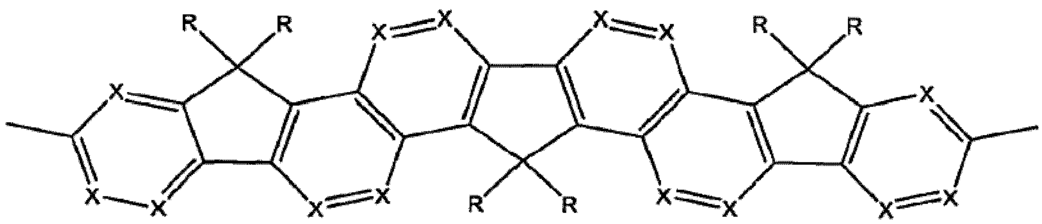

wherein

X is independently selected from N, CH, or $CR_1$ where $R_1$ is independently selected from hydrocarbyl groups, $C_jH_{2j+1}$, branched hydrocarbyl groups, or hydrocarbyl groups with one or more heteroatoms of S, N, O, P, or Si with j = 1 to 6; and
R is independently selected from hydrocarbyl groups, $C_mH_{2m+1}$, branched hydrocarbyl groups, or hydrocarbyl groups with one or more heteroatoms of S, N, O, P, or Si with m = 1 to 15, and

n = 1 to 4,

wherein the Ar and V diradicals are independently selected in each of the n subunits of the chromophore.

There is described herein a process for forming a organic semiconductor, charge polymer transporting polymer or light emitting polymer comprising: polymerizing polymerizable materials having the molecular structure B-S-A-S-B, wherein

B is a crosslinkable end group;
S is a flexible spacer; and
A is a substantially aromatic molecular nucleus having the structure

$$-(Ar-D)_n-Ar-$$

wherein

n = 1 to 6;
Ar is an aromatic diradical, a heteroaromatic diradical bonded linearly or substantially linearly to adjoining diradicals, or a single bond;
D is a diradical having the structure:

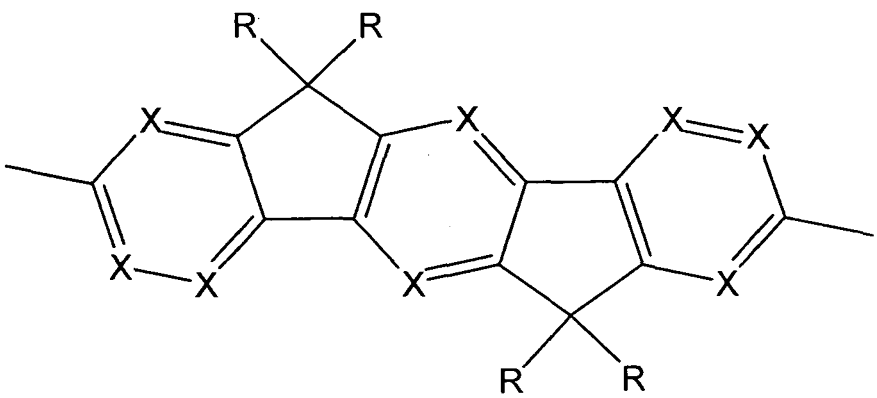

wherein

X is independently selected from N, CH, or $CR_1$ where $R_1$ is independently selected from hydrocarbyl groups, $C_jH_{2j+1}$, branched hydrocarbyl groups, or hydrocarbyl groups with one or more heteroatoms of S, N, O, P, or Si with j = 1 to 6; and

R is independently selected from hydrocarbyl groups, $C_mH_{2m+1}$, branched hydrocarbyl groups, or hydrocarbyl groups with one or more heteroatoms of S, N, O, P, or Si, with m = 1 to 15, and

the Ar and D diradicals are independently selected in each of the n subunits of the chromophore.

Preferably the crosslinkable end group B is 1,4-pentadien-3-yl. Preferably, the crosslinkable end group B is a methacrylate.

There is described herein a process for forming a charge transporting polymer or light emitting polymer comprising: polymerizing polymerizable materials having the molecular structure B-S-A-S-B, wherein

B is a crosslinkable end group;
S is a flexible spacer; and
A is a substantially aromatic molecular nucleus having the structure

$$(Ar-T)_n-Ar-$$

wherein

n = 1 to 4;
Ar is an aromatic diradical, a heteroaromatic diradical bonded linearly or substantially linearly to adjoining diradicals, or a single bond;

T is a diradical having the structure

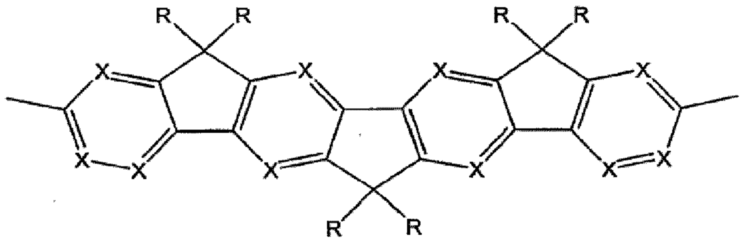

wherein

X is independently selected from N, CH, or $CR_1$ where $R_1$ is independently selected from hydrocarbyl groups, $C_jH_{2j+1}$, branched hydrocarbyl groups, or hydrocarbyl groups with one or more heteroatoms of S, N, O, P, or Si with j = 1 to 6; and
R is independently selected from hydrocarbyl groups, $C_mH_{2m+1}$, branched hydrocarbyl groups, or hydrocarbyl groups with one or more heteroatoms of S, N, O, P, or Si with m = 1 to 15, and
the Ar and T diradicals are independently selected in each of the n subunits of the chromophore.

Preferably the crosslinkable end group B is 1,4-pentadien-3-yl. Preferably the crosslinkable end group B is a methacrylate.

There is described herein a process for forming a charge transporting polymer or light emitting polymer comprising: polymerizing polymerizable materials having the molecular structure B-S-A-S-B, wherein
B is a crosslinkable end group;
S is a flexible spacer; and
A is a substantially aromatic molecular nucleus having the structure

$$-(Ar-Q)_n-Ar-$$

wherein

n = 1 to 4;
Ar is an aromatic diradical, a heteroaromatic diradical bonded linearly or substantially linearly to adjoining diradicals, or a single bond;
Q is a diradical having the structure

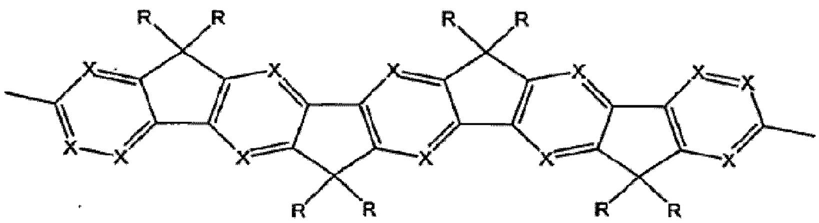

wherein

X is independently selected from N, CH, or $CR_1$ where $R_1$ is independently selected from hydrocarbyl groups, $C_jH_{2j+1}$, branched hydrocarbyl groups, or hydrocarbyl groups with one or more heteroatoms of S, N, O, P, or Si with j = 1 to 6; and
R is independently selected from hydrocarbyl groups, $C_mH_{2m+1}$, branched hydrocarbyl groups, or hydrocarbyl groups with one or more heteroatoms of S, N, O, P, or Si with m = 1 to 15, and

the Ar and Q diradicals are independently selected in each of the n subunits of the chromophore.

Preferably the crosslinkable end group B is 1,4-pentadien-3-yl. Preferably the crosslinkable end group B is a methacrylate.

There is described herein a process for forming a charge transporting polymer or light emitting polymer comprising: polymerizing polymerizable materials having the molecular structure B-S-A-S-B, wherein

B is a crosslinkable end group;
S is a flexible spacer; and
A is a substantially aromatic molecular nucleus having the structure

$$-(Ar\text{-}N)_n\text{-}Ar\text{-}$$

wherein

n = 1 to 6;
Ar is an aromatic diradical, a heteroaromatic diradical bonded linearly or substantially linearly to adjoining diradicals, or a single bond;
N is a diradical having the structure

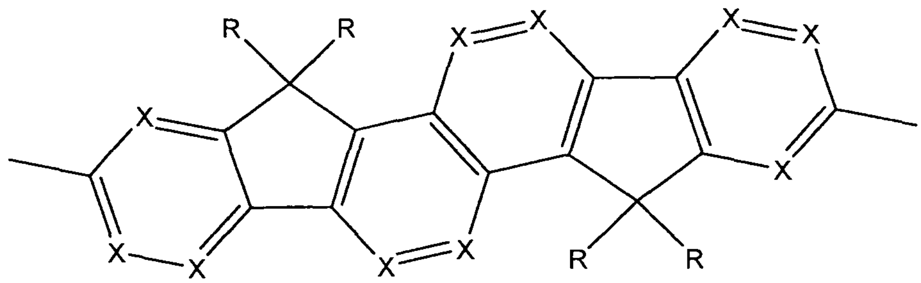

wherein

X is independently selected from N, CH, or $CR_1$ where $R_1$ is independently selected from hydrocarbyl groups, $C_jH_{2j+1}$, branched hydrocarbyl groups, or hydrocarbyl groups with one or more heteroatoms of S, N, O, P, or Si with j = 1 to 6; and
R is independently selected from hydrocarbyl groups, $C_mH_{2m+1}$, branched hydrocarbyl groups, or hydrocarbyl groups with one or more heteroatoms of S, N, O, P, or Si with m = 1 to 15, and

the Ar and N diradicals are independently selected in each of the n subunits of the chromophore.

Preferably the crosslinkable end group B is 1,4-pentadien-3-yl. Preferably the crosslinkable end group B is a methacrylate.

There is described herein a process for forming a charge transporting polymer or light emitting polymer comprising: polymerizing polymerizable materials having the molecular structure B-S-A-S-B, wherein

B is a crosslinkable end group;
S is a flexible spacer; and
A is a substantially aromatic molecular nucleus having the structure

$$-(Ar\text{-}L)_{n\text{-}}Ar\text{-}$$

wherein

n = 1 to 4;
Ar is an aromatic diradical, a heteroaromatic diradical bonded linearly or substantially linearly to adjoining diradicals, or a single bond;
L is a diradical having the structure

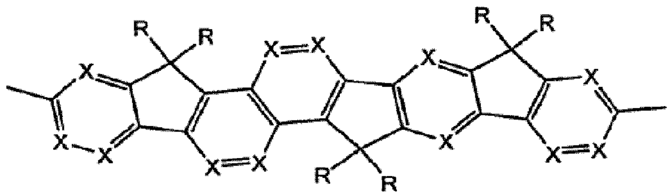

wherein

X is independently selected from N, CH, or $CR_1$ where $R_1$ is independently selected from hydrocarbyl groups, $C_jH_{2j+1}$, branched hydrocarbyl groups, or hydrocarbyl groups with one or more heteroatoms of S, N, O, P, or Si with j = 1 to 6; and
R is independently selected from hydrocarbyl groups, $C_mH_{2m+1}$, branched hydrocarbyl groups, or hydrocarbyl groups with one or more heteroatoms of S, N, O, P, or Si with m = 1 to 15, and

the Ar and L diradicals are independently selected in each of the n subunits of the chromophore.

Preferably the crosslinkable end group B is 1,4-pentadien-3-yl. Preferably the crosslinkable end group B is a methacrylate.

There is described herein a process for forming a charge transporting polymer or light emitting polymer comprising: polymerizing polymerizable materials having the molecular structure B-S-A-S-B,
wherein

B is a crosslinkable end group;

S is a flexible spacer; and

A is a substantially aromatic molecular nucleus having the structure

$$-(Ar-M)_n-Ar-$$

wherein

n = 1 to 4;

Ar is an aromatic diradical, a heteroaromatic diradical bonded linearly or substantially linearly to adjoining diradicals, or a single bond;

M is a diradical having the structure

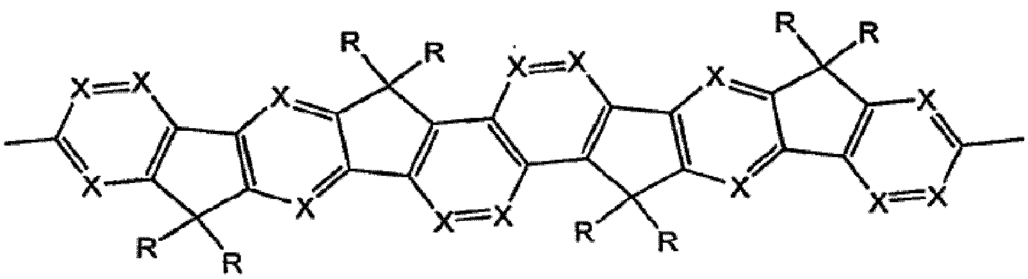

wherein

X is independently selected from N, CH, or $CR_1$ where $R_1$ is independently selected from hydrocarbyl groups, $C_jH_{2j+1}$, branched hydrocarbyl groups, or hydrocarbyl groups with one or more heteroatoms of S, N, O, P, or Si with j = 1 to 6; and
R is independently selected from hydrocarbyl groups, $C_mH_{2m+1}$, branched hydrocarbyl groups, or hydrocarbyl groups with one or more heteroatoms of S, N, O, P, or Si with m = 1 to 15, and

the Ar and M diradicals are independently selected in each of the n subunits of the chromophore.

Preferably the crosslinkable end group B is 1,4-pentadien-3-yl. Preferably the crosslinkable end group B is a methacrylate.

There is described herein a process for forming a charge transporting polymer or light emitting polymer comprising: polymerizing polymerizable materials having the molecular structure B-S-A-S-B,
wherein

B is a crosslinkable end group;
S is a flexible spacer; and
A is a substantially aromatic molecular nucleus having the structure

$$-(Ar-G)_n-Ar-$$

wherein

n = 1 to 6;
Ar is an aromatic diradical, a heteroaromatic diradical bonded linearly or substantially linearly to adjoining diradicals, or a single bond;
G is a diradical having the structure

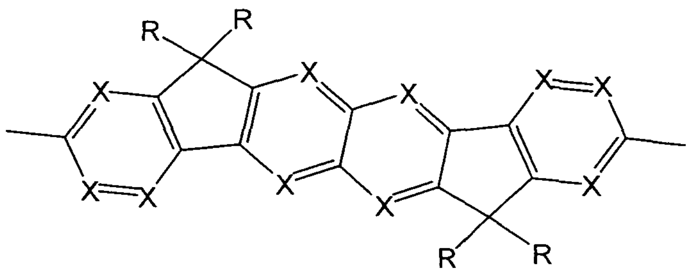

wherein

X is independently selected from N, CH, or $CR_1$ where $R_1$ is independently selected from hydrocarbyl groups, $C_jH_{2j+1}$, branched hydrocarbyl groups, or hydrocarbyl groups with one or more heteroatoms of S, N, O, P, or Si with j = 1 to 6; and
R is independently selected from hydrocarbyl groups, $C_mH_{2m+1}$, branched hydrocarbyl groups, or hydrocarbyl groups with one or more heteroatoms of S, N, O, P, or Si with m = 1 to 15, and

the Ar and G diradicals are independently selected in each of the n subunits of the chromophore.

Preferably the crosslinkable end group B is 1,4-pentadien-3-yl. Preferably the crosslinkable end group B is a methacrylate.

There is described herein a process for forming a charge transporting polymer or light emitting polymer comprising: polymerizing polymerizable materials having the molecular structure B-S-A-S-B,
wherein

B is a crosslinkable end group;
S is a flexible spacer; and
A is a substantially aromatic molecular nucleus having the structure

$$-(Ar-S')_n-Ar-$$

wherein

n = 1 to 4;
Ar is an aromatic diradical, a heteroaromatic diradical bonded linearly or substantially linearly to adjoining diradicals, or a single bond;

S' is a diradical having the structure

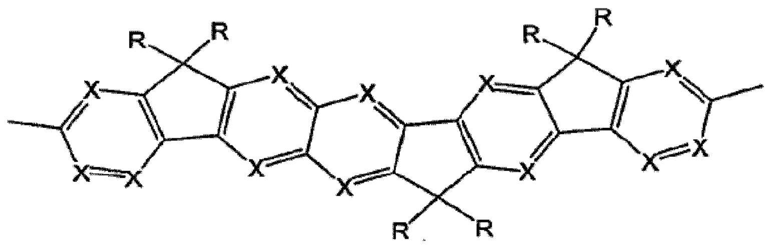

wherein

X is independently selected from N, CH, or $CR_1$ where $R_1$ is independently selected from hydrocarbyl groups, $C_jH_{2j+1}$, branched hydrocarbyl groups, or hydrocarbyl groups with one or more heteroatoms of S, N, O, P, or Si with j = 1 to 6; and

R is independently selected from hydrocarbyl groups, $C_mH_{2m+1}$, branched hydrocarbyl groups, or hydrocarbyl groups with one or more heteroatoms of S, N, O, P, or Si with m = 1 to 15, and

the Ar and S' diradicals are independently selected in each of the n subunits of the chromophore.

Preferably the crosslinkable end group B is 1,4-pentadien-3-yl. Preferably the crosslinkable end group B is a methacrylate.

There is described herein a process for forming a charge transporting polymer or light emitting polymer comprising: polymerizing polymerizable materials having the molecular structure B-S-A-S-B, wherein

B is a crosslinkable end group;
S is a flexible spacer; and
A is a substantially aromatic molecular nucleus having the structure

$$-(Ar-U)_n - Ar-$$

wherein

n = 1 to 4;
Ar is an aromatic diradical, a heteroaromatic diradical bonded linearly or substantially linearly to adjoining diradicals, or a single bond;
U is a diradical having the structure

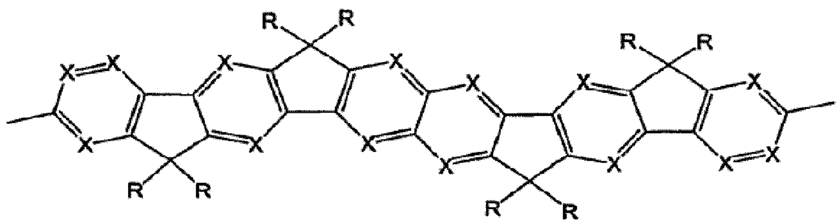

wherein

X is independently selected from N, CH, or $CR_1$ where $R_1$ is independently selected from hydrocarbyl groups, $C_jH_{2j+1}$, branched hydrocarbyl groups, or hydrocarbyl groups with one or more heteroatoms of S, N, O, P, or Si with j = 1 to 6; and

R is independently selected from hydrocarbyl groups, $C_mH_{2m+1}$, branched hydrocarbyl groups, or hydrocarbyl groups with one or more heteroatoms of S, N, O, P, or Si with m = 1 to 15, and

the Ar and U diradicals are independently selected in each of the n subunits of the chromophore.

Preferably the crosslinkable end group B is 1,4-pentadien-3-yl. Preferably the crosslinkable end group B is a methacrylate.

There is described herein a process for forming a charge transporting polymer or light emitting polymer comprising: polymerizing polymerizable materials having the molecular structure B-S-A-S-B, wherein

B is a crosslinkable end group;
S is a flexible spacer; and
A is a substantially aromatic molecular nucleus having the structure

$$-(Ar\text{-}V)_n\text{-}A_r\text{-}$$

wherein

n = 1 to 4;
Ar is an aromatic diradical, a heteroaromatic diradical bonded linearly or substantially linearly to adjoining diradicals, or a single bond;
V is a diradical having the structure

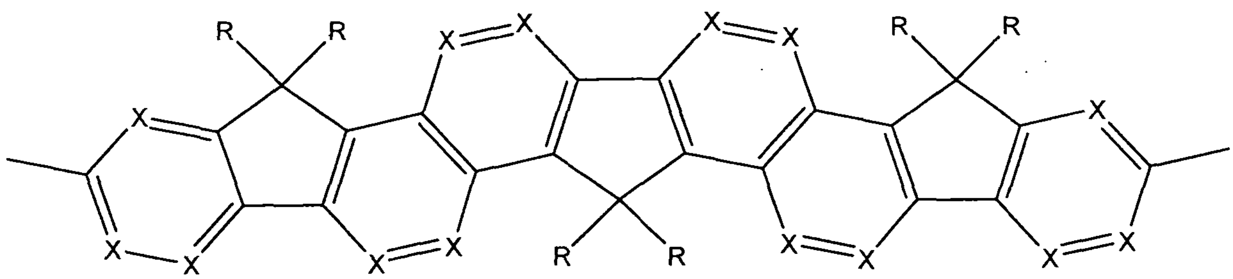

wherein

X is independently selected from N, CH, or $CR_1$ where $R_1$ is independently selected from hydrocarbyl groups, $C_jH_{2j+1}$, branched hydrocarbyl groups, or hydrocarbyl groups with one or more heteroatoms of S, N, O, P, or Si with j = 1 to 6; and
R is independently selected from hydrocarbyl groups, $C_mH_{2m+1}$, branched hydrocarbyl groups, or hydrocarbyl groups with one or more heteroatoms of S, N, O, P, or Si with m = 1 to 15, and

the Ar and V diradicals are independently selected in each of the n subunits of the chromophore.

Preferably the crosslinkable end group B is 1,4-pentadien-3-yl. Preferably the crosslinkable end group B is a methacrylate.

There is described herein a material (not forming part of the invention) for use in forming organic semiconductor, charge transporting or light emitting polymer comprising: a polymerizable materials having the molecular structure B-S-A-S-B wherein

B is a crosslinkable end group;
S is a flexible spacer; and
A is a substantially aromatic molecular nucleus having the structure

$$-(Ar\text{-}F^1)_n\text{-}Ar\text{-}$$

wherein

n = 1 to 8;
Ar is an aromatic diradical, a heteroaromatic diradical bonded linearly or substantially linearly to adjoining

diradicals, or a single bond;
$F^1$ is a diradical having a structure selected from the group consisting of:

or.

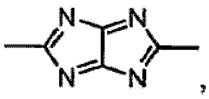, 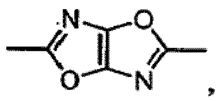, 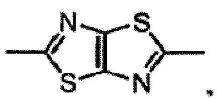,

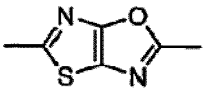, 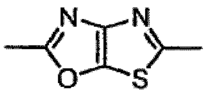, 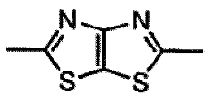 and, 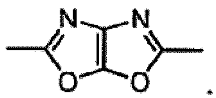.

the Ar diradicals are independently selected in each of the n subunits of the chromophore.

There is described herein a polymeric organic semiconductor, charge transporting or light emitting material (not forming part of the invention) comprising: a polymer formed from a polymerizable material having the molecular structure B-S-A-S-B
wherein

B is a crosslinkable end group;
S is a flexible spacer; and
A is a substantially aromatic molecular nucleus having the structure

$$-(Ar- F^1)_n-Ar-$$

wherein

n = 1 to 8;
Ar is an aromatic diradical, a heteroaromatic diradical bonded linearly or substantially linearly to adjoining diradicals, or a single bond;
$F^1$ is a diradical having a structure selected from the group consisting of:

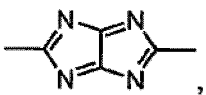, 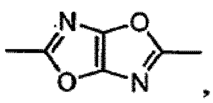, 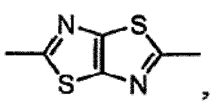,

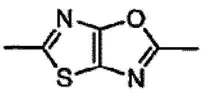, 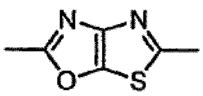, 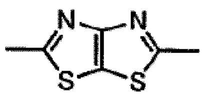 and, 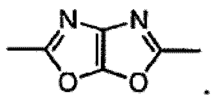.

the Ar diradicals are independently selected in each of the n subunits of the chromophore.

There is described herein a process (not forming part of the invention) for forming an organic semiconductor polymer, charge transporting polymer or light emitting polymer comprising:

polymerizing polymerizable materials having the molecular structure B-S-A-S-B,
wherein

B is a crosslinkable end group;
S is a flexible spacer; and
A is a substantially aromatic molecular nucleus having the structure

$$-(Ar- F^1)_n-Ar-$$

wherein

n = 1 to 8;
Ar is an aromatic diradical, a heteroaromatic diradical bonded linearly or substantially linearly to adjoining diradicals, or a single bond;
$F^1$ is a diradical having a structure selected from the group consisting of:

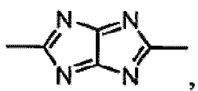,
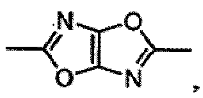,
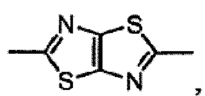,
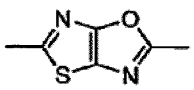,
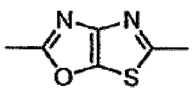,
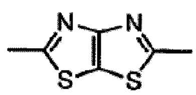 and,
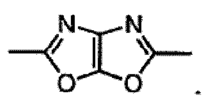.

and
the Ar diradicals are independently selected in each of the n subunits of the chromophore.

There is described herein an organic semiconductor, charge transporting or light emitting polymer comprising: a polymer formed by polymerization of mixure of one of more components (not forming part of the invention), at least one of the one of more component having molecules of formula $A\text{-}(S\text{-}B)_n$
wherein

n is from 1 to 20;
A is a substantially aromatic molecular nucleus;
S is a flexible spacer; and
B is an independently selected crosslinking group chosen from the group consisting of:

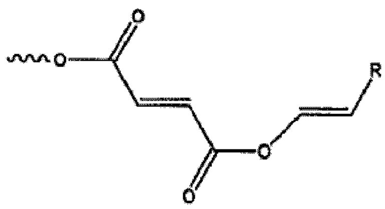
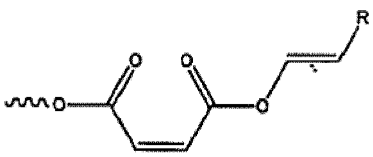
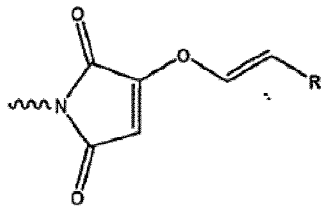

wherein R = H or alkyl.

Preferably the polymerization is photopolymerization. Preferably, the polymer is an electroluminescent material. Preferably, the polymer is included in a field effect transistor or a photovoltaic device. Preferably, the polymer is used in a luminescent application. Preferably, the polymer exhibits a liquid crystalline structure. Preferably, the liquid crystalline structure is a smectic structure, a nematic structure, or a discotic structure. Preferably, at least one of the substantially aromatic molecular nuclei, A, is organometallic nature.

There is described herein a material (not forming part of the invention) for use in forming organic semiconductor, charge transporting or light emitting polymers comprising:
A mixture including one of more components, at least one of the one of more components having molecules of formula $A\text{-}(S\text{-}B)_n$
wherein

n is from 1 to 20;
A is a substantially aromatic molecular nucleus;
S is a flexible spacer; and
B is an independently selected crosslinking group chosen from

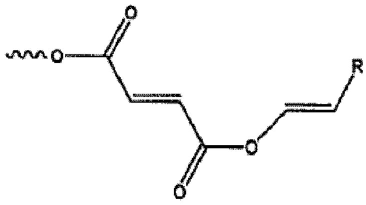
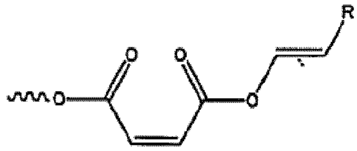
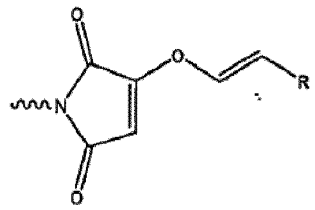

wherein R = H or alkyl.

Preferably, the mixture exhibits a liquid crystalline structure upon polymerization. Preferably, the liquid crystalline structure is a smectic structure, a nematic structure, or a discotic structure. Preferably, at least one of the substantially aromatic molecular nuclei, A, is organometallic in nature.

There is described herein a process (not forming part of the invention) for forming organic semiconductor, charge transporting or light emitting polymers comprising:
polymerizing polymerizable materials having the formula $A\text{-}(\text{-}S\text{-}B)_n$
wherein

A is a substantially aromatic molecular nucleus;
S is a flexible spacer; and
B is an independently selected crosslinking group chosen from the group consisting of:

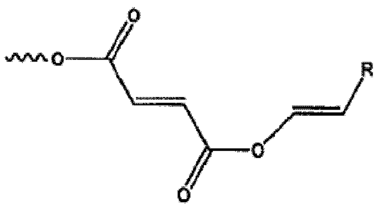
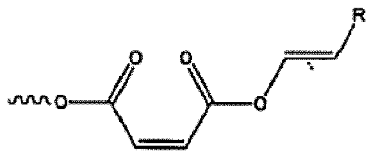
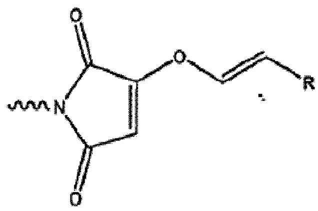

wherein R = H or alkyl.

Preferably the polymerizing is photopolymerizing. Preferably the polymerizable materials formed is an electroluminescent material after polymerization.

Preferably, the process further comprises depositing the polymerizable materials in a field effect transistor or a photovoltaic device. Preferably the polymerizable materials are used in a luminescent application. Preferably the polymerizable materials exhibit a liquid crystalline structure after polymerization. Preferably, the liquid crystalline structure is a smectic structure, a nematic structure, or a discotic structure. Preferably at least one of the substantially aromatic molecular nuclei, A, is organometallic in nature.

There is described herein an organic semiconductor, charge transporting or light emitting polymer (not forming part of the invention) comprising:
a polymer with calamitic liquid crystalline structure formed by polymerization of mixture of one of more components, at least one of the one of more components has molecules of formula B-S-A-S-B
wherein

A is a substantially aromatic molecular nucleus;
S is a flexible spacer; and
B is an independently selected crosslinking group chosen from the group consisting of:

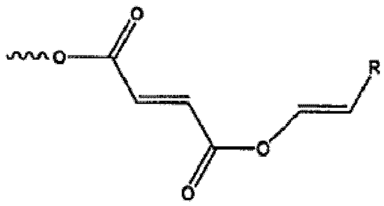
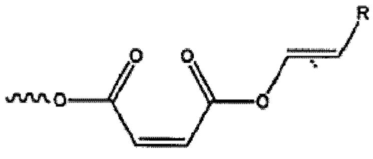
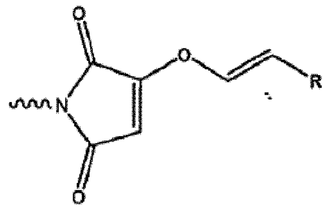

wherein R = H or alkyl.

Preferably the polymerization is photopolymerization. Preferably the polymer is an electroluminescent material. Preferably the polymer is included in a field effect transistor or photovoltaic device. Preferably the polymer is used in a luminescent application. Preferably at least one of the substantially aromatic molecular nuclei, A, is organometallic in nature.

There is described herein a material for use in forming organic semiconductor, charge transporting or light emitting polymers comprising:

A mixture of one of more components (not forming part of the invention), at least one of the one of more components has molecules of formula

B-S-A-S-B

wherein

A is a substantially aromatic molecular nucleus;

S is a flexible spacer; and

B is an independently selected crosslinking group chosen from the group consisting of:

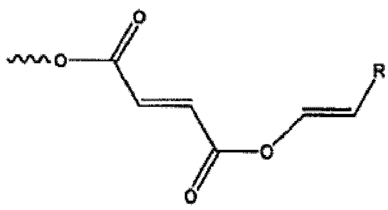
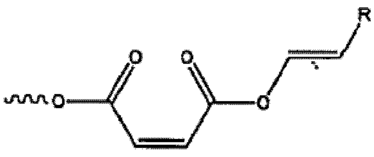
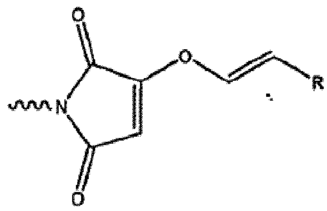

wherein R = H or alkyl.

Preferably the mixture formed exhibits a liquid crystalline structure after polymerization.

Preferably at least one of the one of more components has a monotropic or thermotropic calamitic liquid crystalline phase. Preferably at least one of the substantially aromatic molecular nuclei, A, is organometallic in nature. Preferably the mixture is photopolymerizable. Preferably the mixture forms an electroluminescent material upon polymerization. Preferably the mixture is included in a field effect transistor or a photovoltaic device. Preferably the mixture is used in a luminescent application.

There is described herein a process (not forming part of the invention) for in forming organic semiconductor, charge transporting or light emitting polymers comprising:

polymerizing of a mixture of one of more components, at least one of the one of more components has molecules of formula B-S-A-S-B

wherein

A is a substantially aromatic molecular nucleus;

S is a flexible spacer; and

B is an independently selected crosslinking group chosen from

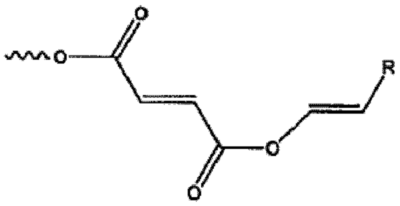

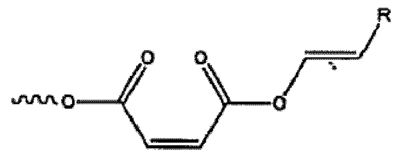

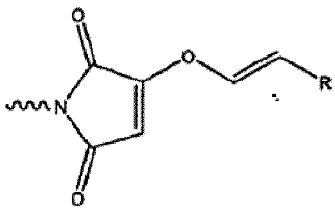

wherein R = H or alkyl.

Preferably the mixture of one of more components exhibits a liquid crystalline structure after polymerization. Preferably at least one of the one of more components has a monotropic or thermotropic calamitic liquid crystalline phase. Preferably at least one of the substantially aromatic molecular nuclei, A, is organometallic in nature. Preferably the polymerizing is photopolymerizing. Preferably the mixture of one of more components is an electroluminescent material after polymerization. Preferably, the process further comprises forming a field effect transistor or a photovoltaic device. Preferably the mixture of one of more components after polymerization is used in a luminescent application.

Brief Description of the Drawings

The invention will be described in detail with reference to the following drawings in which like reference numerals refer to like elements wherein:

FIG. 1 through FIG. 7 is a synthesis for

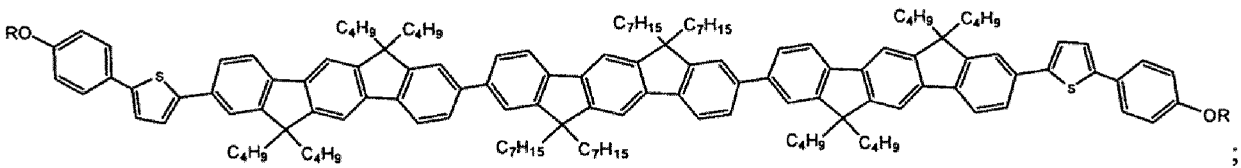

;

FIG. 8 through FIG. 12 is a synthesis for

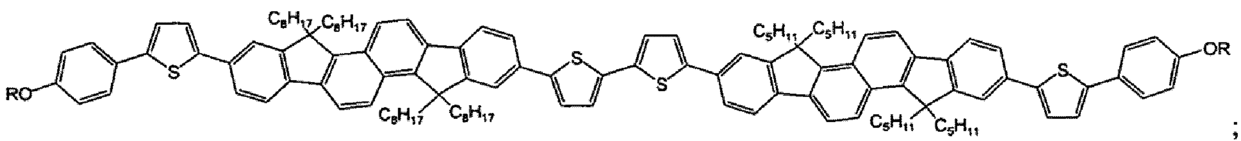

;

and

FIG. 13 through FIG. 20 is a synthesis for

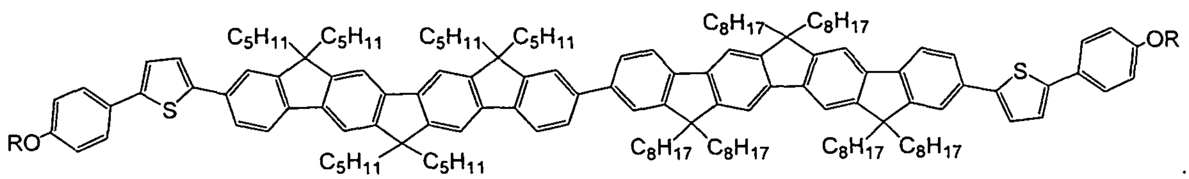

.

**Detailed Description**

Polymeric charge transporting and emitter materials fabricated by photocrosslinking reactive mesogen materials with molecular structure B-S-A-S-B wherein B are crosslinking groups, S are spacers such as n-alkylene diradicals, and A is a rod or lathe-shaped, largely aromatic molecular core.

Properties important in the commercial application of these materials include:

1. High quantum (emissive) efficiency

2. High carrier mobility
3. Low ultraviolet dose requirement for crosslinking
4. Reasonable solvent solubility that allows solvent casting of material films
5. Liquid crystalline phase temperatures that are accessible under normal processing conditions (e.g., room temperature).

Previously, nematic materials have been emphasized because their lower viscosity as compared to smectic materials leads to more rapid crosslinking at lower UV fluences. An example, is the material

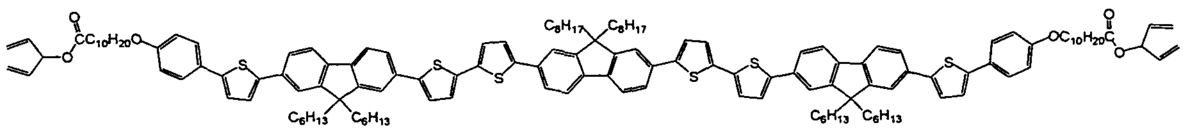

Compound 1

that has glass transition temperature of 26°C and a nematic to isotropic temperature of 188°C. The fact that there is apparently no crystalline solid phase for this material and a low glass transition temperature is greatly due to the lateral alkyl groups 9,9-substituted on the fluorenedi-2,7-yl diradicals in the molecule's backbone. If these lateral alkyl substituents were removed, the material would have an unacceptably high crystal to liquid crystal transition temperature. In addition, the presence of these lateral substituents destabilizes smectic phases in relation to the nematic phase. Without these substituents, interaction between the dipoles in the thiophene rings in the molecules' backbones would induce smectic order in any liquid crystal phases formed. The lateral substituents also greatly increase the solubility of the materials in deposition solvents.

The internal quantum efficiency of reactive mesogen-based polymers with molecular core structures including fluorene diradicals interspersed with other aromatic diradicals as in Compound 1 is quite good, up to 40 to 45%. An approach to increasing the quantum efficiency further is to eliminate the single bonds that connect the aromatic diradicals strung together to create the molecules backbone. Rotations about these single bonds are thought to be a major pathway relaxing energy away from the excited molecular state into phonons. Molecular architectures that reduce the number of single bond rotations incease quantum efficiency.

One approach to eliminating single bonds is to replace the thienylthiophene units in the molecular backbone of Compound 1 with thieno[3,2-b]thien-2,5-diyl diradicals as is described in US Patent Application 10/948,748. Thus, an improved molecule to Compound 1 is then

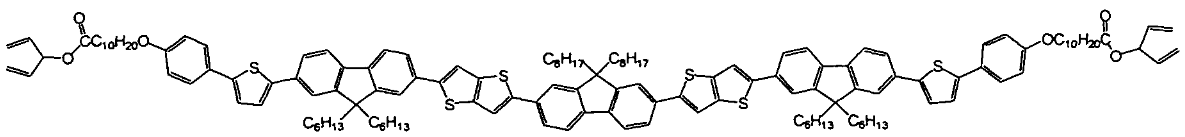

118

Compound 2

Compounds 1 and 2 have molecules that are terminated with 1,4-pentadien-3-yl crosslinking groups. These groups are advantageous in that they can be photocrosslinked with UV light without the use of a photoinitiator and without impacting luminescence efficiency. An issue with reactive mesogens terminated with 1,4-pentadien-3-yl groups is that they require high UV fluences (on the order of 100 to 500 joules/cm$^2$ for crosslinking). However, reactive mesogens with the B-S-A-S-B structure terminated with methacrylate groups crosslink with substantially lower UV fluences (typically less than 20 joules/cm$^2$, typically on the order of 5 to 10 joules/cm$^2$). Methacrylates also may be crosslinked without photoinitiators and without impacting luminescence efficiency. An example of a methacrylate terminated reactive mesogen emitter is Compound 3.

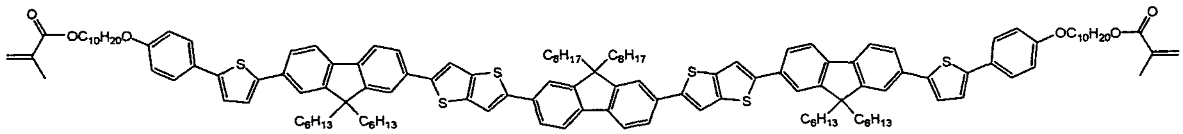

Compound 3

An issue with methacrylates is their thermal stability and long-term stability. This impacts the shelf-life of the materials and limits the methods by which they can be purified.

One aspect of the current invention is the use of fused aromatic ring diradicals containing two or more fluorene-like structures concatenated with other aromatic diradicals to form the rod or lathe-like aromatic core of the reactive mesogen molecules results in further increases in luminescence efficiency by further eliminating single bonds in the molecular backbone. Examples of such diradicals include

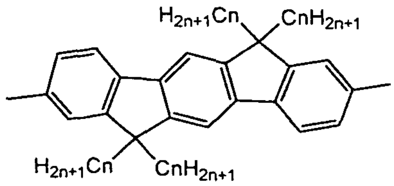

6,6,12,12-tetraalkyl-6,12-dihydro-indeno(1,2-b)fluorene-2,8-diyl,

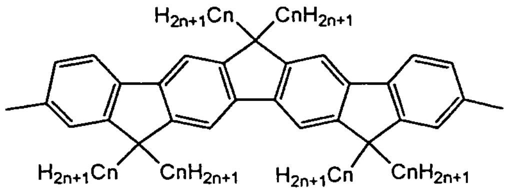

6,6,12,12,15,15-hexaalkyl-12,15-dihydro-6H-bis-indeno[1,2-b:2'1'-h]fluorene-2,10-diyl,

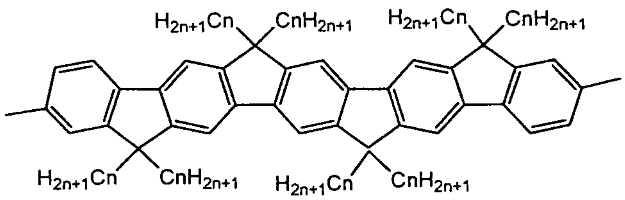

6,6,9,9,15,15,18,18-octaalkyl-6,9,15,18-tetrahydrodifluoreno[2,3-a:3',2'-g]-s-indacene-2,11-diyl,

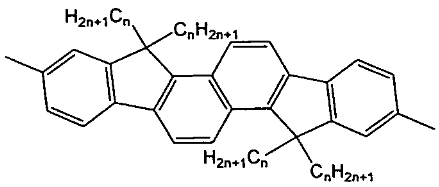

5,5,12,12-tetraalkyl-5,12-dihydrofluoreno(2,1-a)fluorene-3,9-diyl,

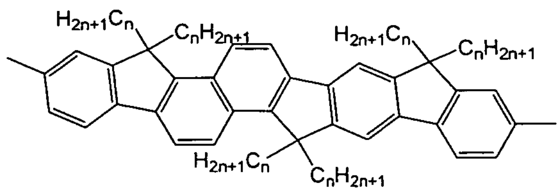

6,6,13,13,17,17-hexaalkyl-6,17-dihydro-13H-indeno(2,1-h)fluoreno(2,1-a)fluorene-2,11-diyl,

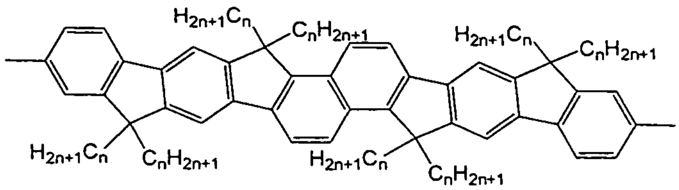

5,5,9,9,15,15,19,19-octaalkyl-5,9,15,19-tetrahydro-diindeno[2,1-h:1',2'-h']fluoreno(2,1-a)fluorene-2,11-diyl,

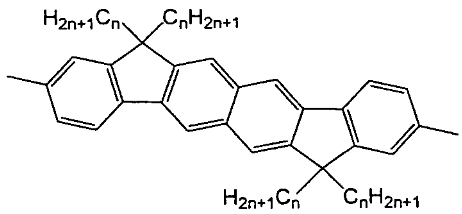

7,7,14,14-tetraalkyl-7,14-dihydro-fluoreno(3,2-b)fluorene-2,9-diyl,

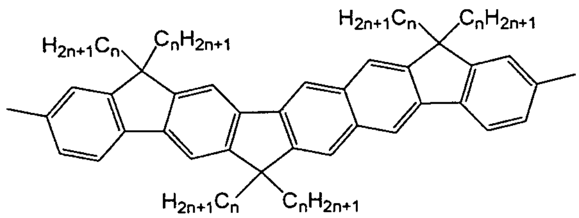

7,7,13,13,17,17-hexaalkyl-7,17-dihydro-13H-indeno(2,1-h)fluoreno(3,2-b)fluorene-2,11-diyl,

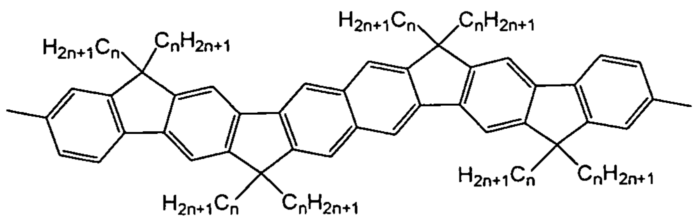

6,6,10,10,16,16,20,20-octaalkyl-6,10,16,20-tetrahydro-diindeno[2,1-h:2',1'-h']fluoreno(3,2-b)fluorene-2,12-diyl,

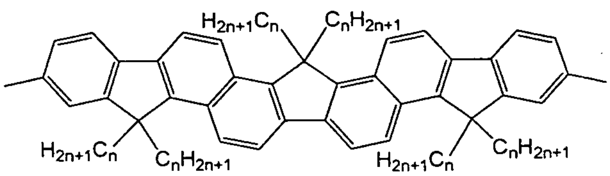

5,5,10,10,17,17-hexaalkyl-5,10,17-trihydro-difluoreno[2,1-a:1',2'-i]fluorene-3,12-diyl.

Exemplary compounds of demonstrating this aspect of the invention include

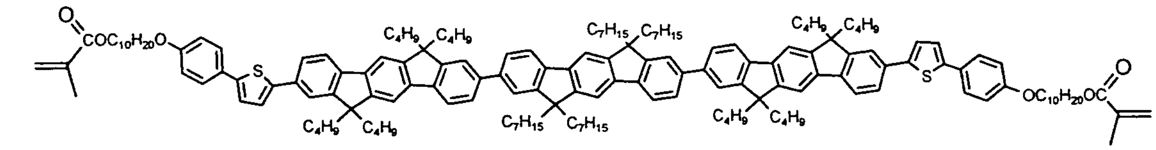

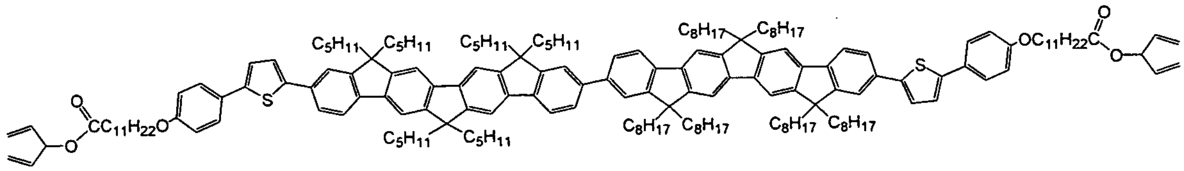

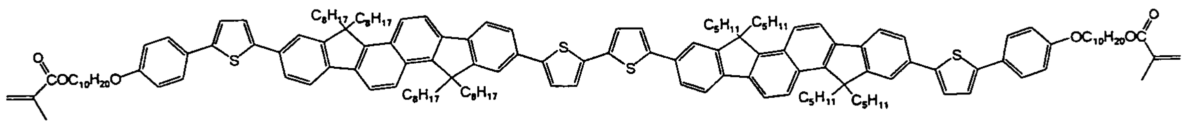

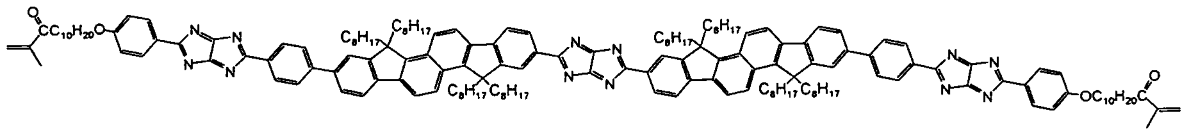

Additionally, the substitution of alkyl groups on the fused aromatic ring diradicals containing two or more fluorene-like structures results in other advantageous materials or features. For example, the alkyl substituents can help to spoil the through conjugation therefore shifting the luminescent emission to the blue. In addition alkyl substituents can be used as blocking substituents on synthetic intermediates to direct ring closure reactions so as to yield linear molecular backbones in the materials.

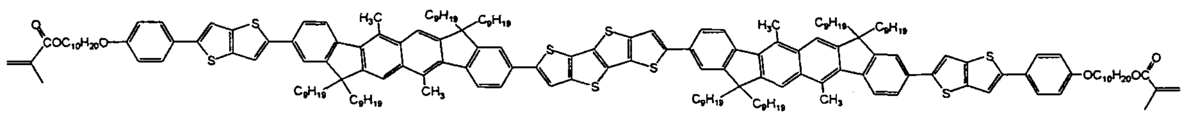

In addition nitrogen atoms may be substituted for carbons in the fused aromatic ring diradicals containing two or more fluorene-like structures. The nitrogen substitution is particularly useful in electron transporting materials. An example is the material

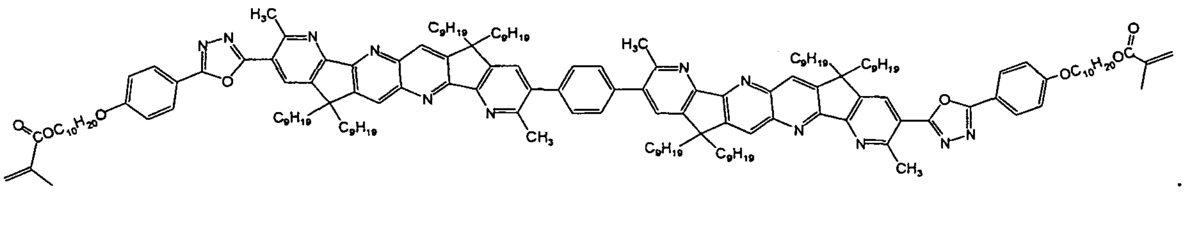

The use of mixtures of monomer materials in which photoinitiated electron donor-acceptor interactions as opposed to ionic or free radical intitiation are used to initiate polymerization may result in much higher material stability than in methacrylate-based materials, while at the same time maintaining low UV crosslinking fluences. In these mixtures at least one of the reactive mesogen materials is substituted with electron-rich crosslinking groups while at least one other component reactive mesogen material is substituted with electron-deficient crosslinking groups. Ultraviolet radiation incident on the material promotes the electron-deficient crosslinking groups on some reactive mesogen molecules into electronically excited states. The excited state, electron-deficient crosslinking groups then abstract protons from the electron-rich (electron donor) crosslinking groups on other reactive mesogen molecules initiating the copolymerization

crosslinking reaction. Descriptions of this mode of photopolymerization may be found in, for example, "Photoinitiated radical polymerization of vinyl ether-maleate systems", Polymer 38, (9) pp. 2229-37 (1997); and "Co-Polymerization of Maleimides and Vinyl Ethers: A Structural Study", Macromolecules 1998, (31) pp. 5681- 89.

Electron-deficient crosslinking groups include maleimides, maleates, fumarates, and other unsaturated esters. Electron donor groups include vinyl ethers, 1-propenyl ethers and other similar alkenyl ethers. Mixtures like these are advantageous in that the individual components are thermally and photochemically stable with excellent shelf-lives. However, when the materials are combined, the mixture has high photochemical sensitivity and requires only a relatively small UV dose for crosslinking. Examples of reactive mesogen mixtures containing both electron-deficient and electron donor crosslinking groups are

Example 1:

50 mole percent

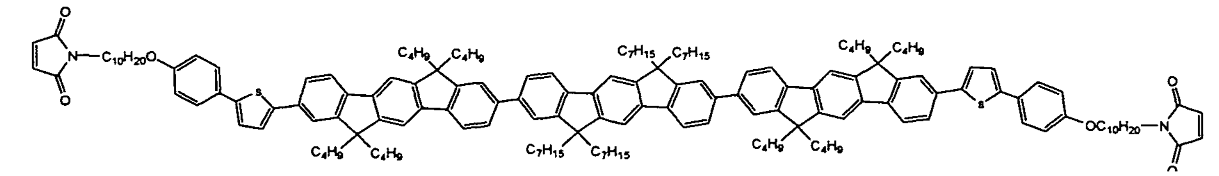

plus 50 mole percent

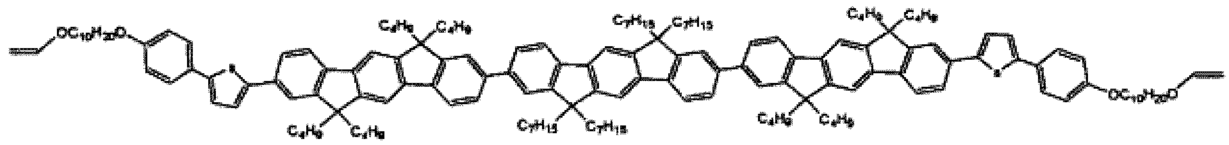

Example 2 (not a claimed embodiment): 50 mole percent

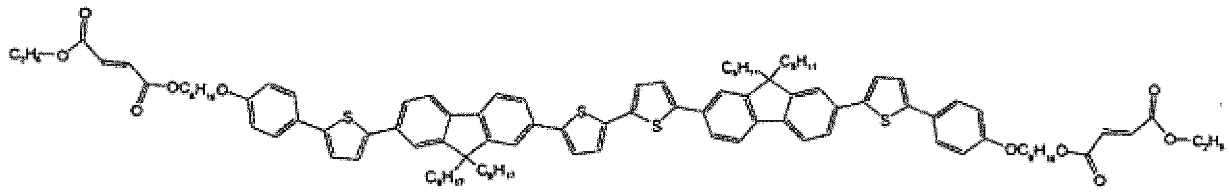

plus 50 mole percent

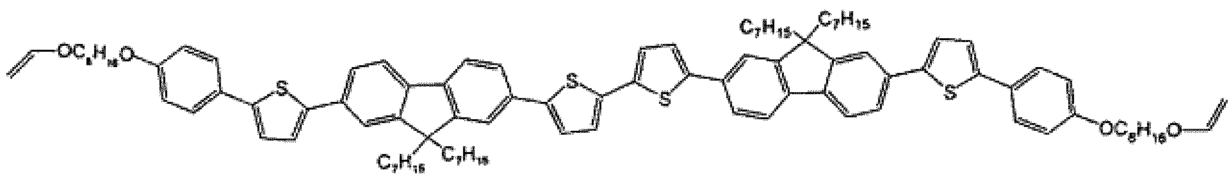

Example 3 (not a claimed embodiment) :

50 mole percent

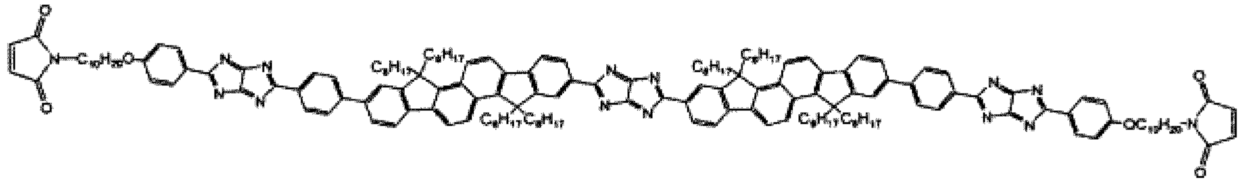

plus 50 mole percent

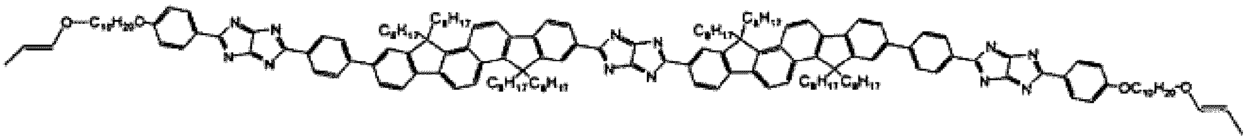

The electron donating and accepting crosslinking groups may also occur in the same molecule, for example,

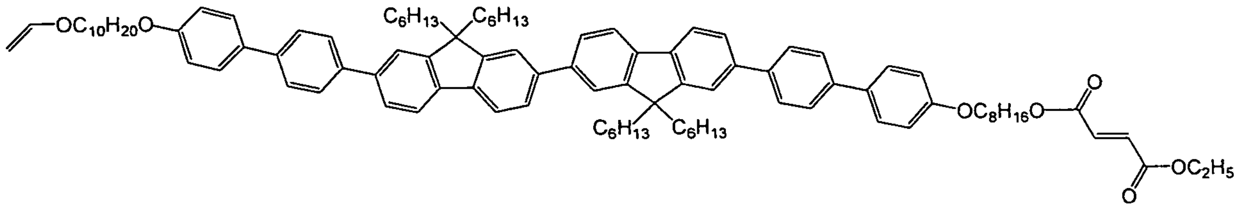

or

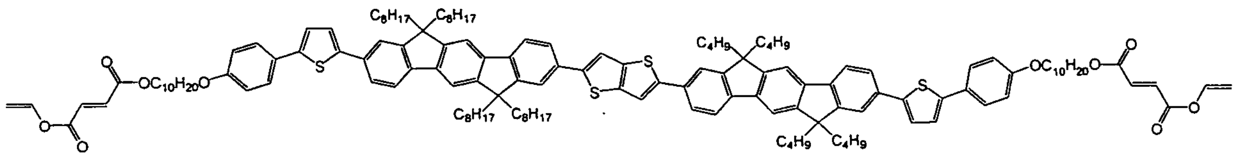

In the second example shown the electron deficient fumarate functions and the electron donating vinyloxy functions occur in the same substituents. Combined electron donating / accepting substituents of this type include:

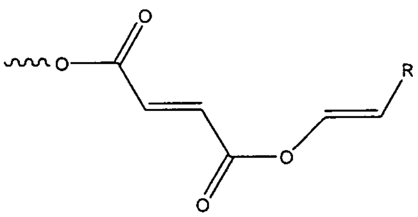

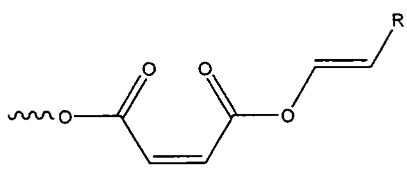

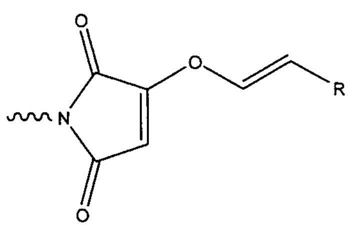

Other advantageous materials may be formed with the use of nitrogen containing fused ring diradicals such as:

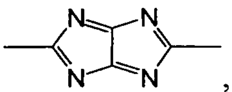, 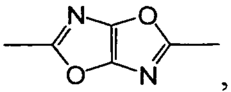, 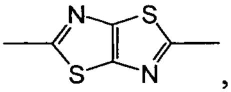, 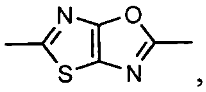, 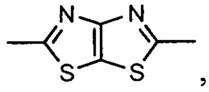,

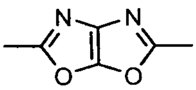, and 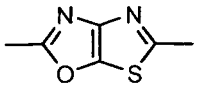.

in the aromatic molecular core of the reactive mesogen molecules discussed above. Fused ring diradicals of these types are advantageous in that their inclusion in the molecular cores can considerably enhance the charge transporting properties of the organic szemiconductors.

An exemplary material for use in forming charge transporting or light emitting polymers may be obtained by polymerizing a mixture of at least two polymerizable components to form a polymer. For example, at least one of the two components includes molecules of the general formula (nor forming part of the invention):

$$Ae\{S\text{-}B_e)_n,$$

and at least another one of the at least two components includes molecules of the general formula:

$$A_d\{S\text{-}B_d)_m$$

wherein

$A_e$ is a substantially aromatic molecular nucleus;
$B_e$ is an independently selected crosslinking group;
$A_d$ is a substantially aromatic molecular nucleus;
$B_d$ is an independently selected crosslinking group;
S is independently selected flexible spacer;
n is from 1 to 20;
m is from 1 to 20.

The polymerization of the mixture is initiated by electron transfer from $B_e$ groups to $B_d$ groups and may be photopolymerization. The resultant polymer or mixture may be an electroluminescent material. The polymer or mixture may be used in electrical or optical applications including but not limited to field effect transistors, photovoltaic devices, luminescent applications and other devices.

The material, either as a mixture or as a polymer, may exhibit a thermotropic or monotropic liquid crystalline structure. For example, thermotropic or monotropic liquid crystalline structure may be a calamitic structure, a nematic structure, or a discotic structure.

Various crosslinking groups may be used. For example, the crosslinking group $B_e$ may be a vinyl ether group while the crosslinking group $B_d$ may be a maleimide group, a maleate group, or a fumarate group.

Similarly, various substantially aromatic molecular nuclei may be used. For example, the substantially aromatic molecular nuclei, $A_e$ or $A_d$, may be organometallic in nature or may have one of the following structures.

Aromatic Molecular Nuclei Formulation 1.1:

$$-(Ar\text{-}F)_n\text{-}Ar\text{-}$$

wherein

Ar is independently selected from an aromatic diradical, a heteroaromatic diradical bonded linearly or substantially linearly to adjoining diradicals, or a single bond;
F is an independently selected diradical having the structure:

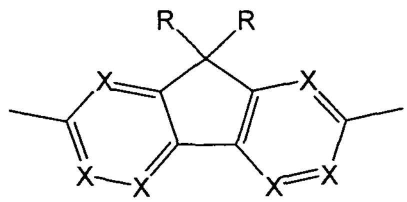

wherein X is independently selected from N, CH, or $CR_1$ where $R_1$ is independently selected from hydrocarbyl groups, $C_jH_{2j+1}$, branched hydrocarbyl groups, or hydrocarbyl groups with one or more heteroatoms of S, N, O, P, or Si with j = 1 to 6; and
R is independently selected from hydrocarbyl groups, $C_mH_{2m+1}$, branched hydrocarbyl groups, or hydrocarbyl groups with one or more heteroatoms of S, N, O, P, or Si, with m = 1 to 15, and

the Ar and F diradicals are independently selected in each of the n subunits of the chromophore; and
$1 \leq n \leq 10$.

Aromatic Molecular Nuclei Formulation 1.2:

$-(Ar-D)_n-Ar-$

wherein

Ar is independently selected from an aromatic diradical, a heteroaromatic diradical bonded linearly or substantially linearly to adjoining diradicals, or a single bond;
D is a diradical having the structure:

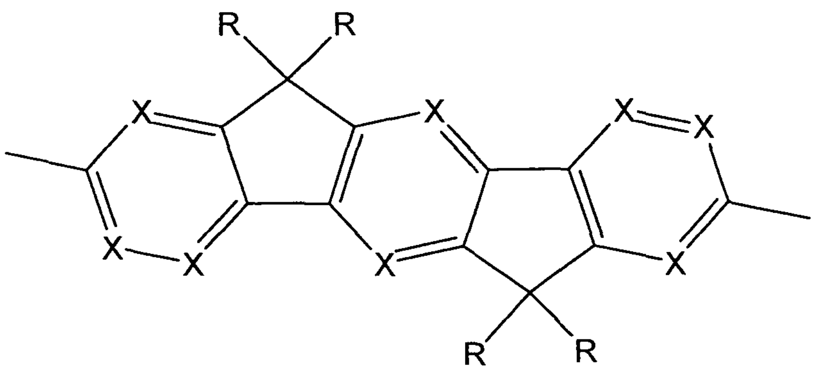

wherein

X is independently selected from N, CH, or $CR_1$ where $R_1$ is independently selected from hydrocarbyl groups, $C_jH_{2j+1}$, branched hydrocarbyl groups, or hydrocarbyl groups with one or more heteroatoms of S, N, O, P, or Si with j = 1 to 6; and
R is independently selected from hydrocarbyl groups, $C_mH_{2m+1}$, branched hydrocarbyl groups, or hydrocarbyl groups with one or more heteroatoms of S, N, O, P, or Si, with m = 1 to 15, and

the Ar and D diradicals are independently selected in each of the n subunits of the chromophore; and
n = 1 to 6.

Aromatic Molecular Nuclei Formulation 1.3:

$-(Ar-T)_n-Ar-$

wherein

Ar is independently selected from an aromatic diradical, a heteroaromatic diradical bonded linearly or substantially

linearly to adjoining diradicals, or a single bond;
T is a diradical having the structure:

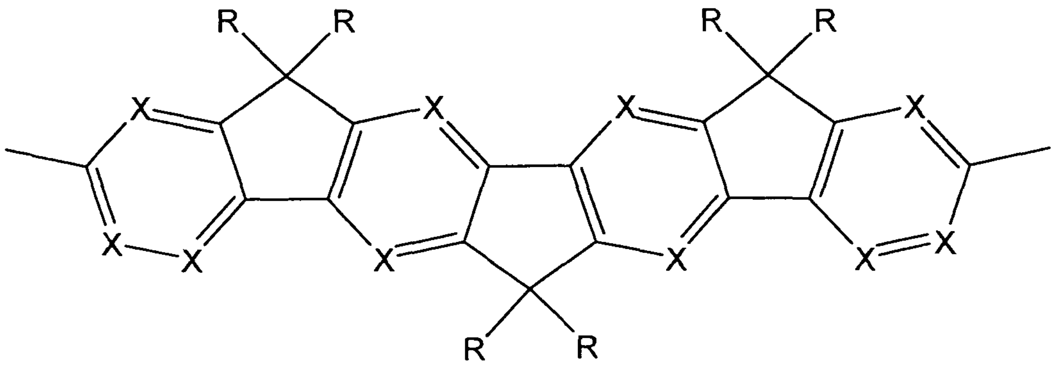

wherein

X is independently selected from N, CH, or $CR_1$ where $R_1$ is independently selected from hydrocarbyl groups, $C_jH_{2j+1}$, branched hydrocarbyl groups, or hydrocarbyl groups with one or more heteroatoms of S, N, O, P, or Si with j = 1 to 6;
R is independently selected from hydrocarbyl groups, $C_mH_{2m+1}$, branched hydrocarbyl groups, or hydrocarbyl groups with one or more heteroatoms of S, N, O, P, or Si with m = 1 to 15, and

n = 1 to 4,
wherein the Ar and T diradicals are independently selected in each of the n subunits of the chromophore.

Aromatic Molecular Nuclei Formulation 1.4:

$$-(Ar-Q)_n-Ar-$$

wherein

Ar is independently selected from an aromatic diradical, a heteroaromatic diradical bonded linearly or substantially linearly to adjoining diradicals, or a single bond;
Q is a diradical having the structure:

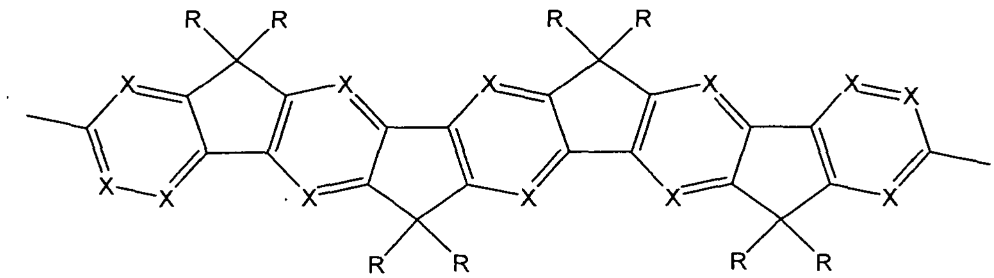

wherein

X is independently selected from N, CH, or $CR_1$ where $R_1$ is independently selected from hydrocarbyl groups, $C_jH_{2j+1}$, branched hydrocarbyl groups, or hydrocarbyl groups with one or more heteroatoms of S, N, O, P, or Si with j = 1 to 6; and
R is independently selected from hydrocarbyl groups, $C_mH_{2m+1}$, branched hydrocarbyl groups, or hydrocarbyl groups with one or more heteroatoms of S, N, O, P, or Si with m = 1 to 15, and

n = 1 to 4,
wherein the Ar and Q diradicals are independently selected in each of the n subunits of the chromophore.

Aromatic Molecular Nuclei Formulation 1.5:

-(Ar-N)$_n$-Ar-

wherein

Ar is independently selected form an aromatic diradical, a heteroaromatic diradical bonded linearly or substantially linearly to adjoining diradicals, or a single bond;
N is a diradical having the structure:

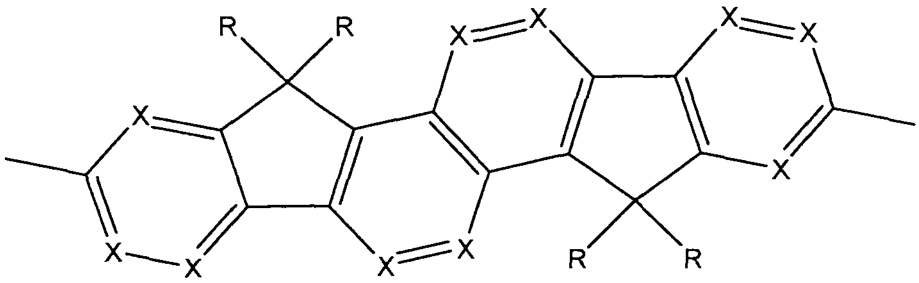

wherein

X is independently selected from N, CH, or $CR_1$ where $R_1$ is independently selected from hydrocarbyl groups, $C_jH_{2j+1}$, branched hydrocarbyl groups, or hydrocarbyl groups with one or more heteroatoms of S, N, O, P, or Si with j = 1 to 6; and
R is independently selected from hydrocarbyl groups, $C_mH_{2m+1}$, branched hydrocarbyl groups, or hydrocarbyl groups with one or more heteroatoms of S, N, O, P, or Si with m = 1 to 15, and

n = 1 to 6,
wherein the Ar and N diradicals are independently selected in each of the n subunits of the chromophore.

Aromatic Molecular Nuclei Formulation 1.6:

-(Ar-L)$_n$-Ar-

wherein

Ar is independently selected from an aromatic diradical, a heteroaromatic diradical bonded linearly or substantially linearly to adjoining diradicals, or a single bond;
L is a diradical having the structure:

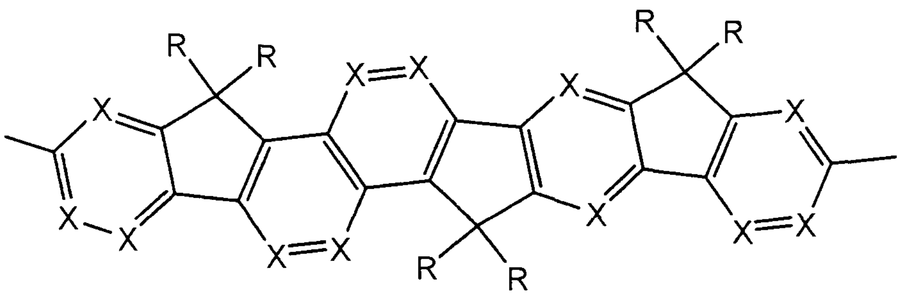

wherein

X is independently selected from N, CH, or $CR_1$ where $R_1$ is independently selected from hydrocarbyl groups, $C_jH_{2j+1}$, branched hydrocarbyl groups, or hydrocarbyl groups with one or more heteroatoms of S, N, O, P, or Si with j = 1 to 6; and
R is independently selected from hydrocarbyl groups, $C_mH_{2m+1}$, branched hydrocarbyl groups, or hydrocarbyl

groups with one or more heteroatoms of S, N, O, P, or Si with m = 1 to 15, and

n = 1 to 4,
wherein the Ar and L diradicals are independently selected in each of the n subunits of the chromophore.

Aromatic Molecular Nuclei Formulation 1.7:

$-(Ar\text{-}M)_n\text{-}Ar-$

wherein

Ar is independently selected form an aromatic diradical, a heteroaromatic diradical bonded linearly or substantially linearly to adjoining diradicals, or a single bond;
M is a diradical having the structure:

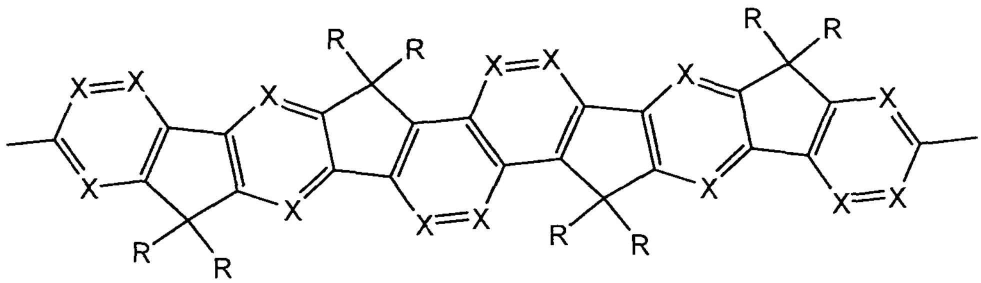

wherein

X is independently selected from N, CH, or $CR_1$ where $R_1$ is independently selected from hydrocarbyl groups, $C_jH_{2j+1}$, branched hydrocarbyl groups, or hydrocarbyl groups with one or more heteroatoms of S, N, O, P, or Si with j = 1 to 6; and
R is independently selected from hydrocarbyl groups, $C_mH_{2m+1}$, branched hydrocarbyl groups, or hydrocarbyl groups with one or more heteroatoms of S, N, O, P, or Si with m = 1 to 15, and

n = 1 to 4,
wherein the Ar and M diradicals are independently selected in each of the n subunits of the chromophore.

Aromatic Molecular Nuclei Formulation 1.8:

$-(Ar\text{-}G)_n\text{-}Ar-$

wherein

Ar is independently selected from an aromatic diradical, a heteroaromatic diradical bonded linearly or substantially linearly to adjoining diradicals, or a single bond;
G is a diradical having the structure:

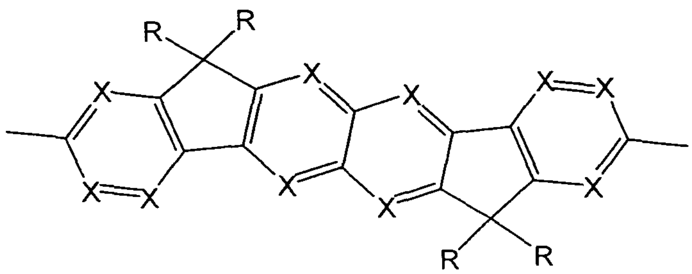

wherein

X is independently selected from N, CH, or $CR_1$ where $R_1$ is independently selected from hydrocarbyl groups, $C_jH_{2j+1}$, branched hydrocarbyl groups, or hydrocarbyl groups with one or more heteroatoms of S, N, O, P, or Si with j = 1 to 6; and
R is independently selected from hydrocarbyl groups, $C_mH_{2m+1}$, branched hydrocarbyl groups, or hydrocarbyl groups with one or more heteroatoms of S, N, O, P, or Si with m = 1 to 15, and

n = 1 to 6,
wherein the Ar and G diradicals are independently selected in each of the n subunits of the chromophore.

Aromatic Molecular Nuclei Formulation 1.9:

$$-(Ar\text{-}S')_n\text{-}Ar-$$

wherein

Ar is independently selected from an aromatic diradical, a heteroaromatic diradical bonded linearly or substantially linearly to adjoining diradicals, or a single bond;
S' is a diradical having the structure:

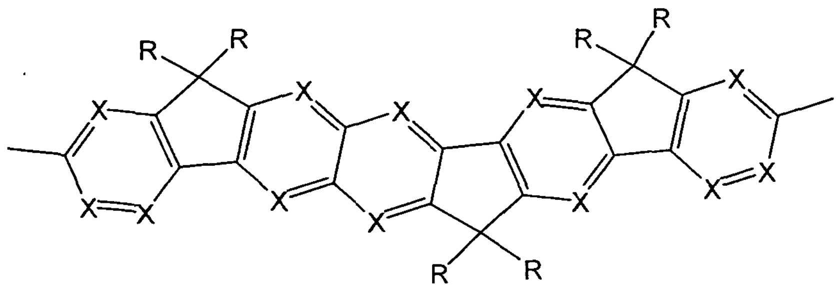

wherein

X is independently selected from N, CH, or $CR_1$ where $R_1$ is independently selected from hydrocarbyl groups, $C_jH_{2j+1}$, branched hydrocarbyl groups, or hydrocarbyl groups with one or more heteroatoms of S, N, O, P, or Si with j = 1 to 6; and
R is independently selected from hydrocarbyl groups, $C_mH_{2m+1}$, branched hydrocarbyl groups, or hydrocarbyl groups with one or more heteroatoms of S, N, O, P, or Si with m = 1 to 15, and

n = 1 to 4,
wherein the Ar and S' diradicals are independently selected in each of the n subunits of the chromophore.

Aromatic Molecular Nuclei Formulation 1.10:

$$-(Ar\text{-}U)_n\text{-}Ar-$$

wherein

Ar is independently selected from an aromatic diradical, a heteroaromatic diradical bonded linearly or substantially linearly to adjoining diradicals, or a single bond;
U is a diradical having the structure:

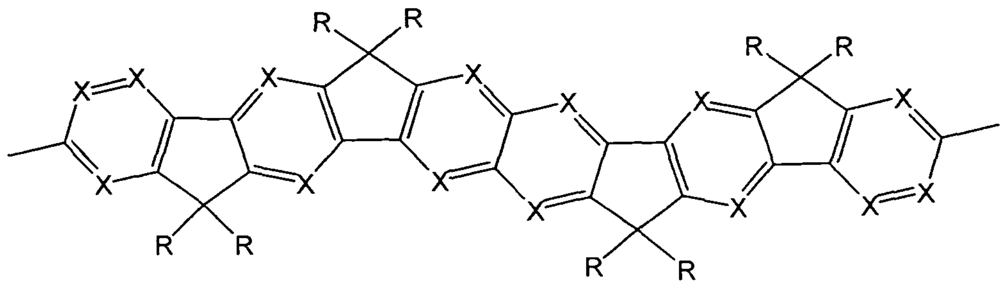

wherein

X is independently selected from N, CH, or $CR_1$ where $R_1$ is independently selected from hydrocarbyl groups, $C_jH_{2j+1}$, branched hydrocarbyl groups, or hydrocarbyl groups with one or more heteroatoms of S, N, O, P, or Si with j = 1 to 6; and
R is independently selected from hydrocarbyl groups, $C_mH_{2m+1}$, branched hydrocarbyl groups, or hydrocarbyl groups with one or more heteroatoms of S, N, O, P, or Si with m = 1 to 15, and

n = 1 to 4,
wherein the Ar and U diradicals are independently selected in each of the n subunits of the chromophore.

Aromatic Molecular Nuclei Formulation 1.11:

$-(Ar-V)_n-Ar-$

wherein

Ar is independently selected from an aromatic diradical, a heteroaromatic diradical bonded linearly or substantially linearly to adjoining diradicals, or a single bond;
V is a diradical having the structure:

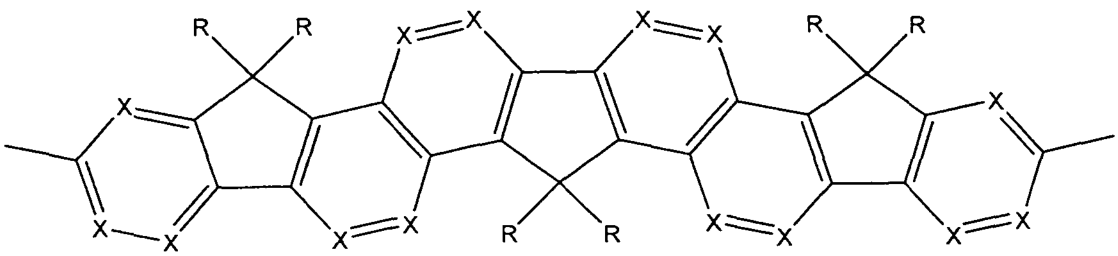

wherein

X is independently selected from N, CH, or $CR_1$ where $R_1$ is independently selected from hydrocarbyl groups, $C_jH_{2j+1}$, branched hydrocarbyl groups, or hydrocarbyl groups with one or more heteroatoms of S, N, O, P, or Si with j = 1 to 6; and
R is independently selected from hydrocarbyl groups, $C_mH_{2m+1}$, branched hydrocarbyl groups, or hydrocarbyl groups with one or more heteroatoms of S, N, O, P, or Si with m = 1 to 15, and

n = 1 to 4,
wherein the Ar and V diradicals are independently selected in each of the n subunits of the chromophore.

Another exemplary material for use in forming charge transporting or light emitting polymers may be obtained by polymerizing a reactive mesogen having the molecular structure B-S-A-S-B to form a polymer where B is a crosslinkable end group, S is a flexible spacer, and A is a substantially aromatic molecular nucleus. The resultant polymer or the reactive mesogen may be an electroluminescent material. The polymer or the reactive mesogen may be used in electrical or optical applications including but not limited to field effect transistors, photovoltaic devices, luminescent applications, phosphorescent applications and other devices.

The material, either as a reactive mesogen or as a polymer, may exhibit a thermotropic or monotropic liquid crystalline structure. For example, thermotropic or monotropic liquid crystalline structure may be a calamitic structure, a nematic structure, or a discotic structure.

Various cross linking groups may be used. For example, the crosslinking group B may be a methacrylate such as 1,4-pentadien-3-yl.

Similarly, various substantially aromatic molecular nuclei may be used. For example, the substantially aromatic molecular nucleus may have one or more metallic atoms chemically bonded into the aromatic molecular nucleus or may have one of the following structures.

Aromatic Molecular Nuclei Formulation 2.1:

$$-(Ar-D)_n-Ar-$$

wherein

n = 1 to 6;
Ar is an aromatic diradical, a heteroaromatic diradical bonded linearly or substantially linearly to adjoining diradicals, or a single bond;
D is a diradical having the structure:

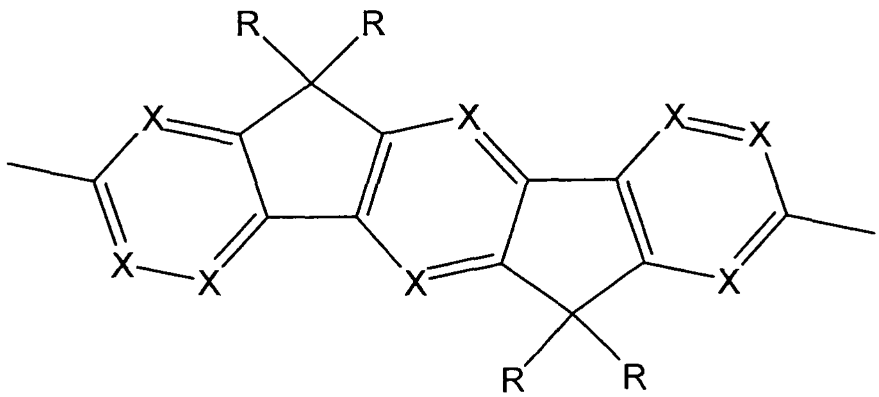

wherein

X is independently selected from N, CH, or $CR_1$ where $R_1$ is independently selected from hydrocarbyl groups, $C_jH_{2j+1}$, branched hydrocarbyl groups, or hydrocarbyl groups with one or more heteroatoms of S, N, O, P, or Si with j = 1 to 6; and
R is independently selected from hydrocarbyl groups, $C_mH_{2m+1}$, branched hydrocarbyl groups, or hydrocarbyl groups with one or more heteroatoms of S, N, O, P, or Si, with m = 1 to 15, and

the Ar and D diradicals are independently selected in each of the n subunits of the chromophore.

Aromatic Molecular Nuclei Formulation 2.2:

$$-(Ar-T)_n-Ar-$$

wherein

n = 1 to 4;
Ar is an aromatic diradical, a heteroaromatic diradical bonded linearly or substantially linearly to adjoining diradicals, or a single bond;
T is a diradical having the structure

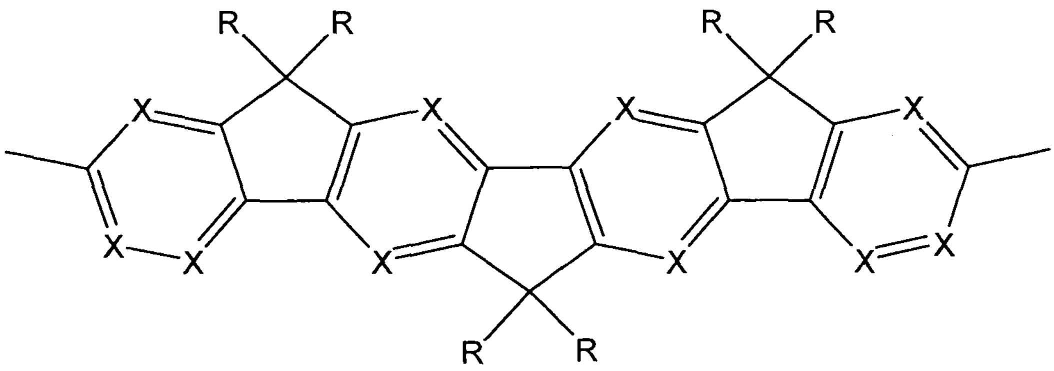

wherein

X is independently selected from N, CH, or $CR_1$ where $R_1$ is independently selected from hydrocarbyl groups, $C_jH_{2j+1}$, branched hydrocarbyl groups, or hydrocarbyl groups with one or more heteroatoms of S, N, O, P, or Si with j = 1 to 6; and
R is independently selected from hydrocarbyl groups, $C_mH_{2m+1}$, branched hydrocarbyl groups, or hydrocarbyl groups with one or more heteroatoms of S, N, O, P, or Si with m = 1 to 15, and

the Ar and T diradicals are independently selected in each of the n subunits of the chromophore.

Aromatic Molecular Nuclei Formulation 2.3:

$-(Ar-Q)_{n-}Ar-$

wherein

n = 1 to 4;
Ar is an aromatic diradical, a heteroaromatic diradical bonded linearly or substantially linearly to adjoining diradicals, or a single bond;
Q is a diradical having the structure

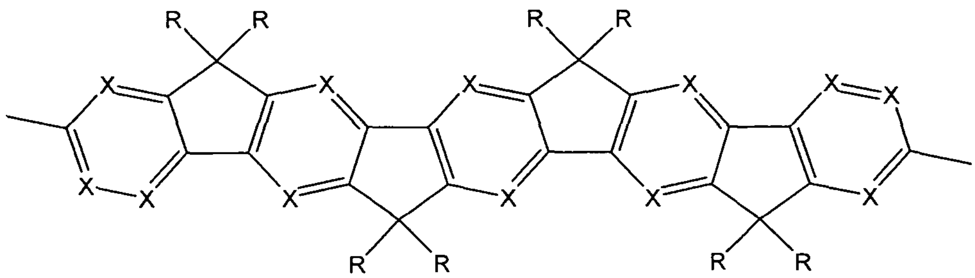

wherein

X is independently selected from N, CH, or $RC_1$ where $R_1$ is independently selected from hydrocarbyl groups, $C_jH_{2j+1}$, branched hydrocarbyl groups, or hydrocarbyl groups with one or more heteroatoms of S, N, O, P, or Si with j = 1 to 6; and
R is independently selected from hydrocarbyl groups, $C_mH_{2m+1}$, branched hydrocarbyl groups, or hydrocarbyl groups with one or more heteroatoms of S, N, O, P, or Si with m = 1 to 15, and

the Ar and Q diradicals are independently selected in each of the n subunits of the chromophore.

Aromatic Molecular Nuclei Formulation 2.4:

$-(Ar-N)_n-Ar-$

wherein

n = 1 to 6;
Ar is an aromatic diradical, a heteroaromatic diradical bonded linearly or substantially linearly to adjoining diradicals, or a single bond;
N is a diradical having the structure

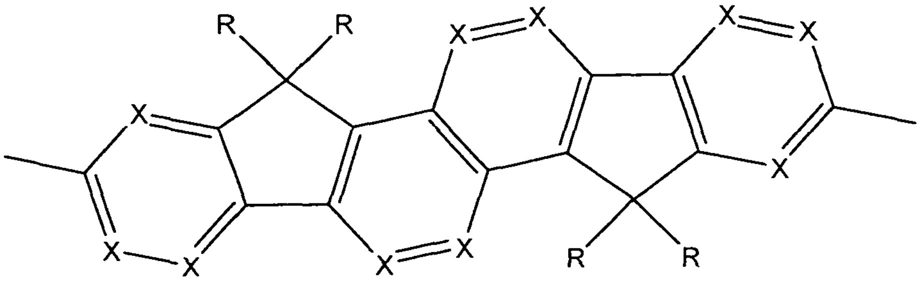

wherein

X is independently selected from N, CH, or $CR_1$ where $R_1$ is independently selected from hydrocarbyl groups, $C_jH_{2j+1}$, branched hydrocarbyl groups, or hydrocarbyl groups with one or more heteroatoms of S, N, O, P, or Si with j = 1 to 6, and
R is independently selected from hydrocarbyl groups, $C_mH_{2m+1}$, branched hydrocarbyl groups, or hydrocarbyl groups with one or more heteroatoms of S, N, O, P, or Si with m = 1 to 15, and

the Ar and N diradicals are independently selected in each of the n subunits of the chromophore.

Aromatic Molecular Nuclei Formulation 2.5:

$$-(Ar-L)_n-Ar-$$

wherein

n = 1 to 4;
Ar is an aromatic diradical, a heteroaromatic diradical bonded linearly or substantially linearly to adjoining diradicals, or a single bond;
L is a diradical having the structure

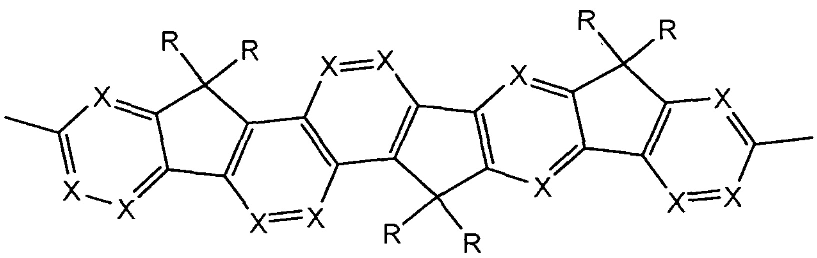

wherein

X is independently selected from N, CH, or $CR_1$ where $R_1$ is independently selected from hydrocarbyl groups, $C_jH_{2j+1}$, branched hydrocarbyl groups, or hydrocarbyl groups with one or more heteroatoms of S, N, O, P, or Si with j = 1 to 6; and
R is independently selected from hydrocarbyl groups, $C_mH_{2m+1}$, branched hydrocarbyl groups, or hydrocarbyl groups with one or more heteroatoms of S, N, O, P, or Si with m = 1 to 15, and

the Ar and L diradicals are independently selected in each of the n subunits of the chromophore.

Aromatic Molecular Nuclei Formulation 2.6:

$$-(Ar-M)_n-Ar-$$

wherein

n = 1 to 4;
Ar is an aromatic diradical, a heteroaromatic diradical bonded linearly or substantially linearly to adjoining diradicals, or a single bond;
M is a diradical having the structure

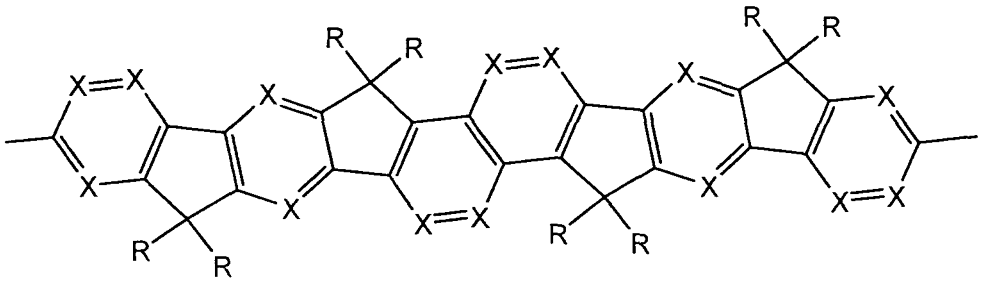

wherein

X is independently selected from N, CH, or $CR_1$ where $R_1$ is independently selected from hydrocarbyl groups, $C_jH_{2j+1}$, branched hydrocarbyl groups, or hydrocarbyl groups with one or more heteroatoms of S, N, O, P, or Si with j = 1 to 6; and
R is independently selected from hydrocarbyl groups, $C_mH_{2m+1}$, branched hydrocarbyl groups, or hydrocarbyl groups with one or more heteroatoms of S, N, O, P, or Si with m = 1 to 15, and

the Ar and M diradicals are independently selected in each of the n subunits of the chromophore.

Aromatic Molecular Nuclei Formulation 2.7:

$$-(Ar-G)_{n-}Ar-$$

wherein

n = 1 to 6;
Ar is an aromatic diradical, a heteroaromatic diradical bonded linearly or substantially linearly to adjoining diradicals, or a single bond;
G is a diradical having the structure

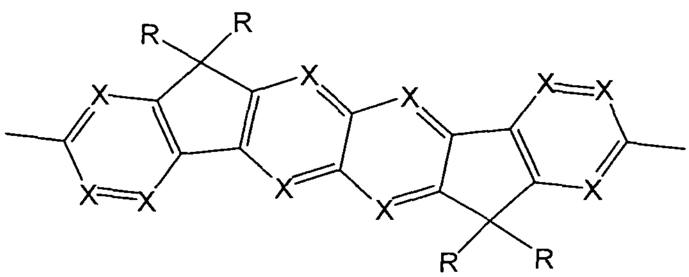

wherein

X is independently selected from N, CH, or $CR_1$ where $R_1$ is independently selected from hydrocarbyl groups, $C_jH_{2j+1}$, branched hydrocarbyl groups, or hydrocarbyl groups with one or more heteroatoms of S, N, O, P, or Si with j = 1 to 6; and
R is independently selected from hydrocarbyl groups, $C_mH_{2m+1}$, branched hydrocarbyl groups, or hydrocarbyl

groups with one or more heteroatoms of S, N, O, P, or Si with m = 1 to 15, and

the Ar and G diradicals are independently selected in each of the n subunits of the chromophore.

Aromatic Molecular Nuclei Formulation 2.8:

-(Ar-S')$_n$-Ar-

wherein

n = 1 to 4;
Ar is an aromatic diradical, a heteroaromatic diradical bonded linearly or substantially linearly to adjoining diradicals, or a single bond;
S' is a diradical having the structure

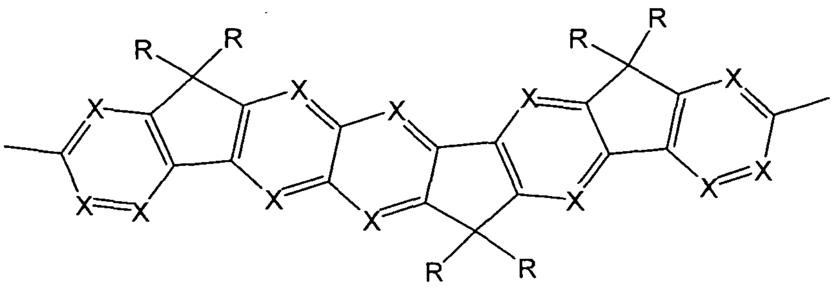

wherein

X is independently selected from N, CH, or $CR_1$ where $R_1$ is independently selected from hydrocarbyl groups, $C_jH_{2j+1}$, branched hydrocarbyl groups, or hydrocarbyl groups with one or more heteroatoms of S, N, O, P, or Si with j = 1 to 6; and
R is independently selected from hydrocarbyl groups, $C_mH_{2m+1}$, branched hydrocarbyl groups, or hydrocarbyl groups with one or more heteroatoms of S, N, O, P, or Si with m = 1 to 15, and

the Ar and S' diradicals are independently selected in each of the n subunits of the chromophore.

Aromatic Molecular Nuclei Formulation 2.9:

-(Ar-U)$_n$-Ar-

wherein

n = 1 to 4;
Ar is an aromatic diradical, a heteroaromatic diradical bonded linearly or substantially linearly to adjoining diradicals, or a single bond;
U is a diradical having the structure

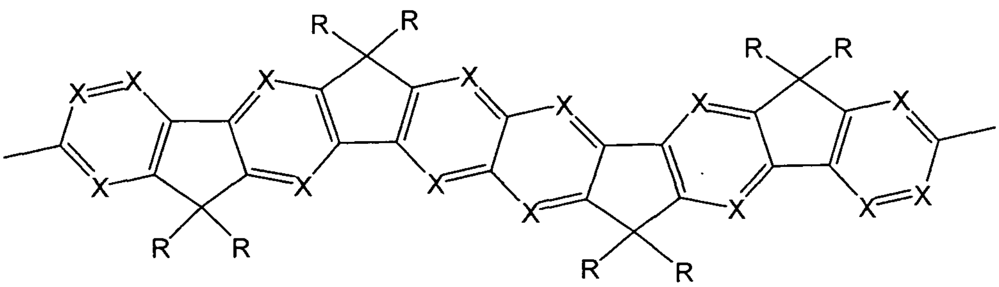

wherein

X is independently selected from N, CH, or $CR_1$ where $R_1$ is independently selected from hydrocarbyl groups, $C_jH_{2j+1}$, branched hydrocarbyl groups, or hydrocarbyl groups with one or more heteroatoms of S, N, O, P, or Si with j = 1 to 6; and

R is independently selected from hydrocarbyl groups, $C_mH_{2m+1}$, branched hydrocarbyl groups, or hydrocarbyl groups with one or more heteroatoms of S, N, O, P, or Si with m = 1 to 15, and

the Ar and U diradicals are independently selected in each of the n subunits of the chromophore.

Aromatic Molecular Nuclei Formulation 2.10:

$$-(Ar-V)_n-Ar-$$

wherein

n = 1 to 4;

Ar is an aromatic diradical, a heteroaromatic diradical bonded linearly or substantially linearly to adjoining diradicals, or a single bond;

V is a diradical having the structure

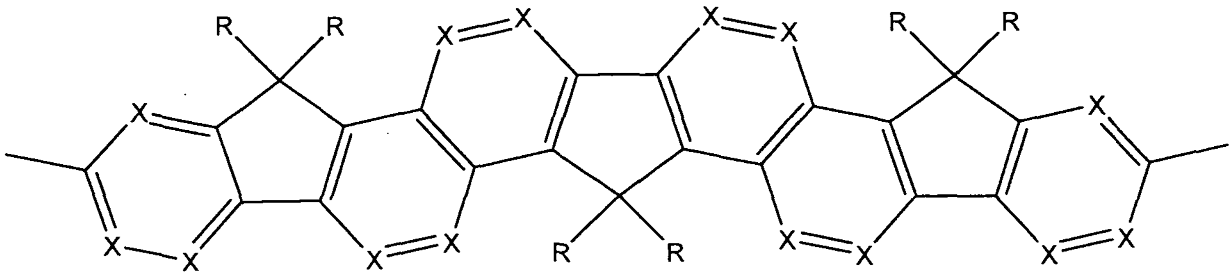

wherein

X is independently selected from N, CH, or $CR_1$ where $R_1$ is independently selected from hydrocarbyl groups, $C_jH_{2j+1}$, branched hydrocarbyl groups, or hydrocarbyl groups with one or more heteroatoms of S, N, O, P, or Si with j = 1 to 6; and

R is independently selected from hydrocarbyl groups, $C_mH_{2m+1}$, branched hydrocarbyl groups, or hydrocarbyl groups with one or more heteroatoms of S, N, O, P, or Si with m = 1 to 15, and

the Ar and V diradicals are independently selected in each of the n subunits of the chromophore.

Another exemplary material (not forming part of the invention) : for use in forming charge transporting or light emitting polymers may be obtained by polymerizing a reactive mesogen having the molecular structure B-S-A-S-B to form a polymer where B is a crosslinkable end group, S is a flexible spacer, and A is a substantially aromatic molecular nucleus having the structure:

$$-(Ar-F^1)_n-Ar-$$

wherein

n = 1 to 8;

Ar is an aromatic diradical, a heteroaromatic diradical bonded linearly or substantially linearly to adjoining diradicals, or a single bond;

$F^1$ is a diradical having a structure selected from the group consisting of:

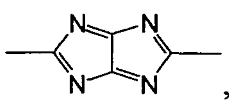 ,

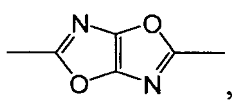 ,

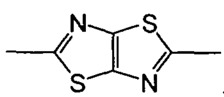 ,

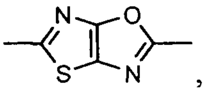, 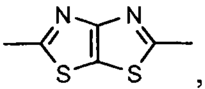, 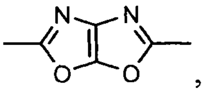, and 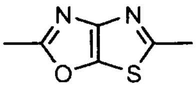.

the Ar diradicals are independently selected in each of the n subunits of the chromophore.

The resultant polymer or the reactive mesogen may be an electroluminescent material. The polymer or the reactive mesogen may be used in electrical or optical applications including but not limited to field effect transistors, photovoltaic devices, luminescent applications, phosphorescent applications and other devices.

The material, either as a reactive mesogen or as a polymer, may exhibit a thermotropic or monotropic liquid crystalline structure. For example, thermotropic or monotropic liquid crystalline structure may be a calamitic structure, a nematic structure, or a discotic structure.

Exemplary syntheses for

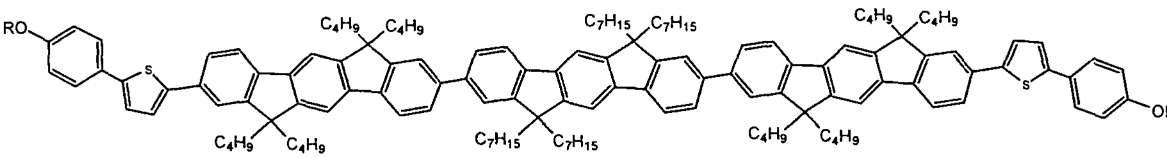;

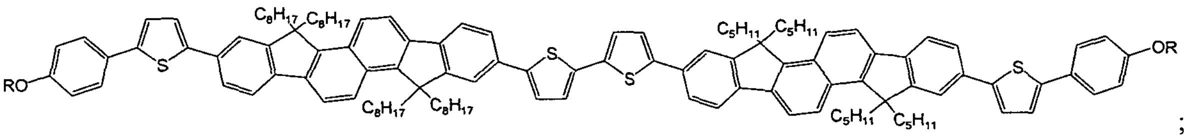;

and

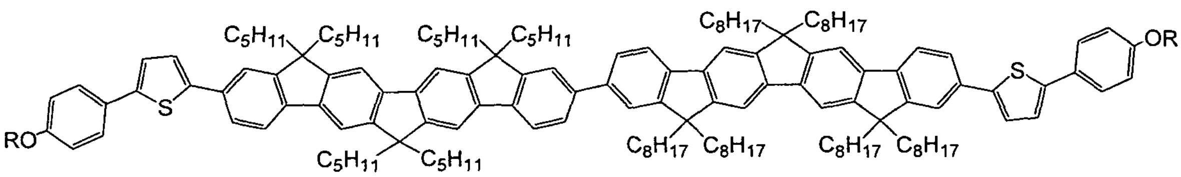

are shown in FIGs. 1 through 20. FIG. 1 through FIG. 7 is a synthesis for

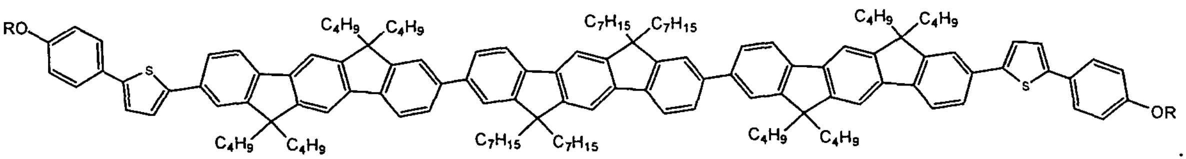.

FIG. 8 through FIG. 12 is a synthesis for

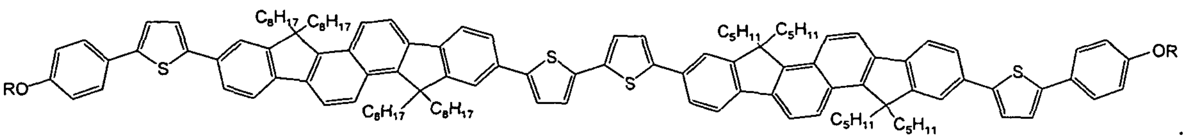.

FIG. 13 through FIG. 20 is a synthesis for

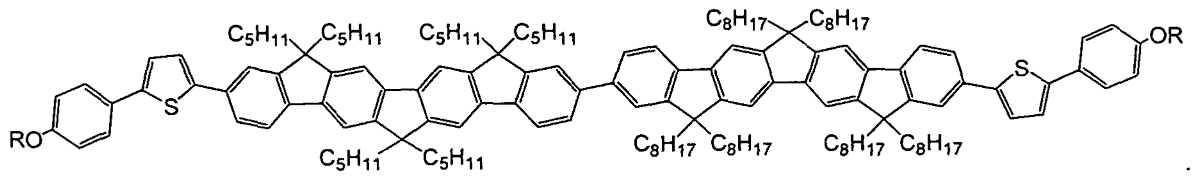

.

Another exemplary material that may be used as an organic semiconductor, organic semiconductor, charge transporting, light emitting polymers and the like includes a polymer formed by polymerization of mixture of one of more components, at least one of the one of more components having molecules of formula A-(S-B)$_n$ wherein n is from 1 to 20, A is a substantially aromatic molecular nucleus, S is a flexible spacer, and B is an independently selected crosslinking group chosen from the group consisting of:

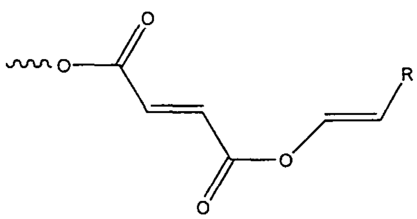
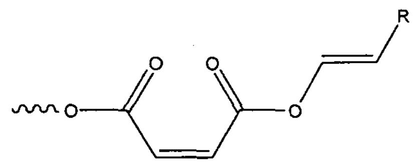
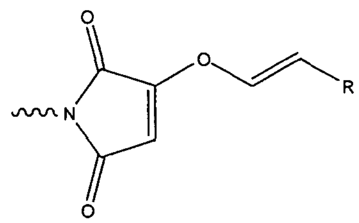

wherein R = H or alkyl. The polymer may be formed by photopolymerization and may be an electroluminescent material. The polymer may exhibit a liquid crystalline structure such as a smectic structure, a nematic structure, or a discotic structure. The polymer may be used in field effect transistors, photovoltaic devices, luminescent applications and in any other suitable applications. One or more of the substantially aromatic molecular nuclei, A, may be organometallic in nature. The one or more components include at least one the above polymerizable materials and may include any other suitable polymerizable materials or any other suitable component.

Another exemplary material that may be used as an organic semiconductor, charge transporting or light emitting polymer and the like includes a polymer with calamitic liquid crystalline structure formed by polymerization of one of more components, at least one of the one of more components has molecules of formula B-S-A-S-B wherein A is a substantially aromatic molecular nucleus, S is a flexible spacer, and B is an independently selected crosslinking group chosen from the group consisting of

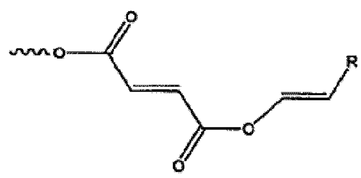
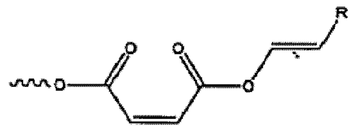
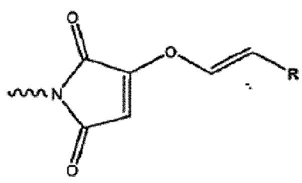

wherein R = H or alkyl. The polymer may be formed by photopolymerization and may be an electroluminescent material. The mixture forms a polymer upon polymerization that may exhibit a liquid crystalline structure such as a monotropic or thermotropic calamitic liquid crystalline phase. The polymer may be used in field effect transistors, photovoltaic devices, luminescent applications and in any other suitable applications. One or more of the substantially aromatic molecular nuclei, A, may be organometallic in nature. The components of the mixture include at least one of the above polymerizable materials and may include any other suitable polymerizable materials.

One advantageous subset of the above polymerizable materials is reactive mesogen materials.

## Claims

1. A material for use in forming organic semiconductor, charge transporting or light emitting polymers comprising: a photopolymerizable material having the molecular structure

B-S-A-S-B,

**characterised in that**

B is a crosslinkable end group;
S is a flexible spacer; and
A is an aromatic molecular nucleus having the structure

$$-(Ar-D)_{n}-Ar-$$

wherein

n = 1 to 6;
Ar is an aromatic diradical, a heteroaromatic diradical bonded linearly to adjoining diradicals, or a single bond; wherein
D are each independently chosen from the group:

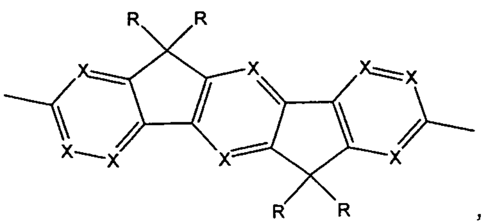
,
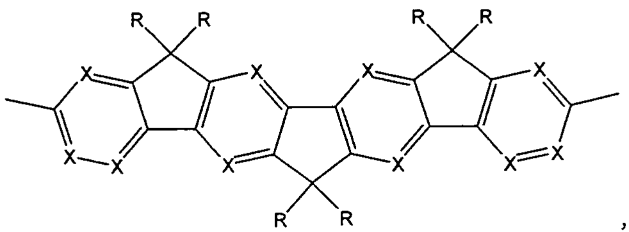
,
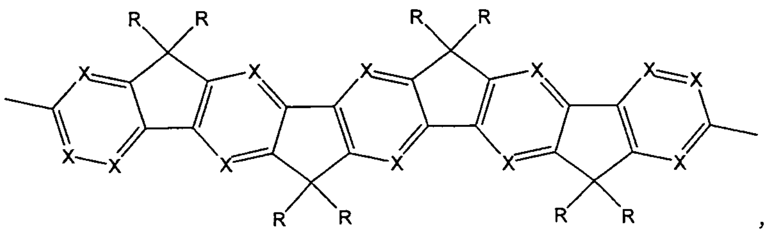
,
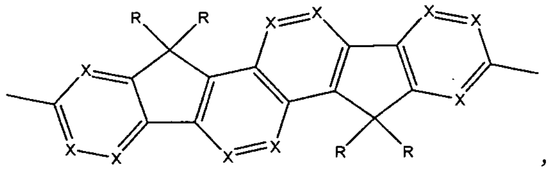
,
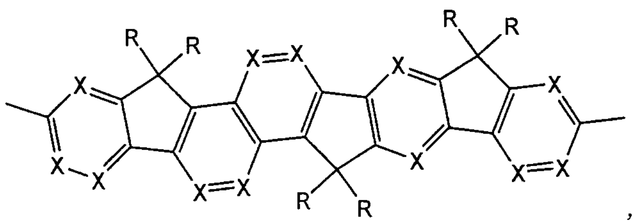
,
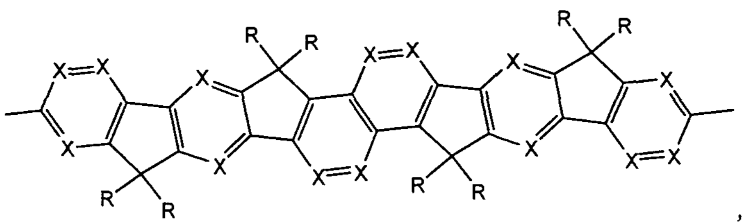
,

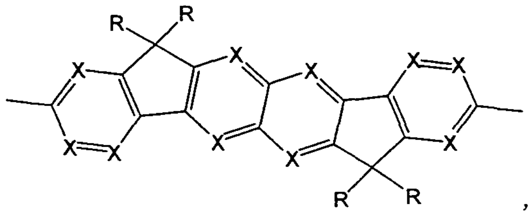

,

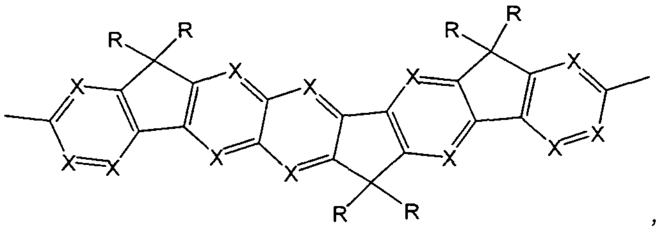

,

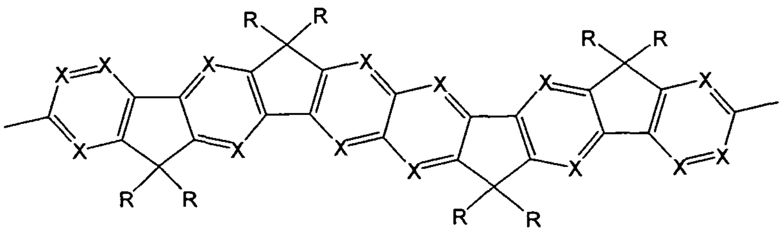

,

or

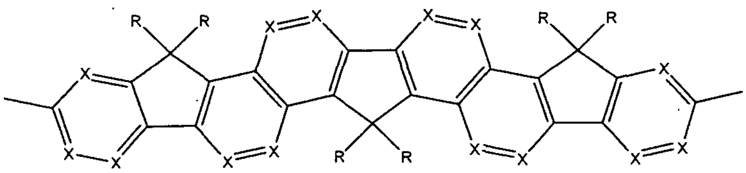

and wherein

X is independently selected from N, CH, or $CR_1$ where $R_1$ is independently selected from hydrocarbyl groups, $C_jH_{2j+1}$, branched hydrocarbyl groups, or hydrocarbyl groups with one or more heteroatoms of S, N, O, P, or Si with j = 1 to 6; and
R is independently selected from hydrocarbyl groups, $C_mH_{2m+1}$, branched hydrocarbyl groups, or hydrocarbyl groups with one or more heteroatoms of S, N, O, P, or Si, with m = 1 to 15, and
the Ar and D diradicals are independently selected in each of the n subunits of the aromatic molecular nucleus A.

2. A material according to claim 1, wherein the crosslinkable end group B is chosen from 1,4-pentadien-3-yl, methacrylato, ethacrylato, vinyloxy, alkylvinyloxy, ethoxyfumarato, ethoxymaleato, N-maleimido, vinyloxyfumarato, vinyloxymaleato, alkylvinyloxyethacrylato, alkylvinyloxyethacrylato, or N-(2-vinyloxy)maleimido.

3. A material according to claim 1 or claim 2, wherein one or more metallic atoms are chemically bonded into the aromatic molecular nucleus A.

4. A material according to any one of the preceding claims, wherein the aromatic diradical Ar is chosen from:

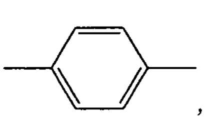 , 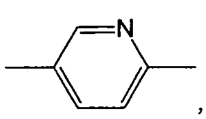 , 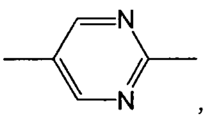 , 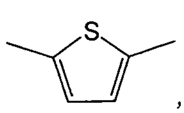 , 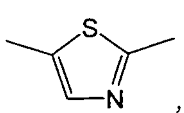 ,

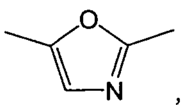, 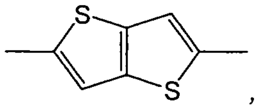, 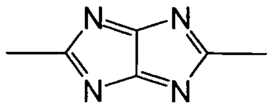, 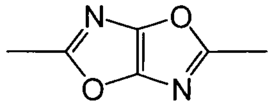,

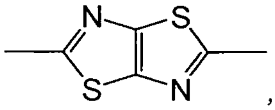, 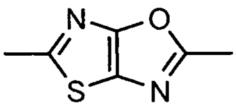, 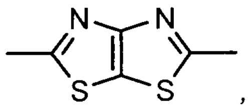, 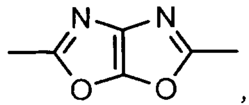,

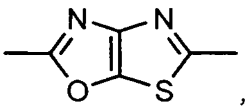, 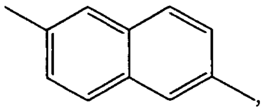, 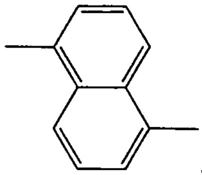, 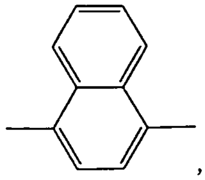,

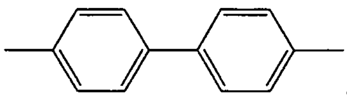, or 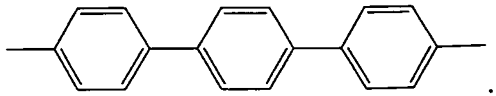.

5. An organic semiconductor, charge transporting or light emitting polymer formed from a polymerisable material according to any one of the preceding claims.

6. A polymer according to claim 5 wherein the polymer exhibits a liquid crystalline structure.

7. A polymer according to claim 6 wherein the structure of the polymer is thermotropic or monotropic

8. A polymer according to any one of claims 6 to 7 wherein the polymer has a calamitic, nematic, or a discotic structure.

9. Use of a polymer according to any one of claims 5 to 8 in an electronic or optical application that utilizes phosphorescence.

## Patentansprüche

1. Material zur Verwendung bei der Herstellung von organischen Halbleitern, ladungstransportierenden oder lichtemittierenden Polymeren, umfassend: ein photopolymerisierbares Material mit der Molekularstruktur B-S-A-S-B, **dadurch gekennzeichnet, dass**

   B eine vernetzbare Endgruppe ist;
   S ein flexibler Abstandshalter ist; und
   A ein aromatischer Molekülkern mit der Struktur

   -(Ar-D)n-Ar- ist;

   wobei

   n = 1 bis 6;
   Ar ist ein aromatisches Diradikal, ein heteroaromatisches Diradikal, das linear an benachbarte Diradikale gebunden ist, oder eine Einfachbindung ist;
   wobei die D jeweils unabhängig voneinander aus folgender Gruppe ausgewählt sind:

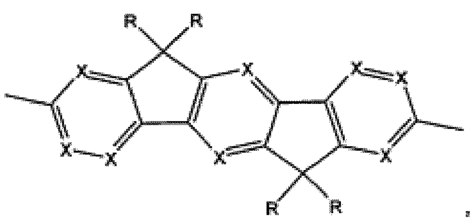
,
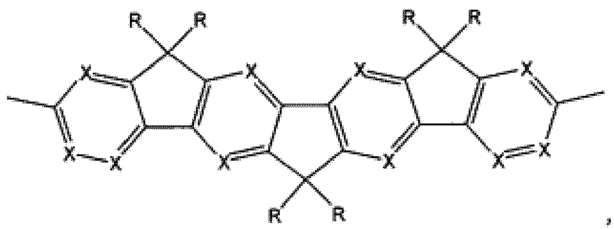
,

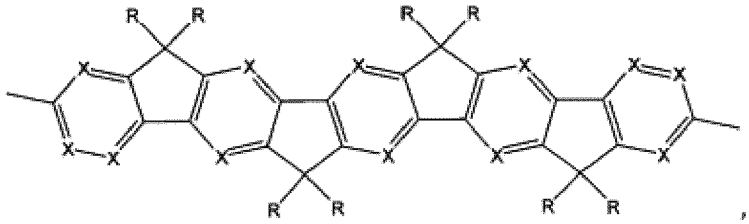
,

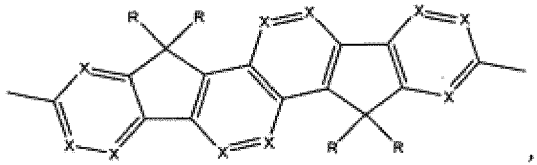
,

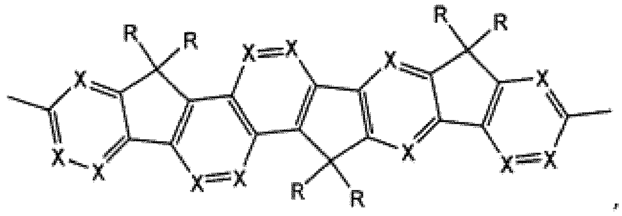
,

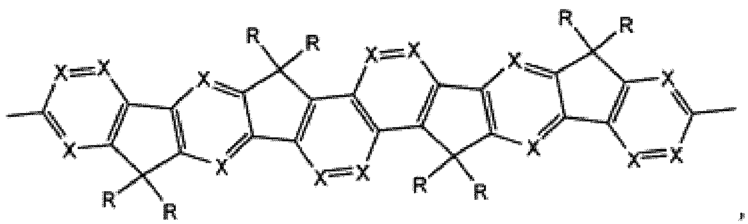
,

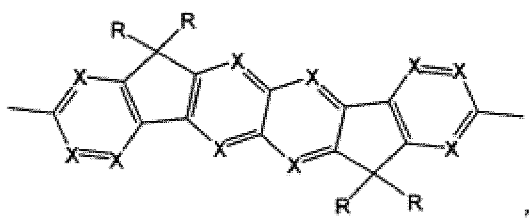
,

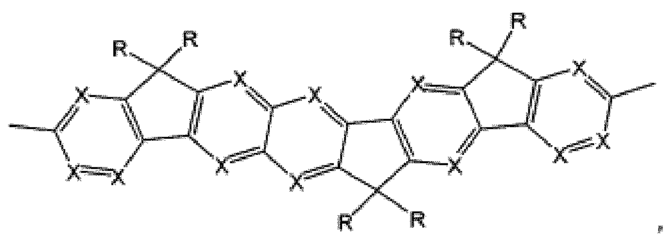
,

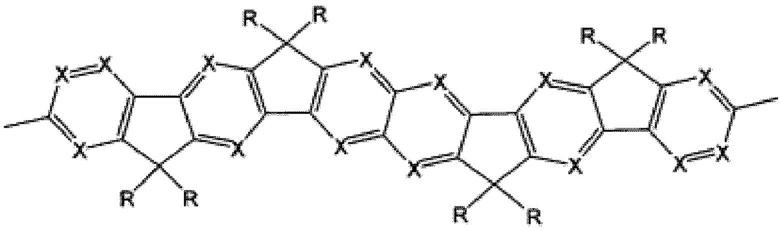

oder

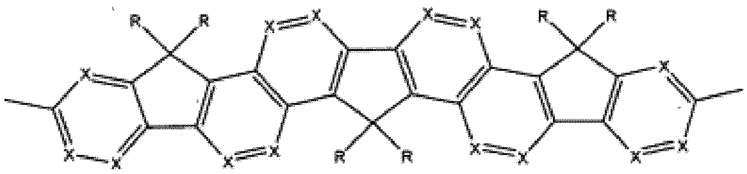

,

wobei

X unabhängig ausgewählt ist aus N, CH oder $CR_1$, wobei $R_1$ unabhängig ausgewählt ist aus Kohlenwasserstoffgruppen, $C_jH_{2j+1}$, verzweigten Kohlenwasserstoffgruppen oder Kohlenwasserstoffgruppen mit einem oder mehreren Heteroatomen von S, N, O, P oder Si, mit j = 1 bis 6; und
R unabhängig ausgewählt ist aus Kohlenwasserstoffgruppen, $C_mH_{2m+1}$, verzweigten Kohlenwasserstoffgruppen oder Kohlenwasserstoffgruppen mit einem oder mehreren Heteroatomen von S, N, O, P oder Si, mit m = 1 bis 15, und

die Ar- und D-Diradikale in jeder der n Untereinheiten des aromatischen Molekularkerns A unabhängig voneinander ausgewählt sind.

2. Material nach Anspruch 1, bei dem die vernetzbaren Endgruppen B ausgewählt sind aus 1,4-Pentadien-3-yl, Methacrylato, Ethacrylato, Vinyloxy, Alkylvinyloxy, Ethoxyfumarato, Ethoxymaleato, Ethoxymaleato, N-Maleimido, Vinyloxyfumarato, Vinyloxymaleato, Alkylvinyloxyethacrylato, Alkylvinyloxyethacrylato oder N-(2-Vinyloxy)maleimido.

3. Material nach Anspruch 1 oder Anspruch 2, bei dem ein oder mehrere Metallatome chemisch in den aromatischen Molekülkern A eingebunden sind.

4. Material nach einem der vorhergehenden Ansprüche, bei dem das aromatische Diradikal Ar ausgewählt ist unter:

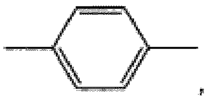 , 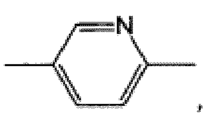 , 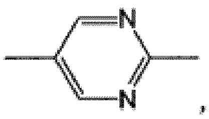 , 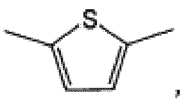 , 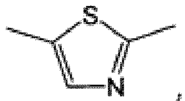 ,

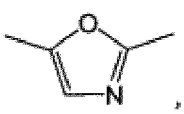 , 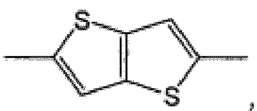 , 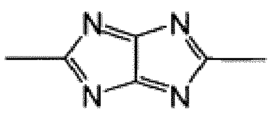 , 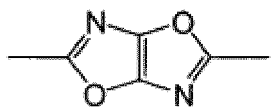 ,

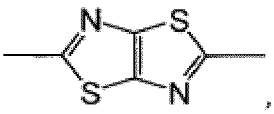 , 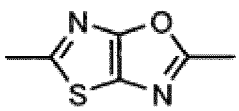 , 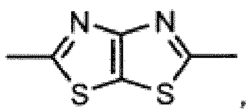 , 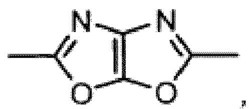 ,

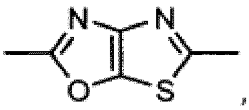, 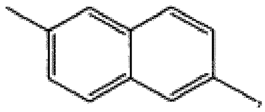, 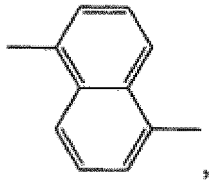, 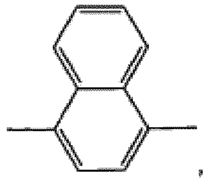,

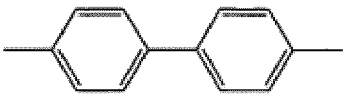 oder 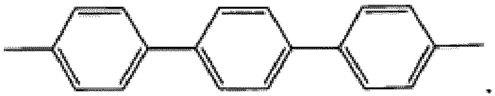.

5. Organischer Halbleiter, ladungstransportierendes oder lichtemittierendes Polymer, gebildet aus einem polymerisierbaren Material nach einem der vorhergehenden Ansprüche.

6. Polymer nach Anspruch 5, wobei das Polymer eine flüssigkristalline Struktur aufweist.

7. Polymer nach Anspruch 6, wobei die Struktur des Polymers thermotrop oder monotrop ist.

8. Polymer nach einem der Ansprüche 6 bis 7, worin das Polymer eine calamitische, nematische oder diskotische Struktur aufweist.

9. Verwendung eines Polymers nach einem der Ansprüche 5 bis 8 in einer elektronischen oder optischen Anwendung, die Phosphoreszenz verwendet.

## Revendications

1. Matériau destiné à être utilisé dans la formation de polymères organiques semi-conducteurs, transporteurs de charge ou électroluminescents comprenant : un matériau photopolymérisable ayant la structure moléculaire

B-S-A-S-B,

**caractérisé en ce que**

B représente un groupe terminal réticulable ;
S représente un espaceur flexible ; et
A représente un noyau moléculaire aromatique ayant la structure $-(Ar-D)_n-Ar-$
dans laquelle

n = 1 à 6 ;
Ar représente un diradical aromatique, un diradical hétéroaromatique lié de manière linéaire à des diradicaux adjacents, ou une liaison simple ;
où
D sont chacun indépendamment choisis dans le groupe :

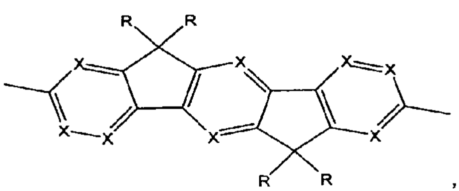, 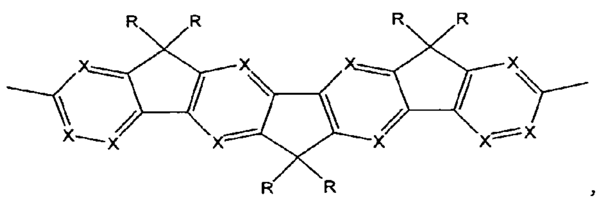,

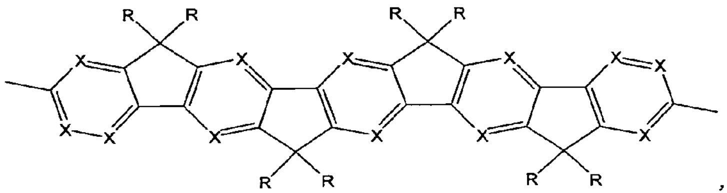

,

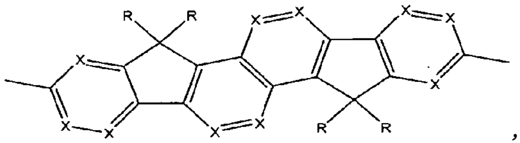

,

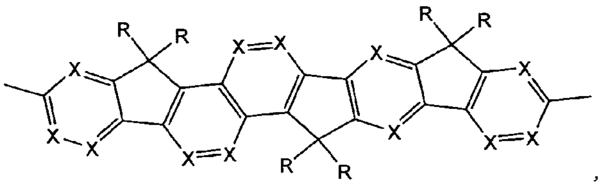

,

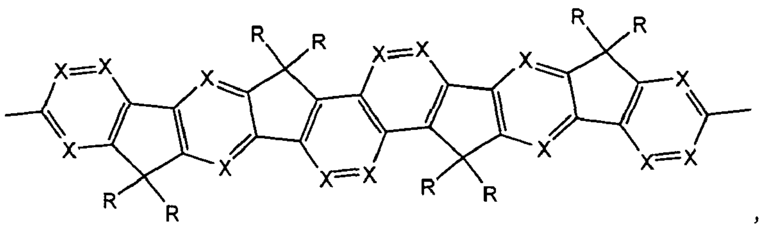

,

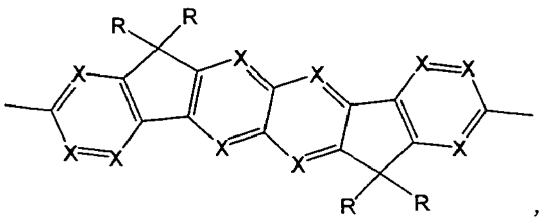

,

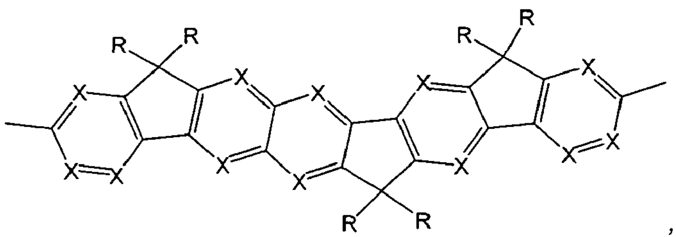

,

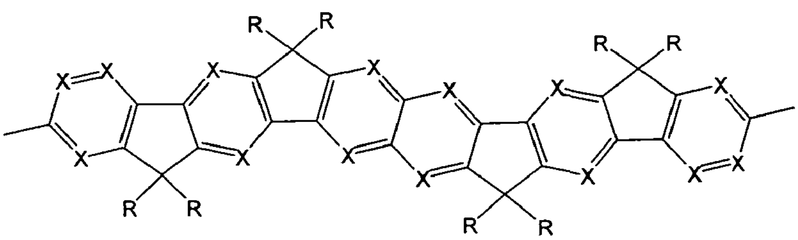

,

ou

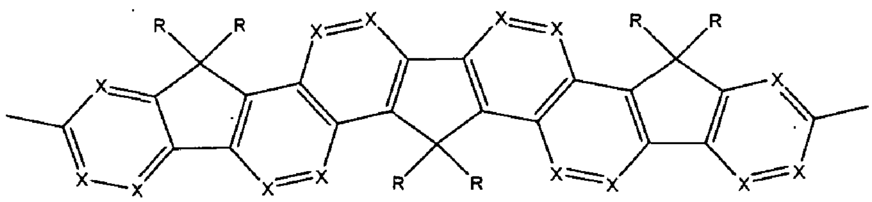

et où

X est indépendamment choisi entre un atome de N, un groupe CH ou $CR_1$ où $R_1$ est indépendamment choisi entre des groupes hydrocarbyle, $C_jH_{2j+1}$, des groupes hydrocarbyle ramifiés ou des groupes hydrocarbyle avec un ou plusieurs hétéroatomes de S, N, O, P ou Si avec j = 1 à 6 ; et
R est indépendamment choisi entre des groupes hydrocarbyle, $C_mH_{2m+1}$, des groupes hydrocarbyle ramifiés ou des groupes hydrocarbyle avec un ou plusieurs hétéroatomes de S, N, O, P ou Si, avec m = 1 à 15, et
les diradicaux Ar et D sont indépendamment choisis dans chacune des n sous-unités du noyau moléculaire aromatique A.

2. Matériau selon la revendication 1, dans lequel le groupe terminal réticulable B est choisi entre un groupe 1,4-pentadiène-3-yle, méthacrylato, éthacrylato, vinyloxy, alkylvinyloxy, éthoxyfumarato, éthoxymaléato, N-maléimido, vinyloxyfumarato, vinyloxymaléato, alkylvinyloxyéthacrylato, alkylvinyloxyéthacrylato ou N-(2-vinyloxy)maléimido.

3. Matériau selon la revendication 1 ou 2, dans lequel un ou plusieurs atomes métalliques sont liés chimiquement dans le noyau moléculaire aromatique A.

4. Matériau selon l'une quelconque des revendications précédentes, dans lequel le diradical aromatique Ar est choisi entre :

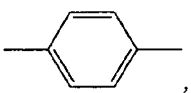 , 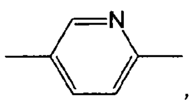 , 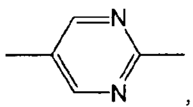 , 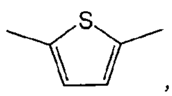 , 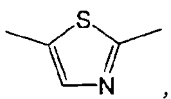 ,

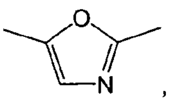 , 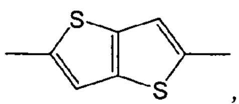 , 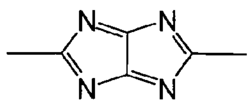 , 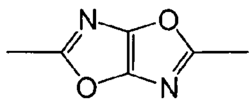 ,

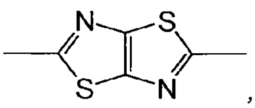 , 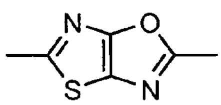 , 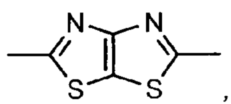 , 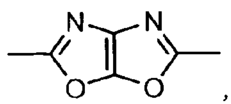 ,

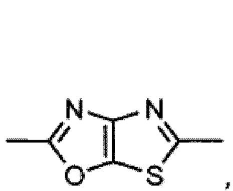 , 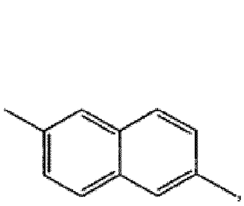 , 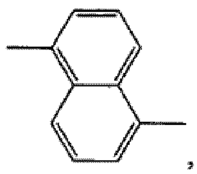 , 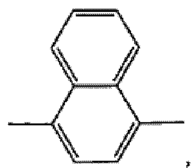 ,

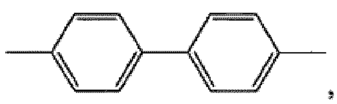 , ou 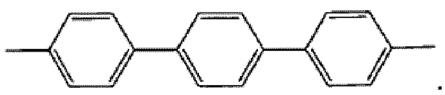 .

5. Polymère organique semi-conducteur, transporteur de charge ou électroluminescent formé à partir d'un matériau polymérisable selon l'une quelconque des revendications précédentes.

6. Polymère selon la revendication 5, où le polymère présente une structure cristalline liquide.

7. Polymère selon la revendication 6, dans lequel la structure du polymère est thermotrope ou monotrope.

8. Polymère selon l'une quelconque des revendications 6 et 7, où le polymère a une structure calamitique, nématique ou discotique.

9. Utilisation d'un polymère selon l'une quelconque des revendications 5 à 8 dans une application électronique ou optique qui utilise la phosphorescence.

# FIG. 1

Synthesis for:

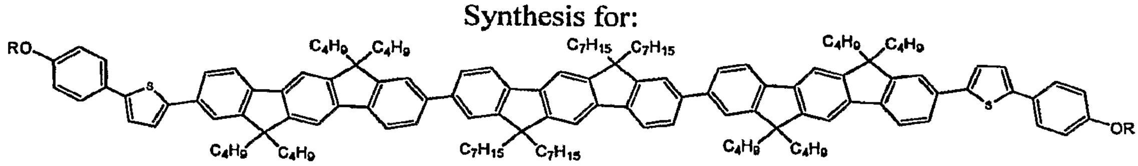

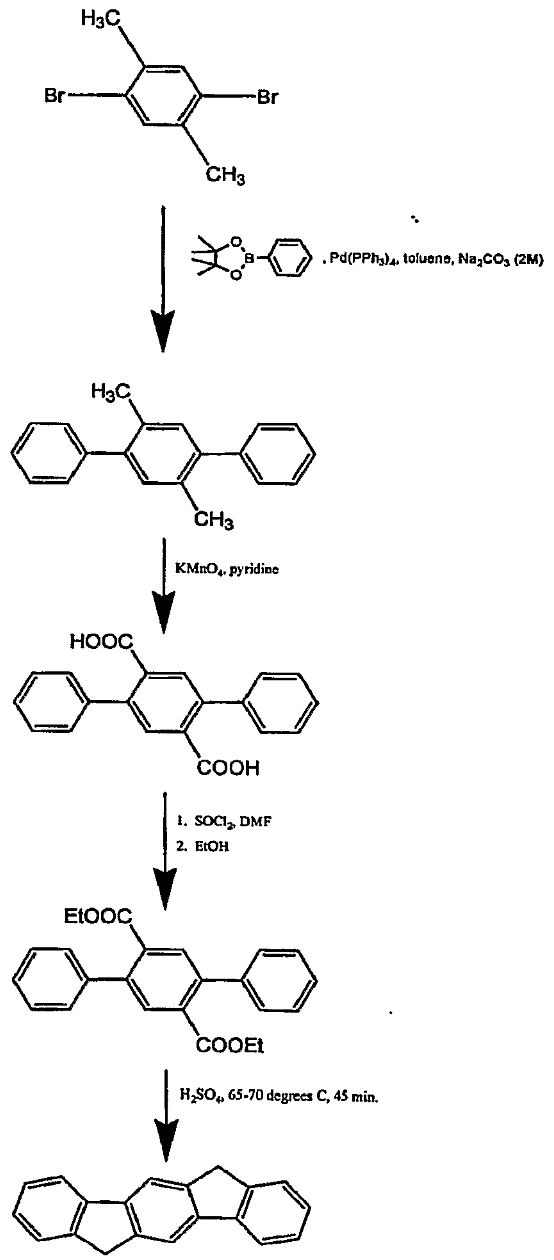


I.

II.

III.

IV.

V.

# FIG. 2

Synthesis Continued

V.

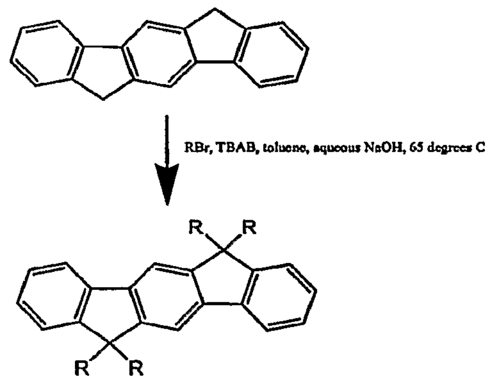


VIa. R = $C_7H_{15}$

VIb. R = $C_4H_9$

VIa.

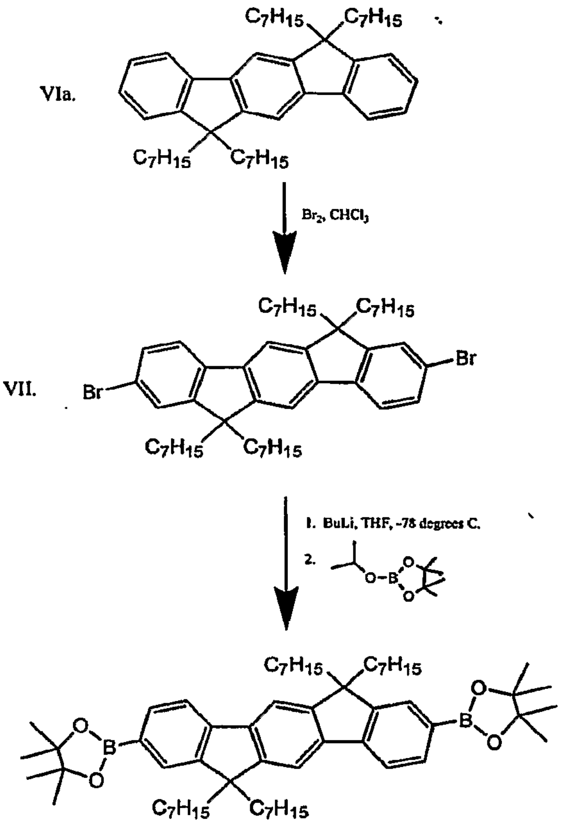


VII.

VIII.

# FIG. 3

Synthesis Continued

VIb.

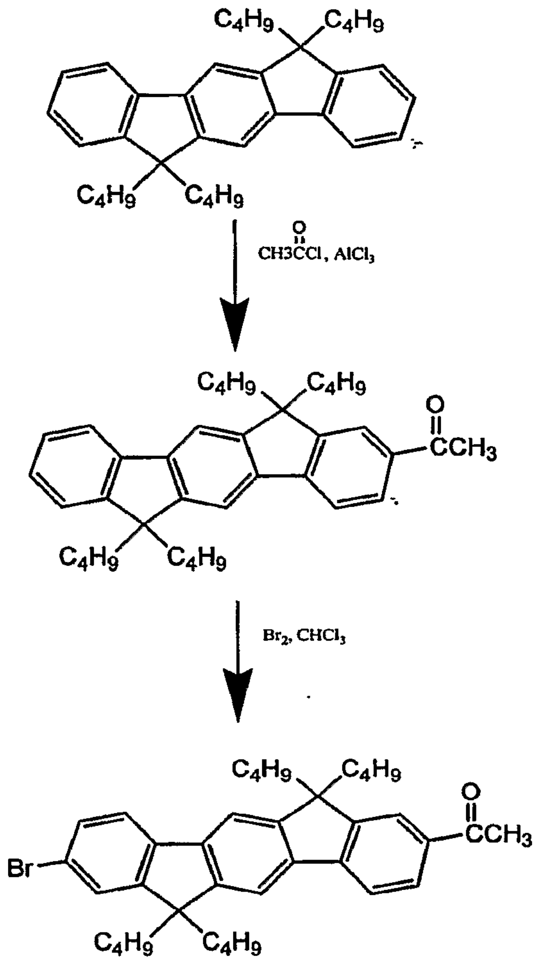


IX.

X.

# FIG. 4

Synthesis Continued

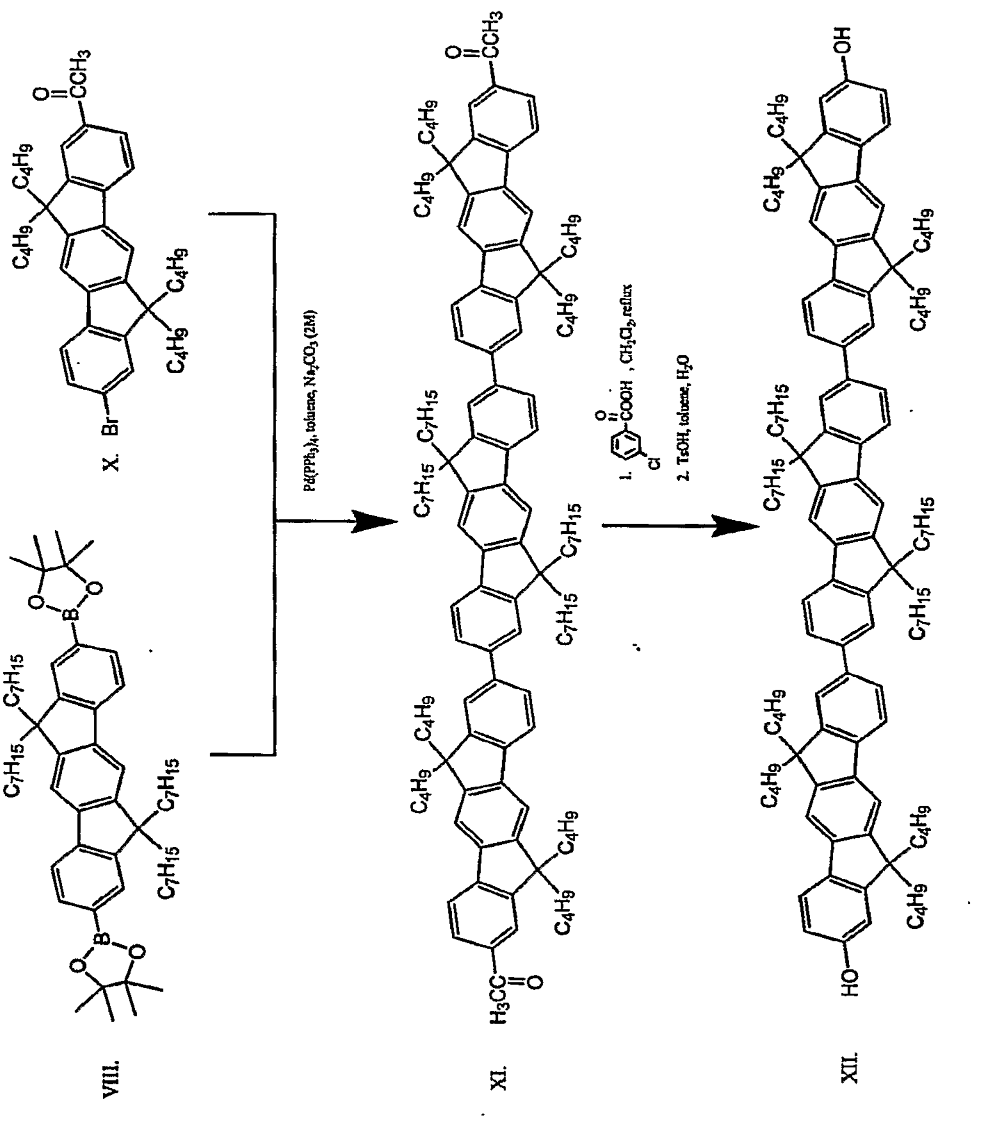


VIII. X. XI. XII.

# FIG. 5

Synthesis Continued

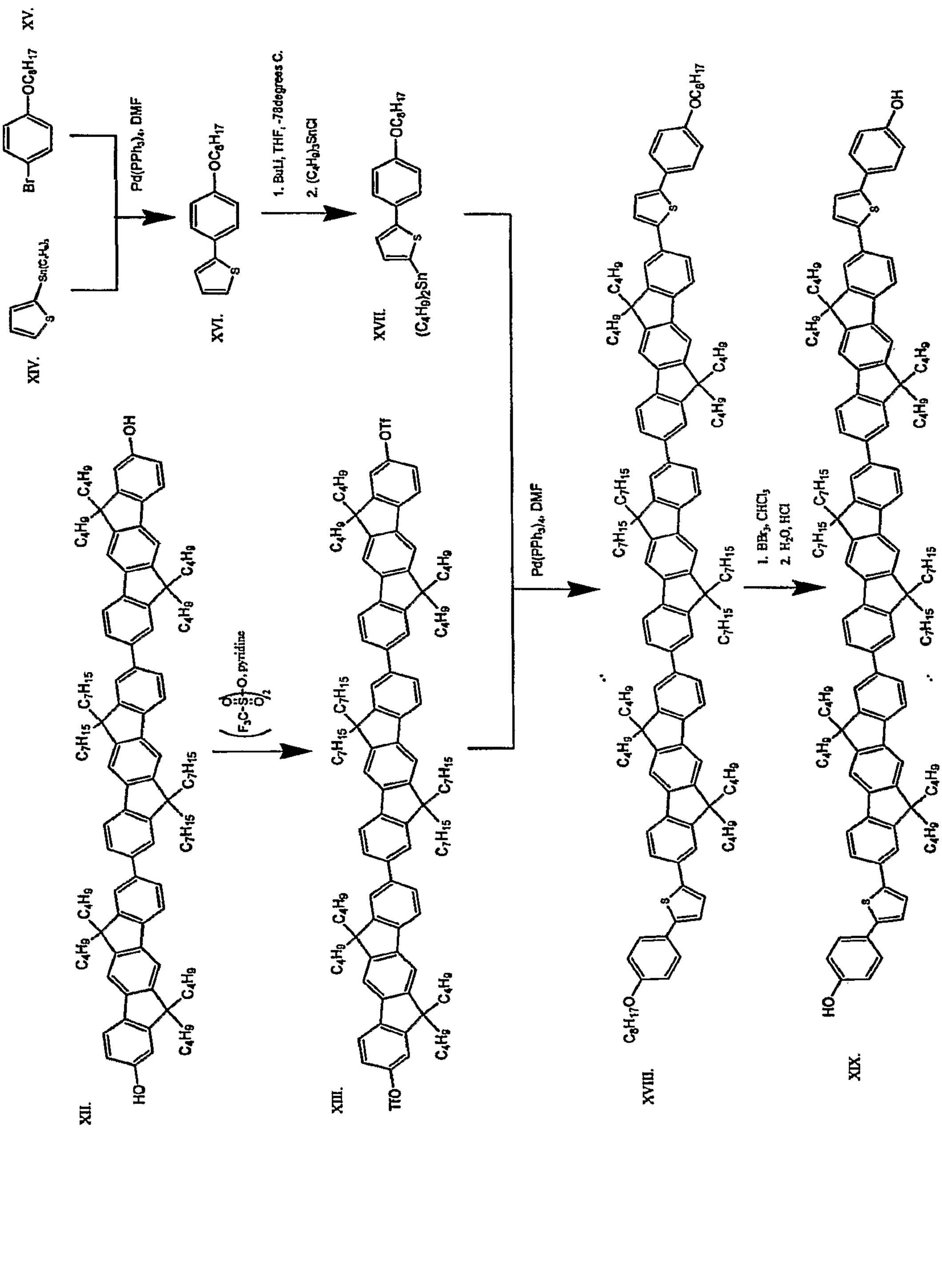

# FIG. 6

Synthesis Continued

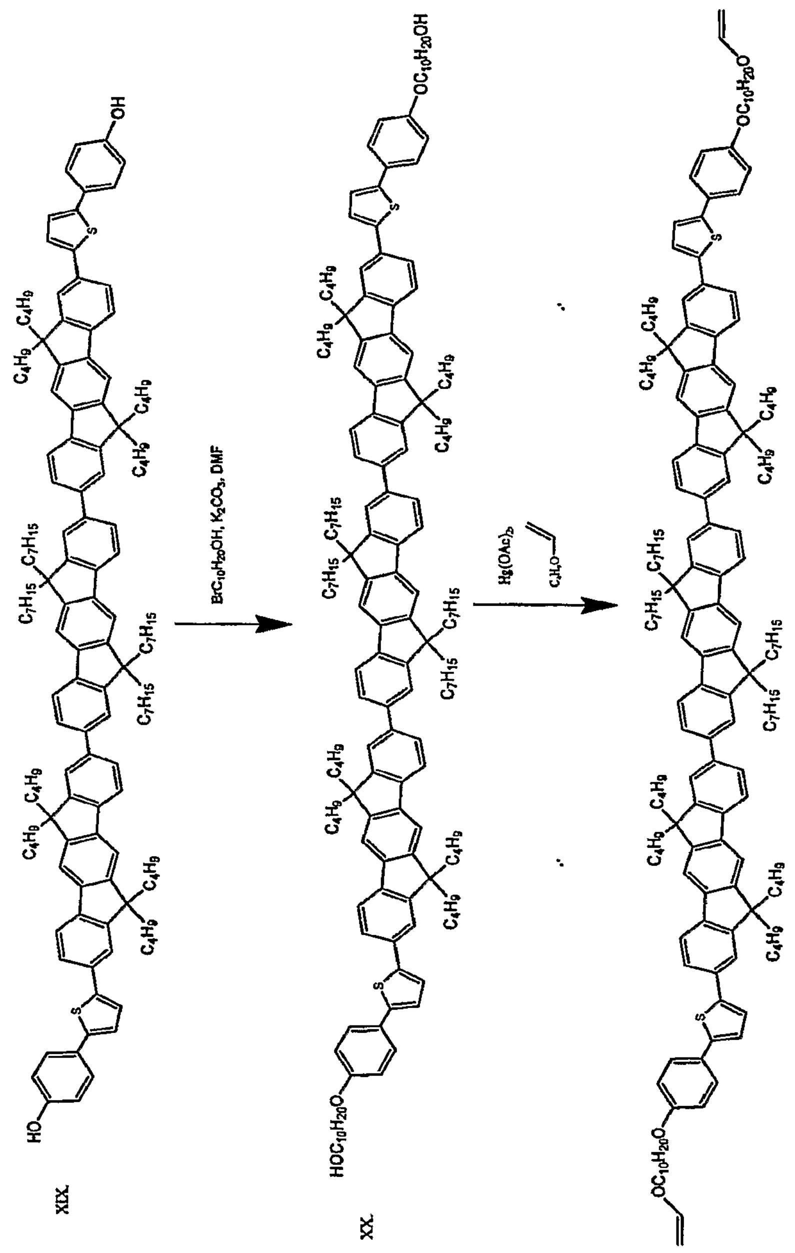


XIX.

XX.

XXI.

# FIG. 7

Synthesis Continued

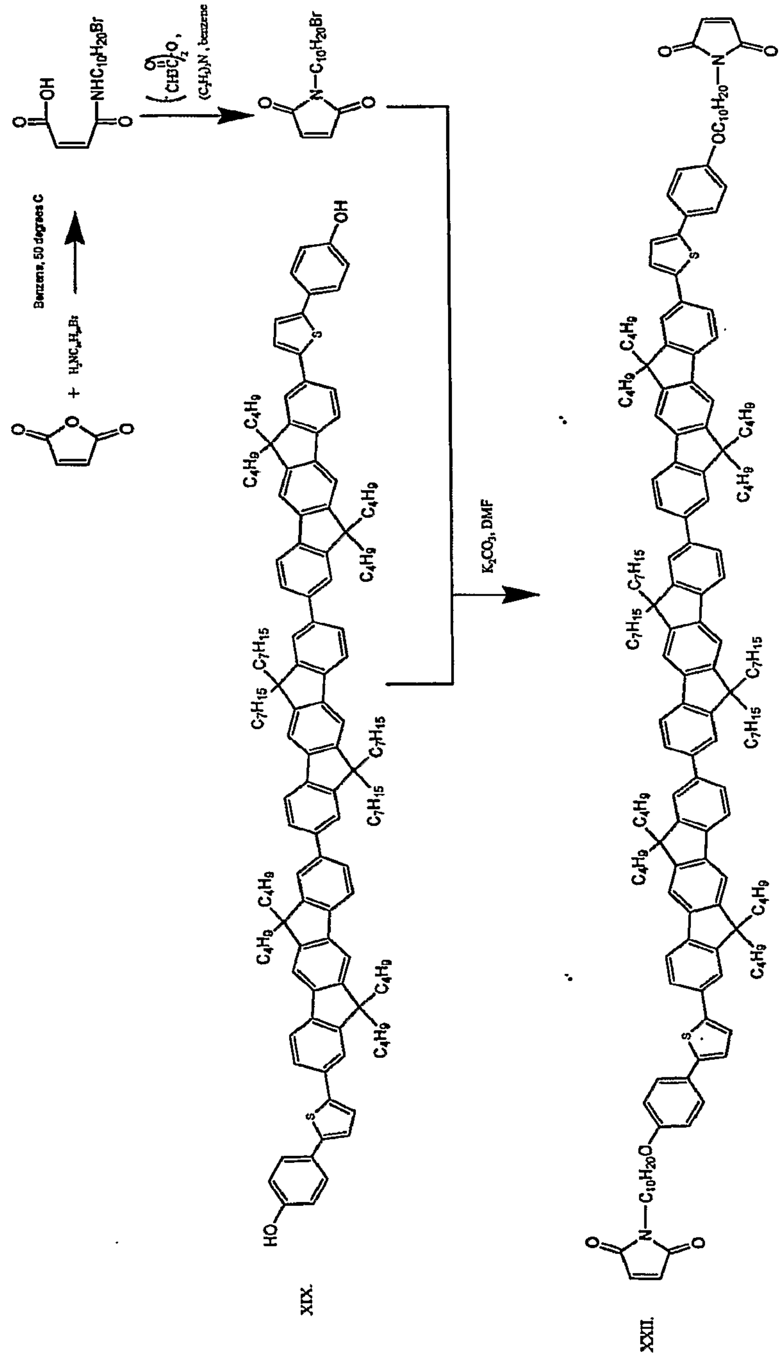


XIX.

XXII.

# FIG. 8

Synthesis for:

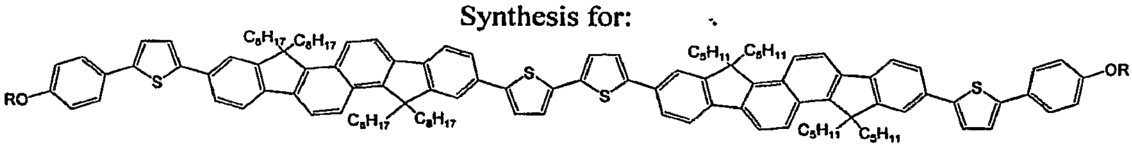

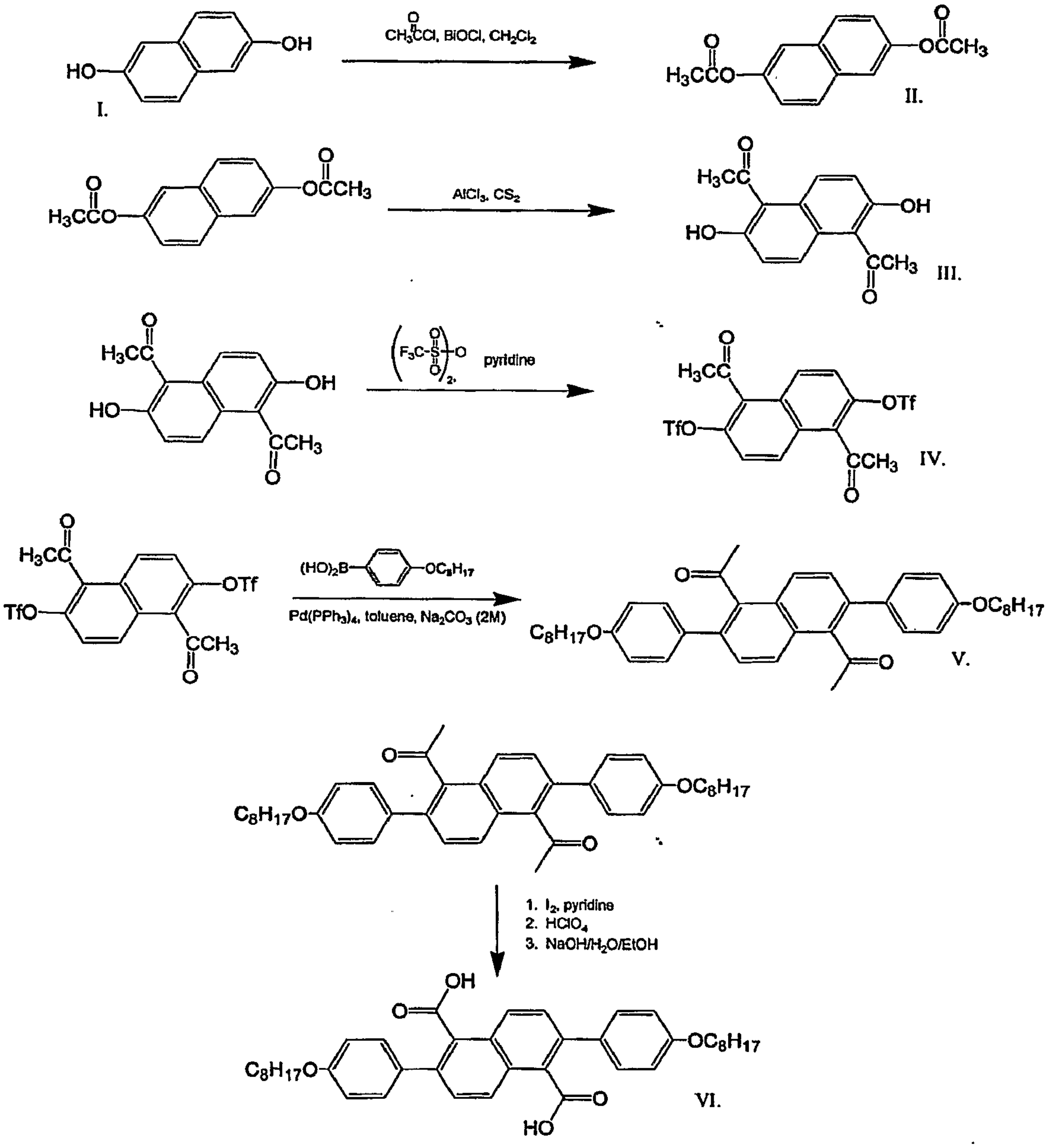


I. II. III. IV. V. VI.

# FIG. 9

Synthesis Continued

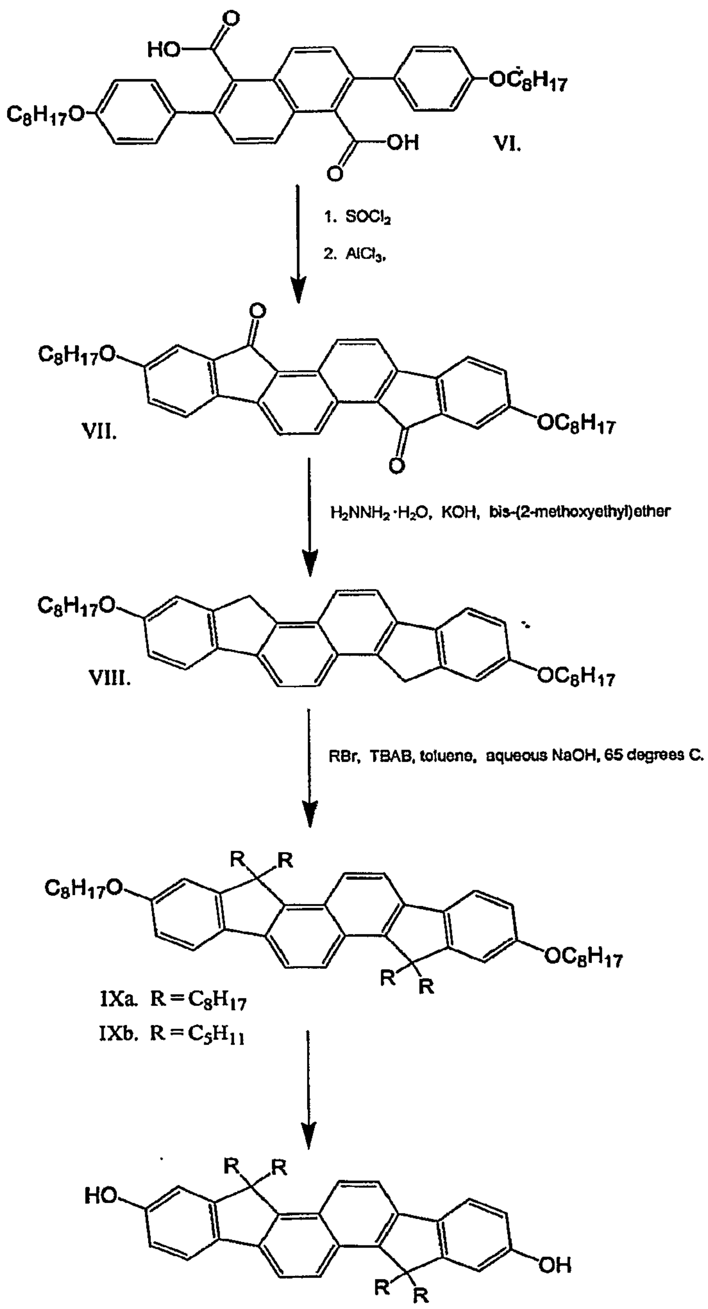


VI.

VII.

VIII.

IXa. $R = C_8H_{17}$
IXb. $R = C_5H_{11}$

Xa. $R = C_8H_{17}$
Xb. $R = C_5H_{11}$

# FIG. 10

Synthesis Continued

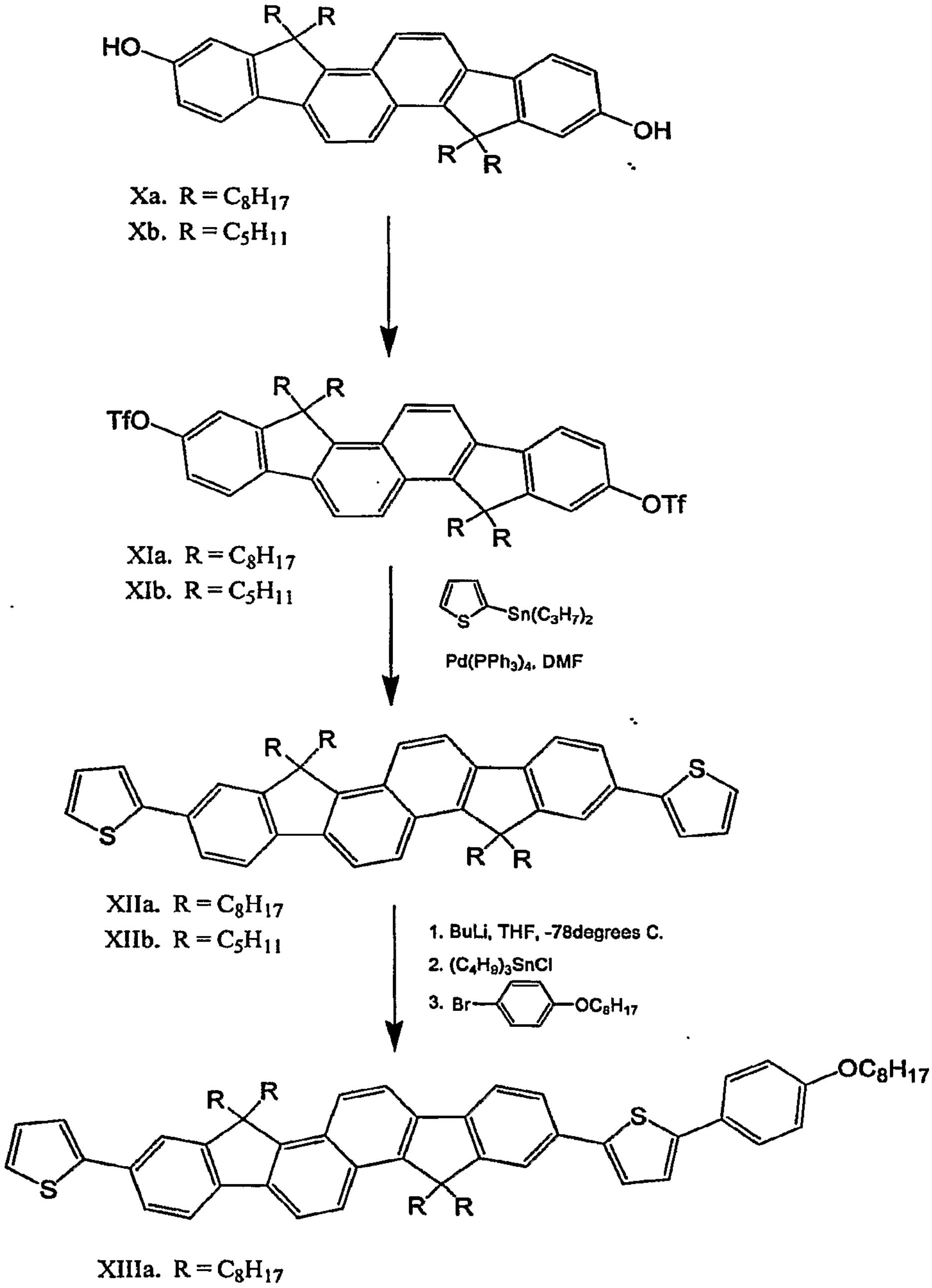


Xa. R = $C_8H_{17}$
Xb. R = $C_5H_{11}$

XIa. R = $C_8H_{17}$
XIb. R = $C_5H_{11}$

XIIa. R = $C_8H_{17}$
XIIb. R = $C_5H_{11}$

XIIIa. R = $C_8H_{17}$
XIIIb. R = $C_5H_{11}$

# FIG. 11

Synthesis Continued

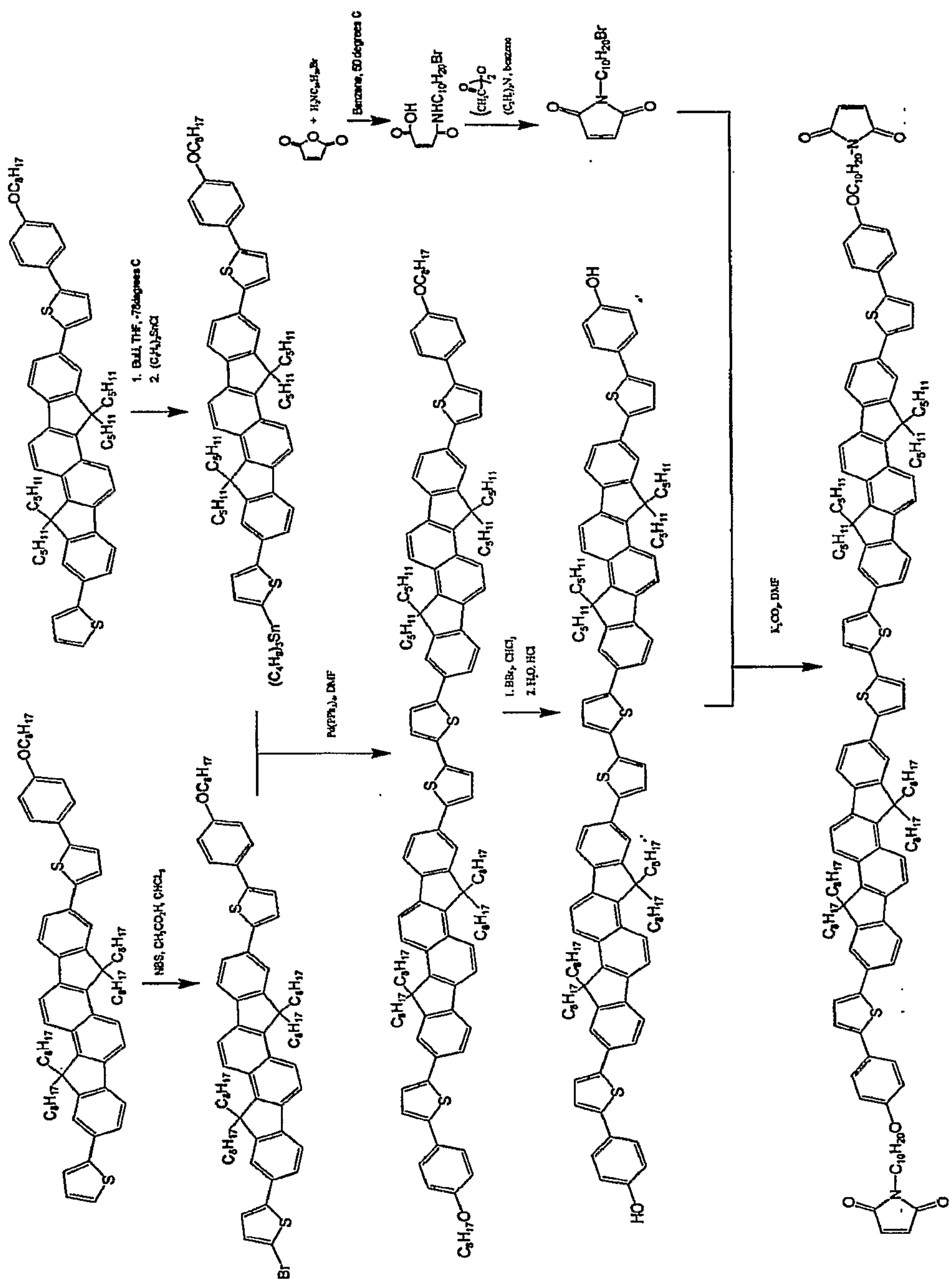

# FIG. 12

Synthesis Continued

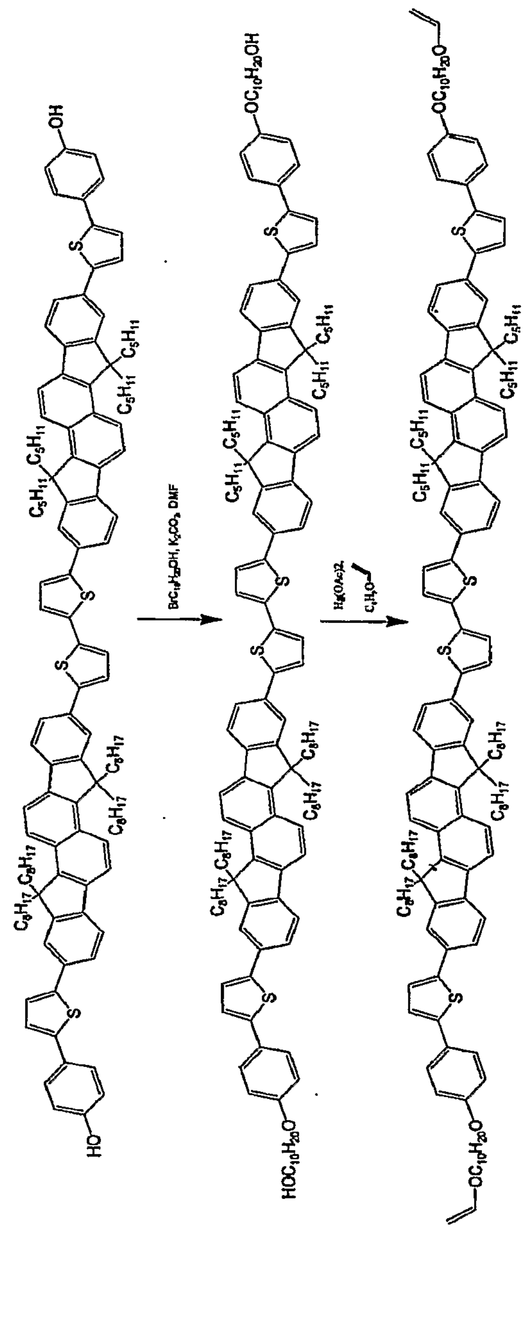

# FIG. 13

Synthesis of:

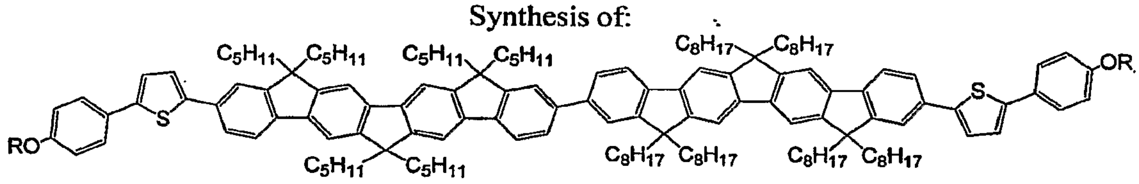

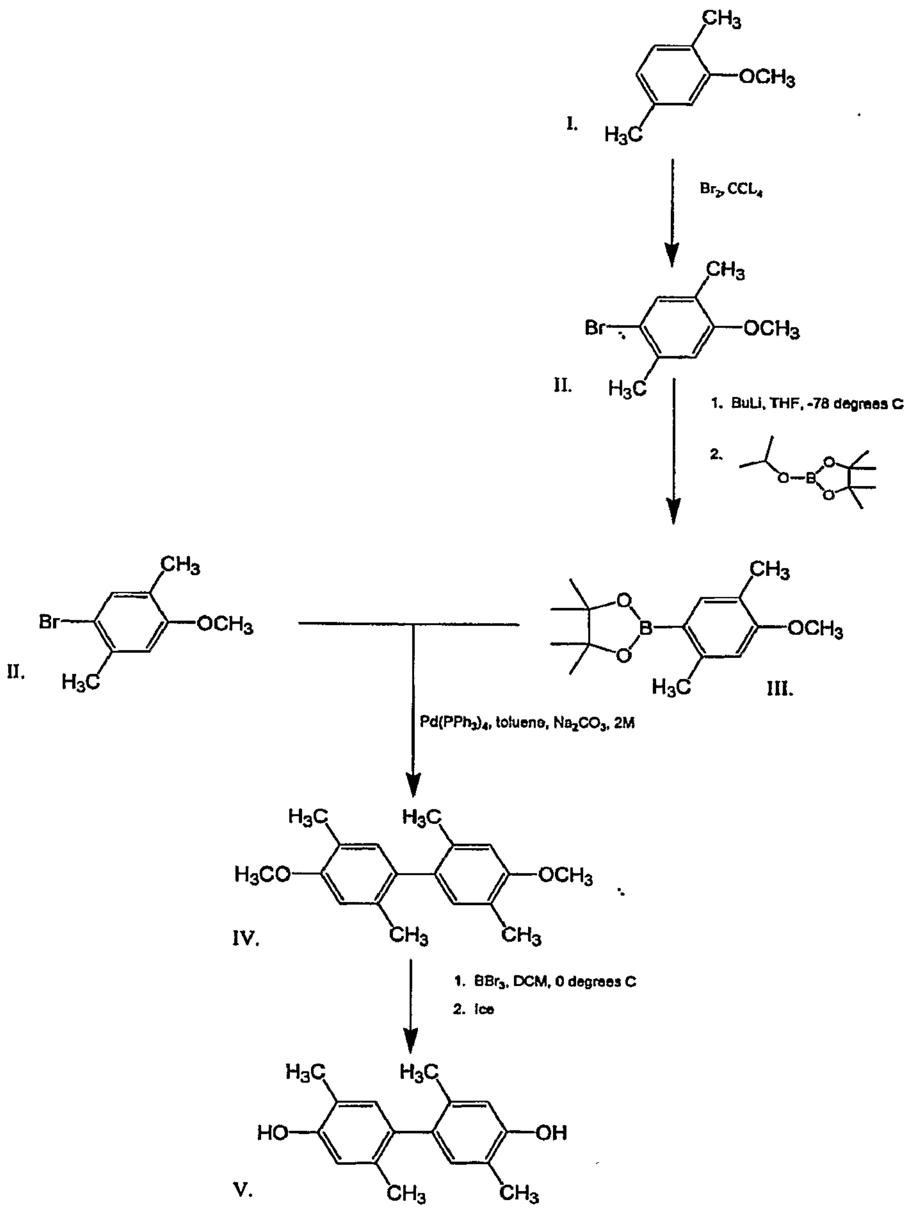


I.

II.

II.

III.

IV.

V.

# FIG. 14

Synthesis Continued

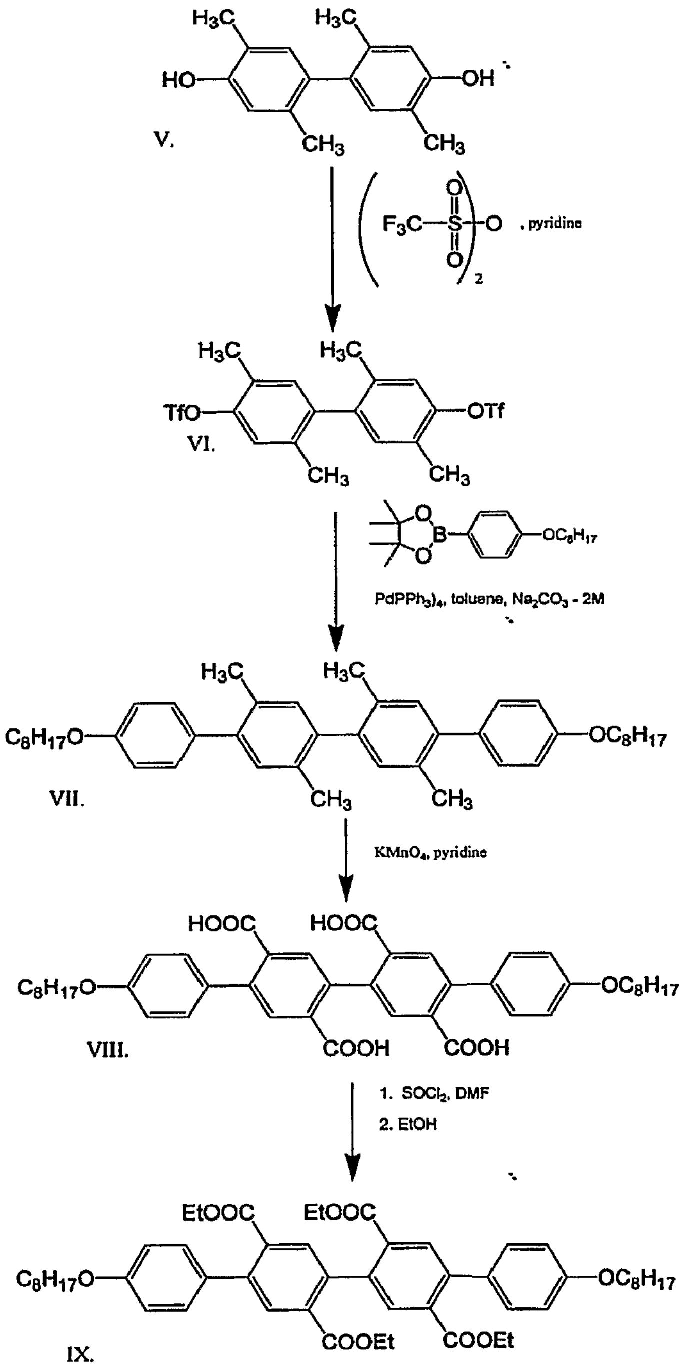


V.

VI.

VII.

VIII.

IX.

# FIG. 15

Synthesis Continued

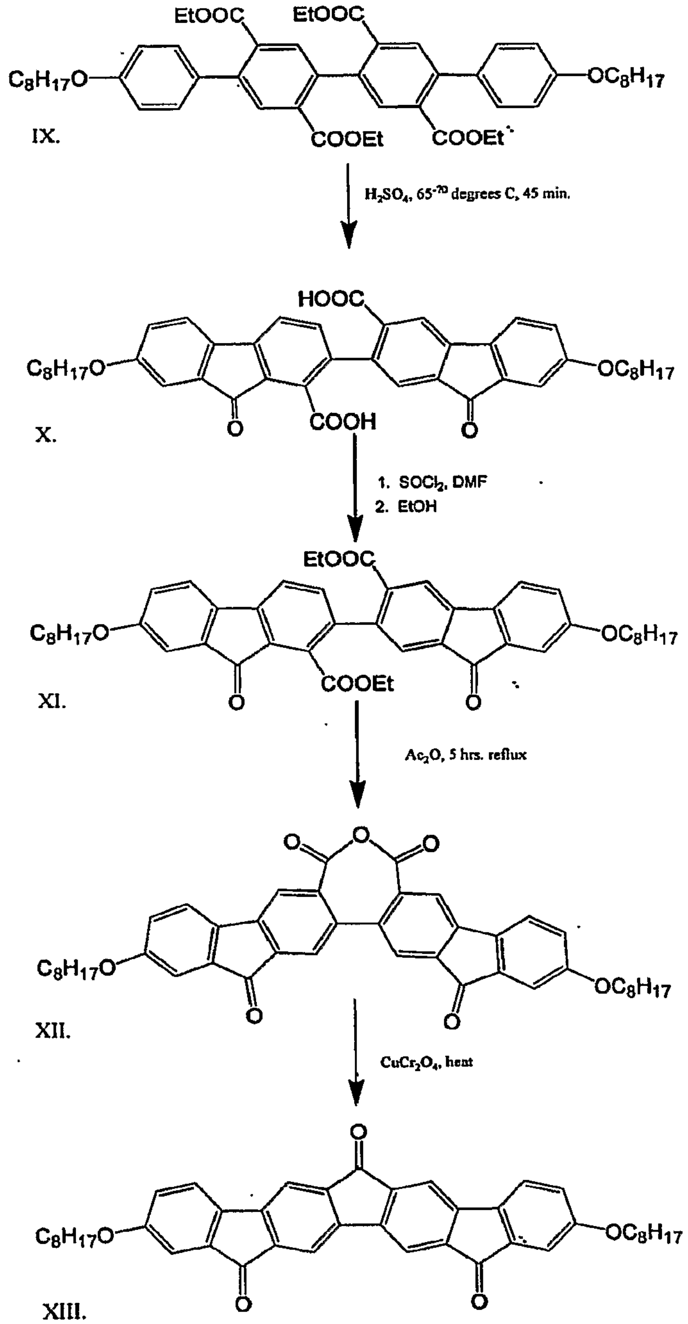


IX.

X.

XI.

XII.

XIII.

# FIG. 16

Synthesis Continued

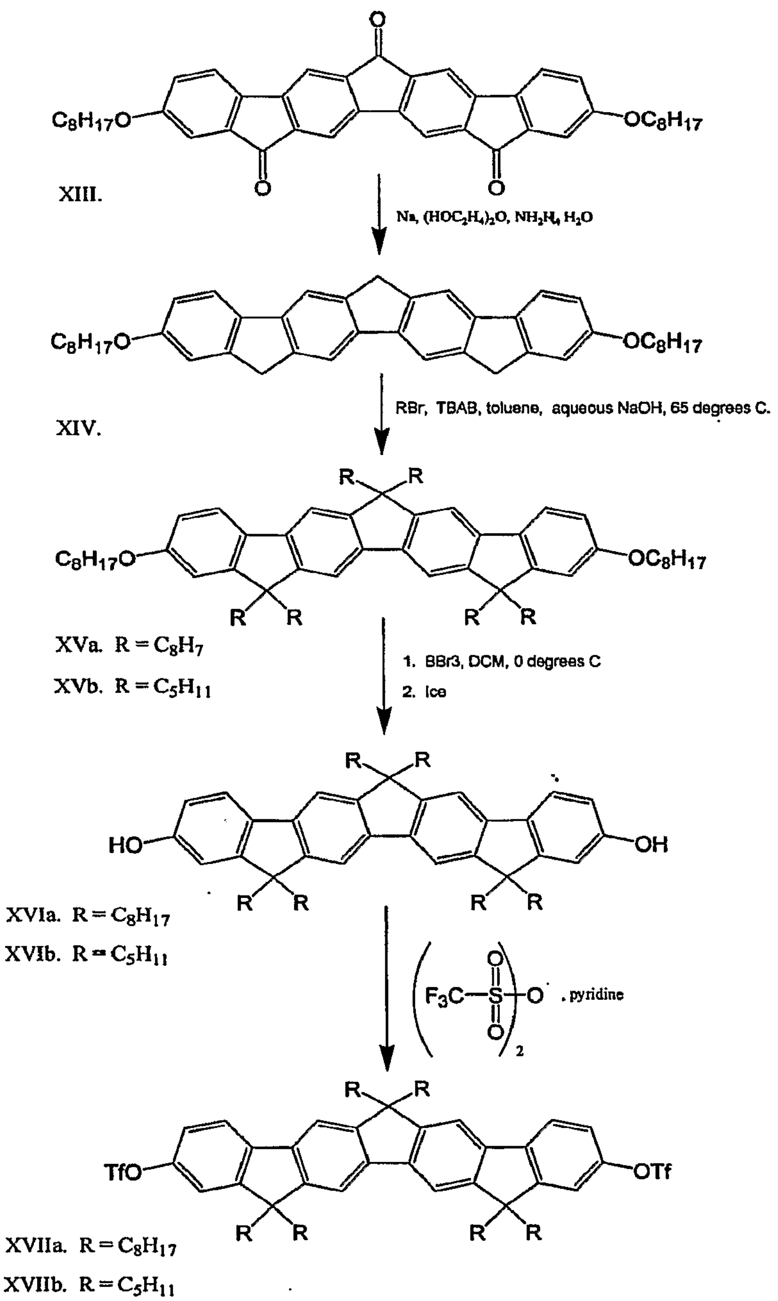


XIII.

XIV.

XVa. $R = C_8H_7$

XVb. $R = C_5H_{11}$

XVIa. $R = C_8H_{17}$

XVIb. $R = C_5H_{11}$

XVIIa. $R = C_8H_{17}$

XVIIb. $R = C_5H_{11}$

# FIG. 17

Synthesis Continued

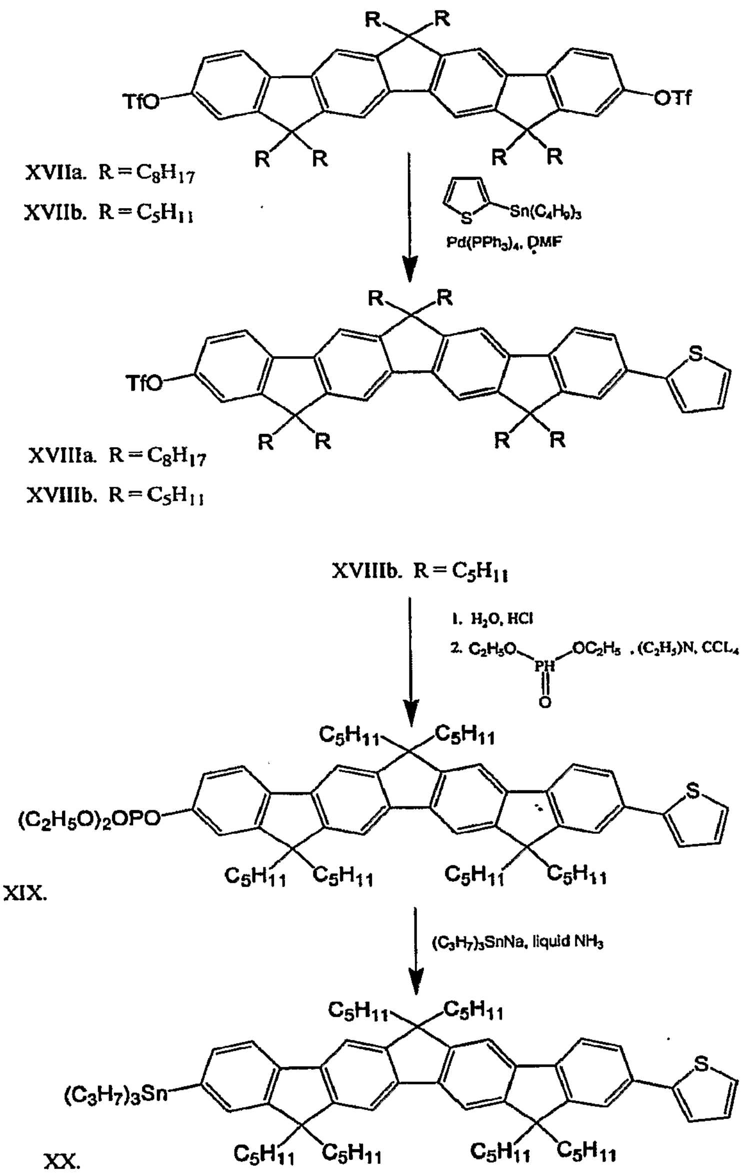


XVIIa. $R = C_8H_{17}$

XVIIb. $R = C_5H_{11}$

XVIIIa. $R = C_8H_{17}$

XVIIIb. $R = C_5H_{11}$

XVIIIb. $R = C_5H_{11}$

XIX.

XX.

# FIG. 18

Synthesis Continued

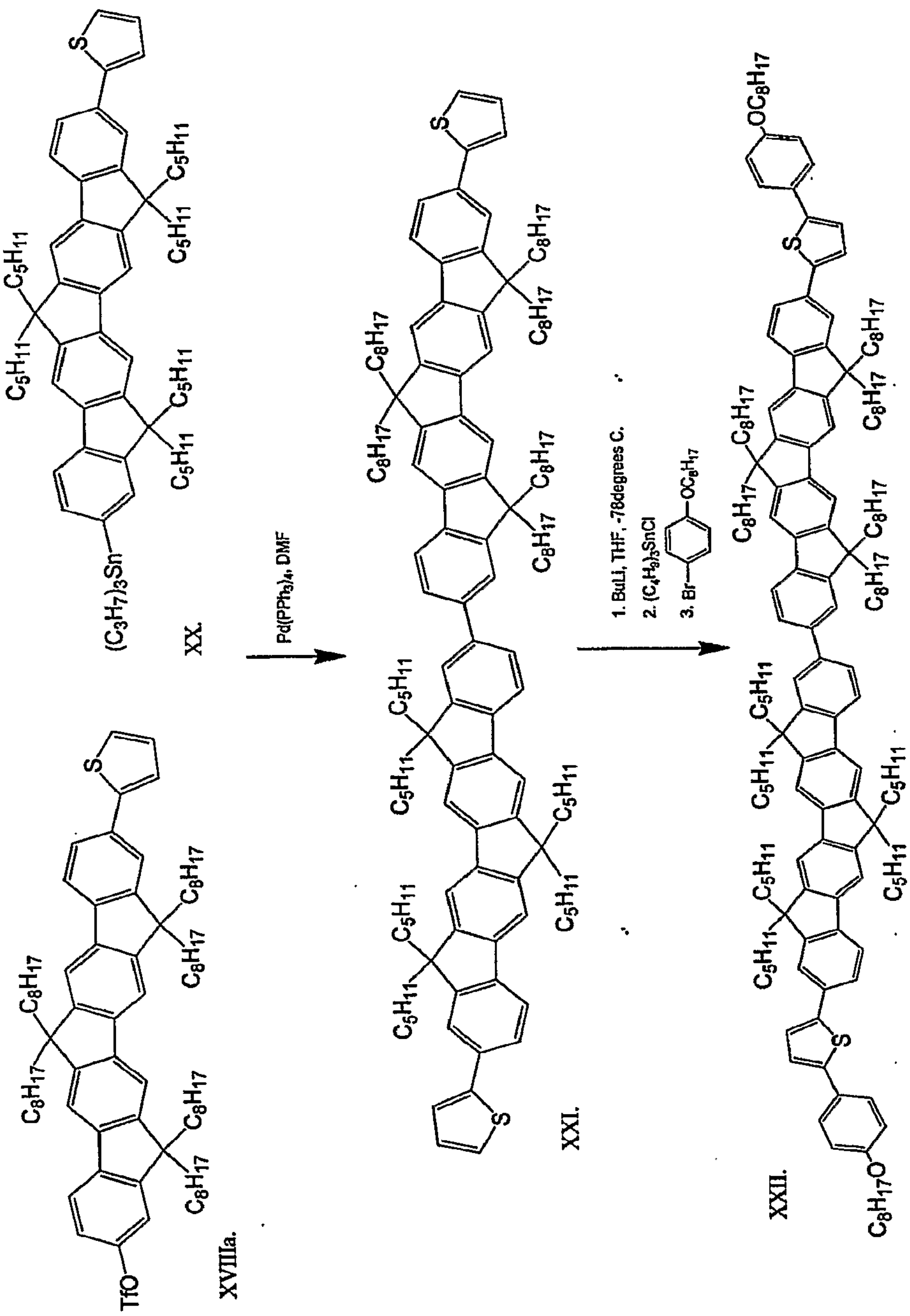


XVIIIa.

XX.

XXI.

XXII.

# FIG. 19

Synthesis Continued

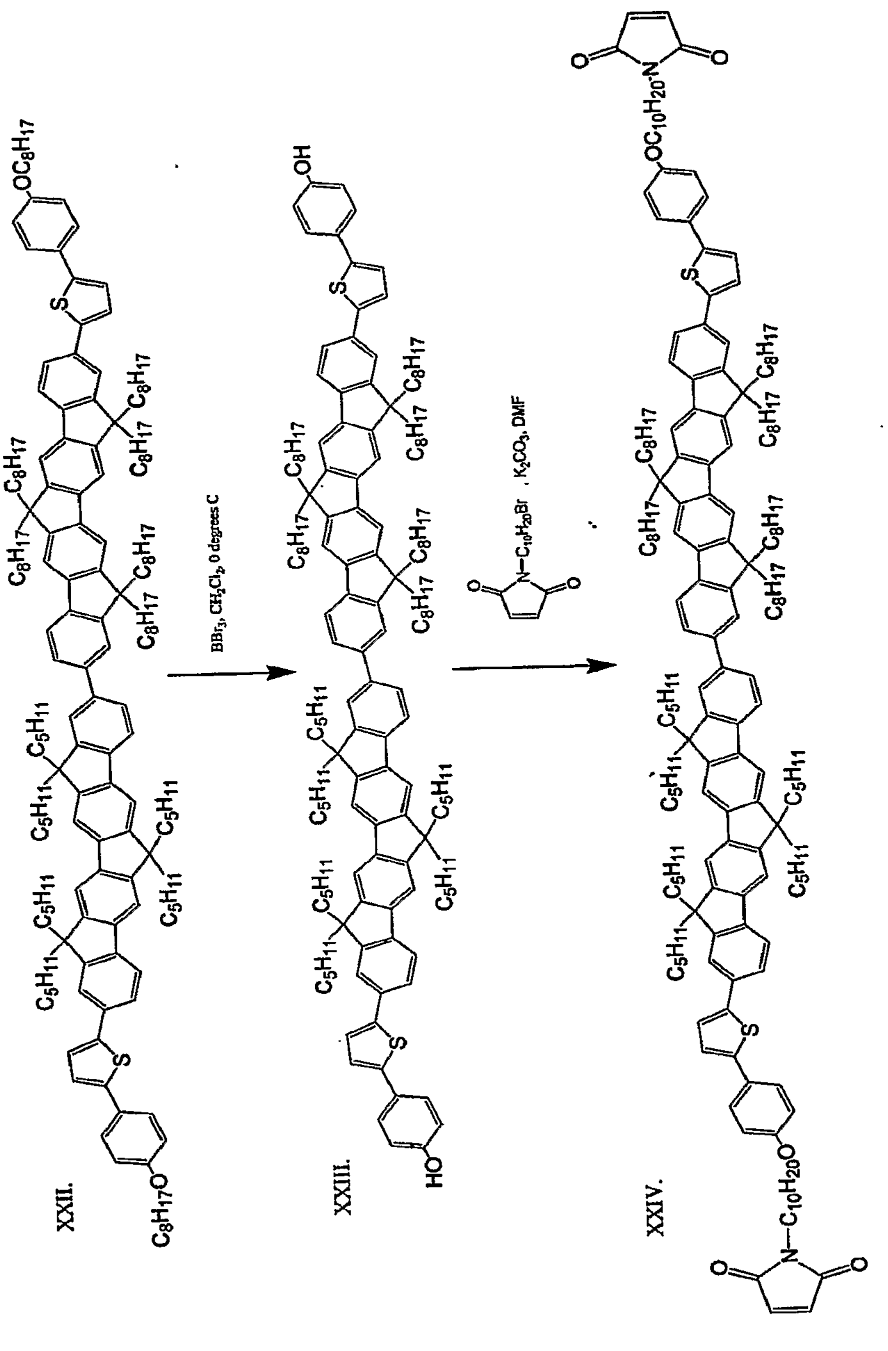


XXII.

XXIII.

XXIV.

# FIG. 20

Synthesis Continued

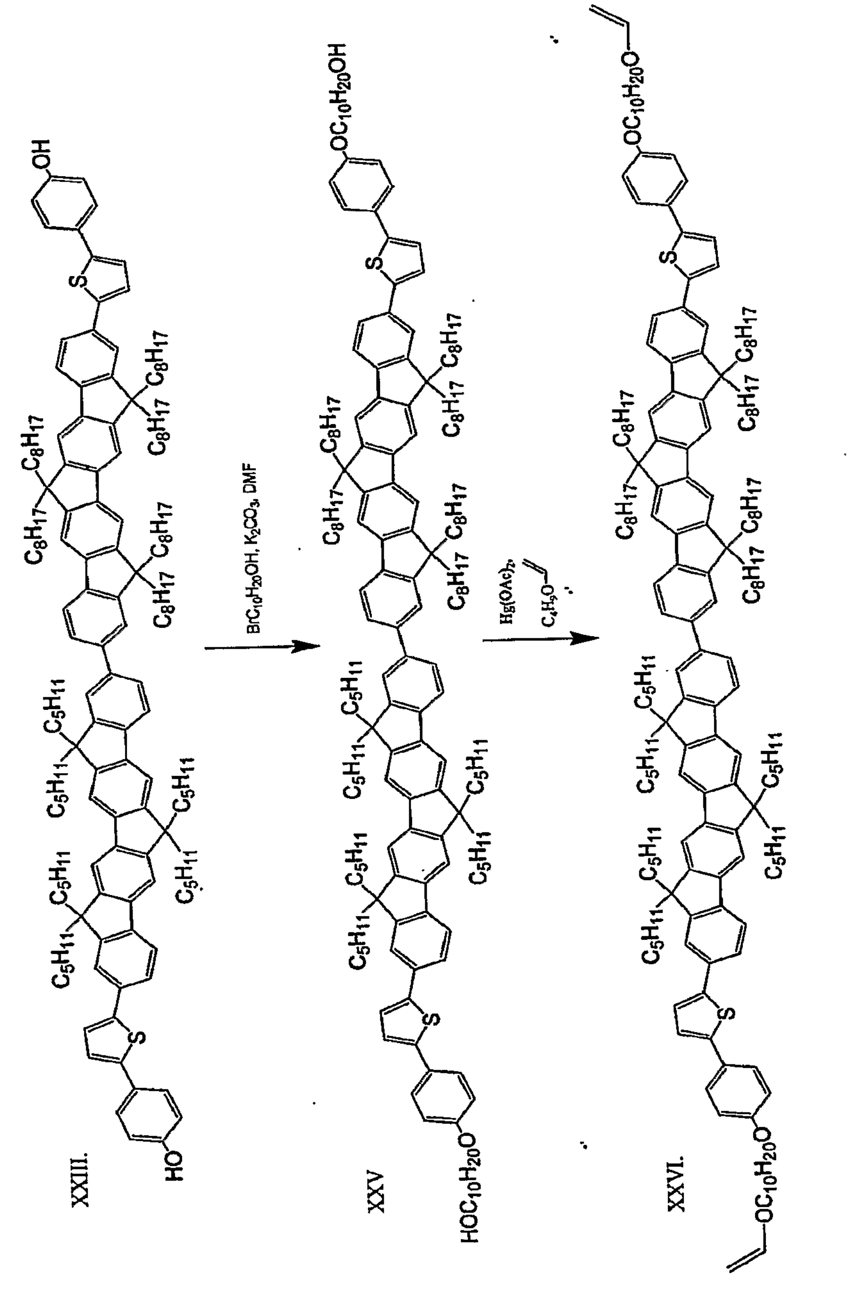


XXIII.

XXV

XXVI.

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- US 74063305 P
- WO 2004041901 A
- WO 2005095543 A
- US 2005116199 A1
- US 10948748 B


### Non-patent literature cited in the description


- **ADAM A. E. CONTORET.** The Photopolymerization and Cross-Linking of Electroluminescent Liquid Crystals Containing Methacrylate and Diene Photopolymerizable End Groups for Multilayer Organic Light-Emitting Diodes. *Chem. Mater.,* 2002, vol. 14, 1477-1487
- Photoinitiated radical polymerization of vinyl ether-maleate systems. *Polymer,* 1997, vol. 38 (9), 2229-37
- Co-Polymerization of Maleimides and Vinyl Ethers: A Structural Study. *Macromolecules,* 1998, vol. 31, 5681-89